# EUROPEAN PATENT SPECIFICATION

(11) **EP 4 453 129 B1**
(45) Date of publication and mention of the grant of the patent: **04.02.2026**
(21) Application number: 22840087.5
(22) Date of filing: 19.12.2022
(51) Int. Cl.: C09K 11/56, C09K 11/70, H10K 50/115, H10K 85/60

(54) **ELECTRONIC DEVICES**
ELEKTRONISCHE VORRICHTUNGEN
DISPOSITIFS ÉLECTRONIQUES

(30) Priority: 21.12.2021 EP 21216503
(43) Date of publication of application: 30.10.2024
(73) Proprietor: Samsung Electronics Co., Ltd, Suwon-si, Gyeonggi-do 16677 (KR)
(72) Inventor: ENGEL, Miriam, 64293 DARMSTADT (DE); MEYER, Sebastian, 64293 DARMSTADT (DE); HAMBURGER, Manuel, 64293 DARMSTADT (DE); MAY, Falk, 64293 DARMSTADT (DE); BOEHM, Edgar, 64293 DARMSTADT (DE)
(74) Representative: Appleyard Lees IP LLP
(86) International application number: PCT/EP2022/086544
(87) International publication number: WO 2023/117836

(56) References cited:
- JP-A- 2015 187 942
- JP-A- 2019 033 005
- US-A1- 2021 091 327

## Description

The present invention relates to electronic devices, in particular electroluminescent devices (EL devices), methods for preparing the electronic devices, compositions comprising at least one semiconducting light emitting nanoparticle, such as a quantum dot, and at least one spirobifluorene-amine-based compound, and formulations comprising the compositions.

Electronic devices in the context of this application are understood to mean so-called electroluminescent devices such as light emitting diodes (LEDs), which employ semiconducting nanoparticles such as quantum dots (QD) as light emitting materials. As used herein, electroluminescent devices should be understood to also include organic electroluminescent devices, such as an organic light emitting diode (OLED), which comprises one or more layers including organic compounds as functional materials. Accordingly, the term organic electroluminescent devices in the context of the present application is understood to also include such hybrid systems of organic electroluminescent devices, such as OLEDs, which employ inorganic semiconducting nanoparticles such as quantum dots (QD) as light emitting materials.

Electroluminescent devices based on quantum dots (EL-QD-LED) as the emitters show the potential of narrow full-width FWHM, tunable emission wavelength and high quantum efficiencies (Adv. Mater. 2017, 29, 1607022).

US 2021/091327 discloses an electroluminescent device and display device comprising same, JP 2015 187942 discloses a light emitting element, method for manufacturing light emitting element and display device, and JP 2019 033005 discloses a light emitting element.

Reported devices are often based on Cd-containing quantum dots in the emissive layer, which are often also deployed as monolayers or bare quantum dot emissive layers, as described in US 2015/022885 A1.

EL-QD-LEDs based on bare quantum dot emissive layers, with the quantum dots moreover being Cd-free, suffer from strong film-inhomogeneity, poor device performance and poor transport characteristics. Typically, these QDs can only be formulated in high concentrated inks to avoid degradation or storage instability.

In view of the disadvantages described above, it has been proposed to embed and homogeneously distribute the quantum dots in an organic matrix and to additionally add a transporting moiety, such as polymers as described in CN 105900529 B, or small molecules having a triphenylamine skeleton as described in JP 2019-33005 A, to the emissive layer.

However, there is still a need for electric devices based on semiconducting light emitting nanoparticles such as quantum dots, which are in particular Cd-free and exhibit improved device performance, improved stability as well as improved transport characteristics.

It is therefore an object of the present invention to provide an electric device, in particular an organic electroluminescent device, based on semiconducting light emitting nanoparticles such as quantum dots, in particular Cd-free quantum dots, which exhibits improved device performance, in particular reduced voltage, high efficiencies and longer lifetime,and improved transport characteristics.

Surprisingly, it has been found that an improvement of layer film homogeneity and morphology, improved device performance, in particular reduced voltage, high efficiency and long-term stability, and improved transport characteristics, as well as improved ink and film stability, can be achieved by using a spirobifluorene-amine small molecule as described herein in combination with semiconducting light emitting nanoparticles such as quantum dots, in particular Cd-free quantum dots, in an electronic device, in particular in the light-emitting layer of the electronic device, and in a formulation, respectively, to thereby solve one or more of the objects mentioned above.

According to the present invention, there is provided an electronic device according to claim 1, a method for preparing an electronic device according to claim 13, a composition according to claim 14 and a formulation according to claim 15.

The present invention therefore relates to an electronic device comprising anode, cathode and at least one layer which comprises the following compounds:
a) at least one semiconducting light emitting nanoparticle; and
b) at least one compound selected from the formulae (2) to (5), (10) and (11): 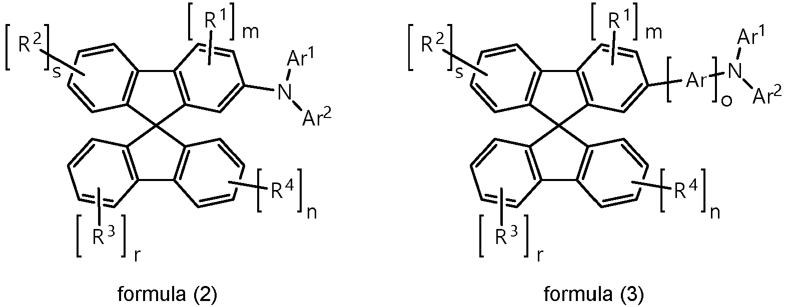 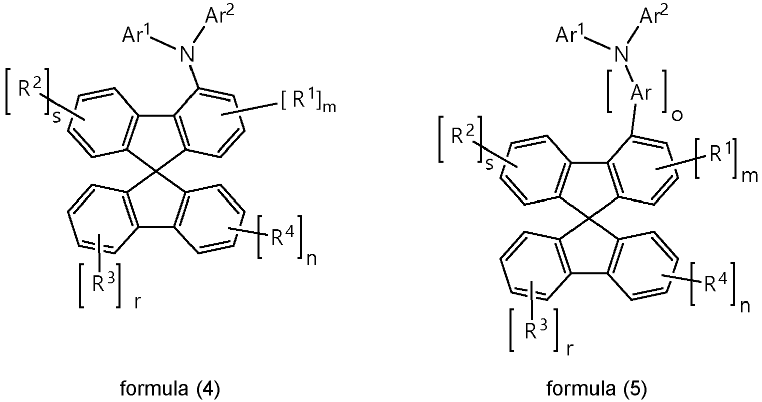 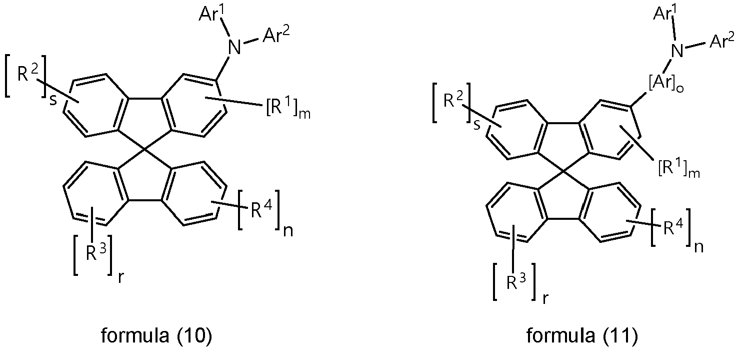
where the following applies to the symbols and indices used:
- Ar: is, identically or differently on each occurrence, an aromatic ring system selected from the group consisting of benzene, naphthalene, phenanthrene, fluorene, spirobifluorene, dibenzofuran and dibenzothiophene, each of which may be substituted by one or more radicals R^{5a}; Ar may also be connected to Ar¹ and/or to Ar² here by a group E;
- Ar¹, Ar²: are, identically or differently on each occurrence, an aromatic or heteroaromatic ring system having 6 to 60 C, each of which may also be substituted by one or more radicals R^{5a}; Ar¹ and Ar² here may also be connected to one another and/or Ar¹ may be connected to Ar and/or Ar² may be connected to Ar by a group E;
- E: is on each occurrence, identically or differently, a single bond, C(R^{5a})₂, NR^{5a}, O or S;
- R¹, R², R³: are selected on each occurrence, identically or differently, from the group consisting of H, D, F, Cl, Br, I, CN, Si(R⁶)₃, a straight-chain alkyl, alkoxy or thioalkyl group having 1 to 40 C atoms or a branched or cyclic alkyl, alkoxy or thioalkyl group having 3 to 40 C atoms, each of which may be substituted by one or more radicals R⁶, where in each case one or more non-adjacent CH₂ groups may be replaced by Si(R⁶)₂, C=NR⁶, P(=O)(R⁶), SO, SO₂, NR⁶, O, S or CONR⁶ and where one or more H atoms may be replaced by D, F, Cl, Br or I, an aromatic or heteroaromatic ring system having 6 to 60 C atoms, which may in each case be substituted by one or more radicals R⁶, an aryloxy group having 5 to 60 aromatic ring atoms, which may be substituted by one or more radicals R⁶, or an aralkyl group having 5 to 60 aromatic ring atoms, which may in each case be substituted by one or more radicals R⁶, where two or more adjacent substituents R¹ or R² or R³ may optionally form a mono- or polycyclic, aliphatic ring system, which may be substituted by one or more radicals R⁶;
- R⁴: is selected, identically or differently on each occurrence, from the group consisting of H, D, F, Cl, Br, I, CN, Si(R⁶)₃, a straight-chain alkyl, alkoxy or thioalkyl group having 1 to 40 C atoms or a branched or cyclic alkyl, alkoxy or thioalkyl group having 3 to 40 C atoms, each of which may be substituted by one or more radicals R⁶, where in each case one or more non-adjacent CH₂ groups may be replaced by Si(R⁶)₂, C=NR⁶, P(=O)(R⁶), SO, SO₂, O, S or CONR⁶ and where one or more H atoms may be replaced by D, F, Cl, Br or I, an aromatic or heteroaromatic ring system having 6 to 60 C atoms, which may in each case be substituted by one or more radicals R⁶, an aryloxy group having 5 to 60 aromatic ring atoms, which may be substituted by one or more radicals R⁶, or an aralkyl group having 5 to 60 aromatic ring atoms, which may in each case be substituted by one or more radicals R⁶, where two or more adjacent substituents R⁴ may optionally form a mono- or polycyclic, aliphatic ring system, which may be substituted by one or more radicals R⁶;
- R^{5a}: is selected on each occurrence, identically or differently, from the group consisting of H, D, F, Cl, Br, I, CN, Si(R⁶)₃, N(R⁶)₂ a straight-chain alkyl, alkoxy or thioalkyl group having 1 to 40 C atoms or a branched or cyclic alkyl, alkoxy or thioalkyl group having 3 to 40 C atoms, each of which may be substituted by one or more radicals R⁶, where in each case one or more non-adjacent CH₂ groups may be replaced by Si(R⁶)₂, C=NR⁶, P(=O)(R⁶), SO, SO₂, NR⁶, O, S or CONR⁶ and where one or more H atoms may be replaced by D, F, Cl, Br or I, an aromatic or heteroaromatic ring system having 6 to 60 C atoms, which may in each case be substituted by one or more radicals R⁶, an aryloxy group having 5 to 60 aromatic ring atoms, which may be substituted by one or more radicals R⁶, or an aralkyl group having 5 to 60 aromatic ring atoms, which may in each case be substituted by one or more radicals R⁶, where two or more adjacent substituents R^{5a} may optionally form a mono- or polycyclic, aliphatic ring system, which may be substituted by one or more radicals R⁶;
- R⁶: is selected from the group consisting of H, D, F, an aliphatic hydrocarbon radical having 1 to 20 C atoms or an aromatic or heteroaromatic ring system having 5 to 30 C atoms, in which one or more H atoms may be replaced by D or F, where two or more adjacent substituents R⁶ may form a mono- or polycyclic, aliphatic ring system with one another;
- m: is 0, 1, 2 or 3;
- n: is on each occurrence, identically or differently, 0, 1, 2, 3 or 4;
- o: is on each occurrence, identically or differently, 0, 1 or 2;
- r, s: are on each occurrence, identically or differently, 0, 1, 2, 3 or 4.

An aryl group in the sense of this invention is taken to mean either a simple aromatic ring, i.e. benzene, or a condensed (anellated) aryl group, for example naphthalene or phenanthrene. By contrast, aromatic groups linked to one another by a single bond, such as, for example, biphenyl or fluorene, are not referred to as an aryl group, but instead as an aromatic ring system.

An aromatic ring system in the sense of this invention contains 6 to 60 C atoms in the ring system, where the aromatic ring system is built up from benzene, naphthalene, phenanthrene, fluorene and spirobifluorene or combinations of these groups. An aromatic ring system in the sense of this invention is, in particular, also intended to be taken to mean a system in which, in addition, a plurality of aryl groups is linked to one another directly or via a carbon atom. Thus, for example, substituents such as phenyl, biphenyl, terphenyl, quaterphenyl, fluorenyl, 9,9'-spirobifluorenyl, 9,9-diarylfluorenyl, etc., in particular, are also intended to be taken to be aromatic ring systems in the sense of this invention. The aromatic ring system here by definition contains no amino groups. Triarylamino groups are thus not covered by the definition of an aromatic ring system.

For the purposes of the present invention, an aliphatic hydrocarbon radical or an alkyl group or an alkenyl or alkynyl group, which may typically contain 1 to 40 or also 1 to 20 C atoms and in which, in addition, individual H atoms or CH₂ groups may be substituted by the above-mentioned groups, is preferably taken to mean the radicals methyl, ethyl, n-propyl, i-propyl, n-butyl, i-butyl, s-butyl, t-butyl, 2-methylbutyl, n-pentyl, s-pentyl, neopentyl, cyclopentyl, n-hexyl, neohexyl, cyclohexyl, n-heptyl, cycloheptyl, n-octyl, cyclooctyl, 2-ethylhexyl, trifluoromethyl, pentafluoroethyl, 2,2,2-trifluoroethyl, ethenyl, propenyl, butenyl, pentenyl, cyclopentenyl, hexenyl, cyclohexenyl, heptenyl, cycloheptenyl, octenyl, cyclooctenyl, ethynyl, propynyl, butynyl, pentynyl, hexynyl, heptynyl or octynyl. An alkoxy group having 1 to 40 C atoms is preferably taken to mean methoxy, trifluoromethoxy, ethoxy, n-propoxy, i-propoxy, n-butoxy, i-butoxy, s-butoxy, t-butoxy, n-pentoxy, s-pentoxy, 2-methylbutoxy, n-hexoxy, cyclohexyloxy, n-heptoxy, cycloheptyloxy, n-octyloxy, cyclooctyloxy, 2-ethylhexyloxy, pentafluoroethoxy or 2,2,2-trifluoroethoxy. A thioalkyl group having 1 to 40 C atoms is taken to mean, in particular, methylthio, ethylthio, n-propylthio, i-propylthio, n-butylthio, i-butylthio, s-butylthio, t-butylthio, n-pentylthio, s-pentylthio, n-hexylthio, cyclohexylthio, n-heptylthio, cycloheptylthio, n-octylthio, cyclooctylthio, 2-ethylhexylthio, trifluoromethylthio, pentafluoroethylthio, 2,2,2-trifluoroethyl-thio, ethenylthio, propenylthio, butenylthio, pentenylthio, cyclopentenylthio, hexenylthio, cyclohexenylthio, heptenylthio, cycloheptenylthio, octenylthio, cyclooctenylthio, ethynylthio, propynyl-thio, butynylthio, pentynylthio, hexynylthio, heptynylthio or octynylthio. In general, alkyl, alkoxy or thioalkyl groups in accordance with the present invention can be straight-chain, branched or cyclic, where one or more non-adjacent CH₂ groups may be replaced by the above-mentioned groups; furthermore, one or more H atoms may also be replaced by D, F, Cl, Br, I, CN or NO₂, preferably F, CI or CN, further preferably F or CN, particularly preferably CN.

In a more preferred embodiment of the invention, the compound is selected from the compounds of the following formulae (2a-1) to (2a-3), (3a-1) to (3a-3), (4a), (5a), (10a) and (11a) 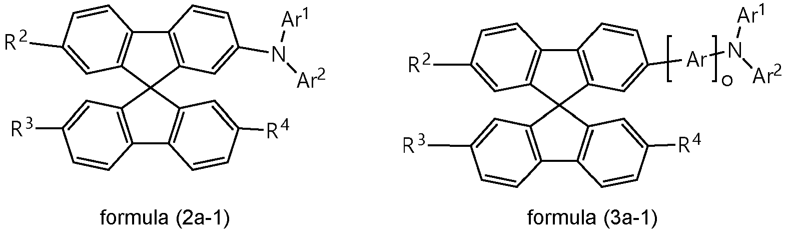 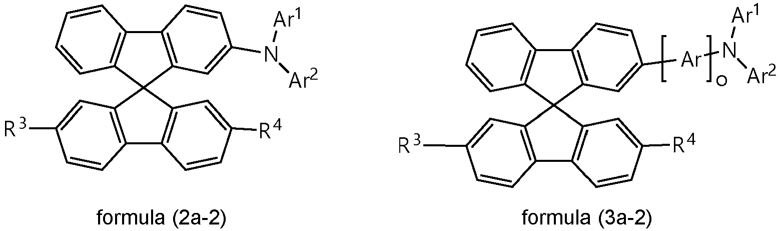 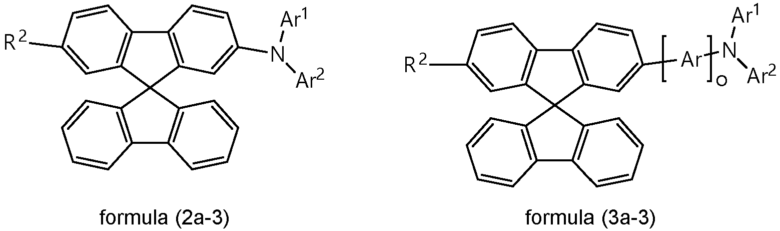 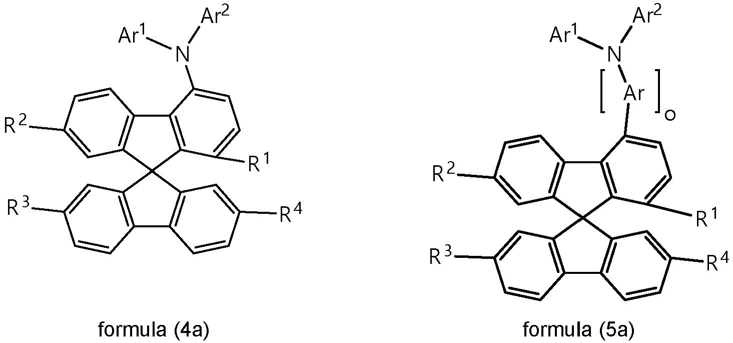 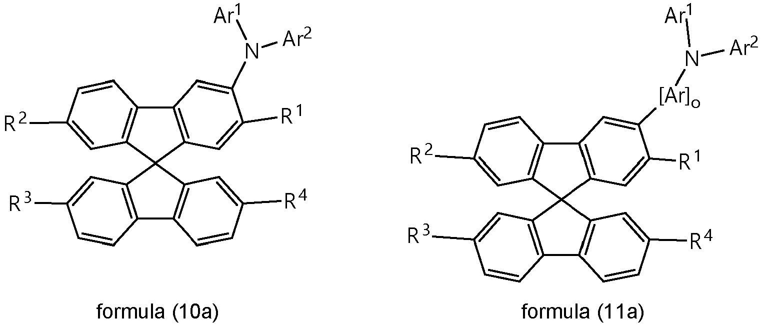 where the symbols and indices used have the meanings given above.

In a particularly preferred embodiment of the invention, the compound is selected from the compounds of the following formulae (2b) to (5b), (10b) and (11b) 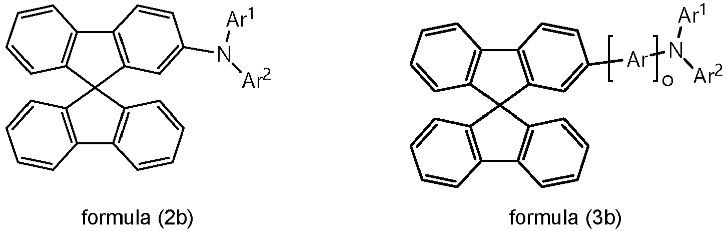 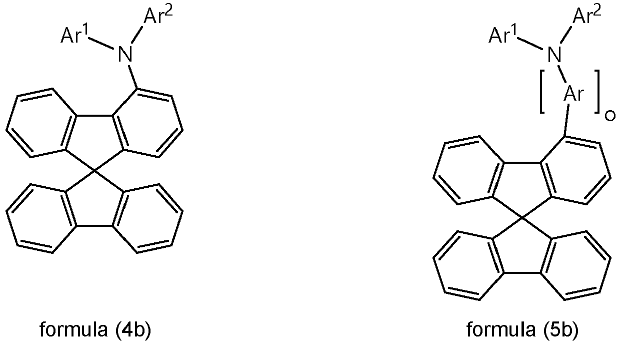 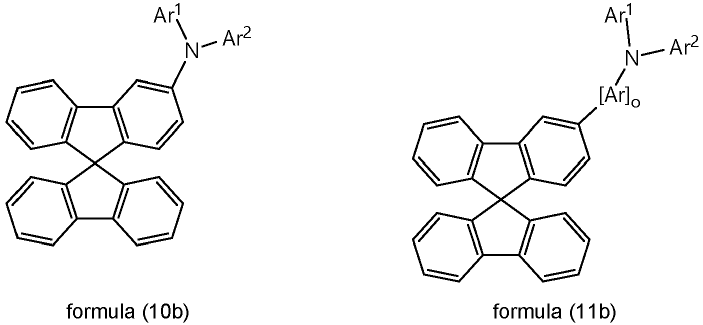 where the symbols and indices used have the meanings given above.

In a very particularly preferred embodiment of the invention, the compound according to the invention is a monoamine compound and accordingly contains only one diarylamino group -NAr¹Ar². This thus relates preferably to compounds of the formulae (2), (3), (4), (5) and (10), or (2a-1), (2a-2), (2a-3), (3a-1), (3a-2), (3a-3), (4a), (5a) and (10a), or (2b), (3b), (4b), (5b) and (10b).

In a further preferred embodiment of the invention, the groups Ar¹ and Ar² are selected, identically or differently on each occurrence, from the group consisting of fluorenyl, spirobifluorenyl, phenyl, biphenyl, terphenyl, quaterphenyl, carbazolyl, dibenzofuranyl, dibenzothiophenyl, naphthyl and phenantryl, each of which may be substituted, identically or differently, by one or more radicals R^{5a} as defined herein. Preferably, groups Ar¹ and Ar² are unsubstituted.

The groups Ar¹ and Ar² are preferably selected, identically or differently on each occurrence, from the groups of the following formulae (Ar-1) to (Ar-123)

| | | |
|---|---|---|
| 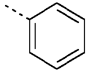 | 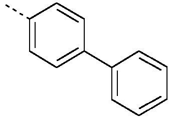 | 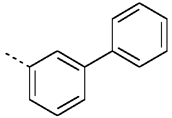 |
| Ar-1 | Ar-2 | Ar-3 |
| 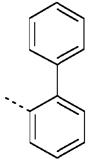 | 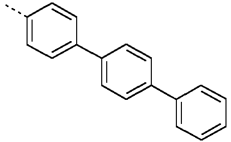 | 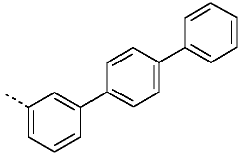 |
| Ar-4 | Ar-5 | Ar-6 |
| 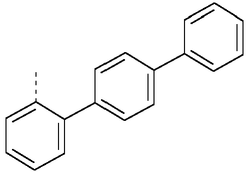 | 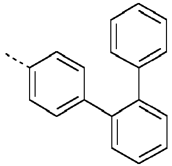 | 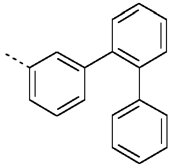 |
| Ar-7 | Ar-8 | Ar-9 |
| 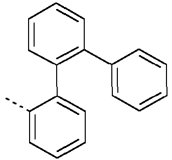 | 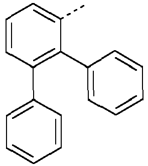 | 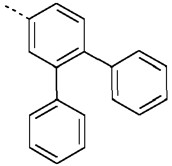 |
| Ar-10 | Ar-11 | Ar-12 |
| 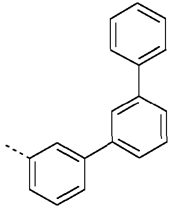 | 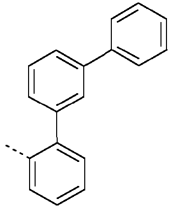 | 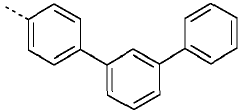 |
| Ar-13 | Ar-14 | Ar-15 |
| 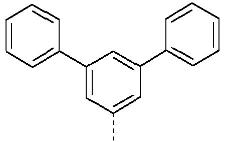 | 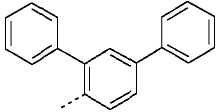 | 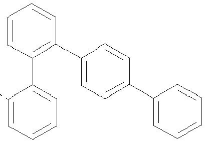 |
| Ar-16 | Ar-17 | Ar-18 |
| 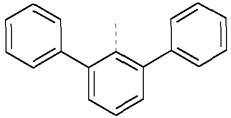 | | |
| Ar-19 | | |
| 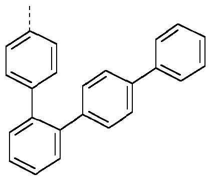 | 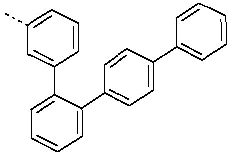 | 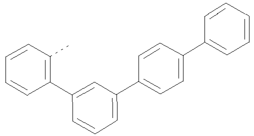 |
| Ar-20 | Ar-21 | Ar-22 |
| 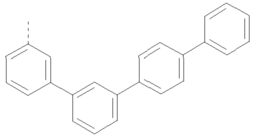 | 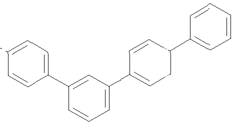 | 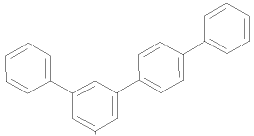 |
| Ar-23 | Ar-24 | Ar-25 |
| 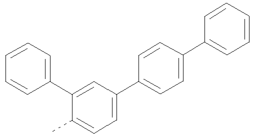 | 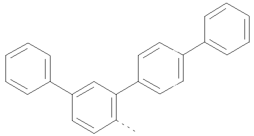 | 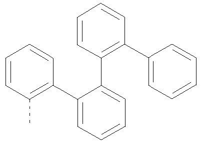 |
| Ar-26 | Ar-27 | Ar-28 |
| 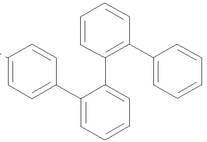 | 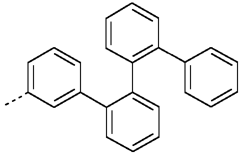 | 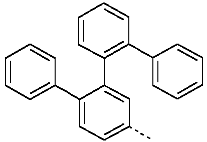 |
| Ar-29 | Ar-30 | Ar-31 |
| 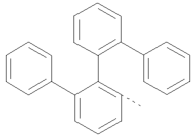 | 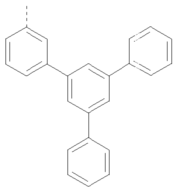 | 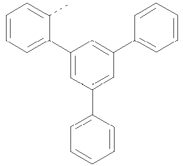 |
| Ar-32 | Ar-33 | Ar-34 |
| 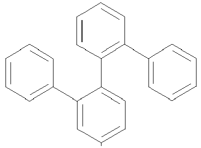 | 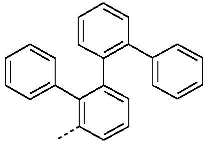 | 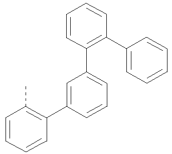 |
| Ar-35 | Ar-36 | Ar-37 |
| 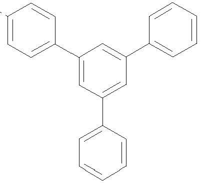 | 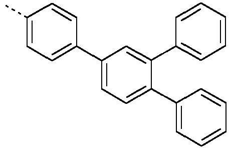 | 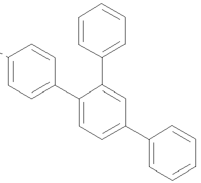 |
| Ar-38 | Ar-39 | Ar-40 |
| 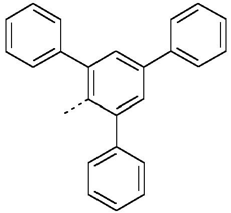 | 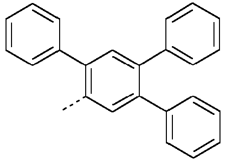 | 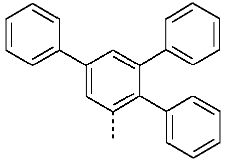 |
| Ar-41 | Ar-42 | Ar-43 |
| 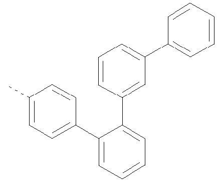 | 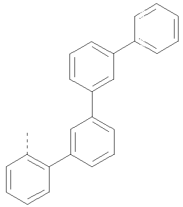 | 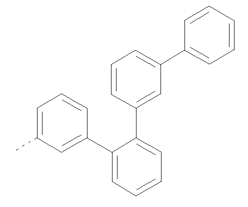 |
| Ar-44 | Ar-45 | Ar-46 |
| 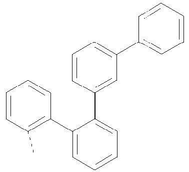 | | |
| Ar-47 | | |
| 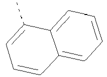 | 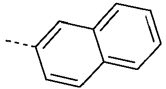 | 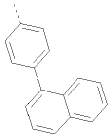 |
| Ar-48 | Ar-49 | Ar-50 |
| 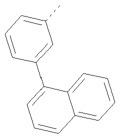 | 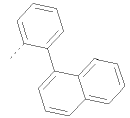 | 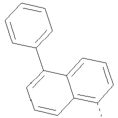 |
| Ar-51 | Ar-52 | Ar-53 |
| 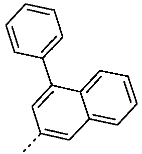 | 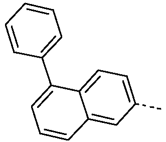 | 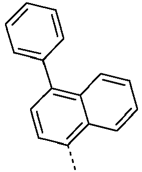 |
| Ar-54 | Ar-55 | Ar-56 |
| 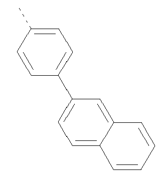 | 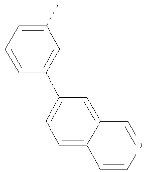 | 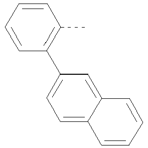 |
| Ar-57 | Ar-58 | Ar-59 |
| 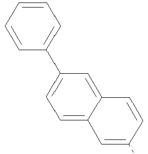 | 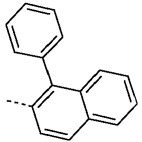 | 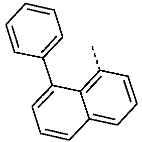 |
| Ar-60 | Ar-61 | Ar-62 |
| 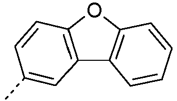 | 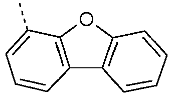 | 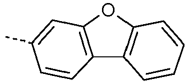 |
| Ar-63 | Ar-64 | Ar-65 |
| 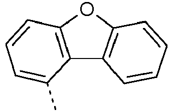 | 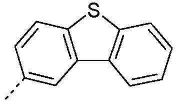 | 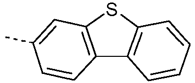 |
| Ar-66 | Ar-67 | Ar-68 |
| 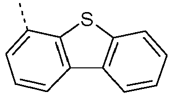 | 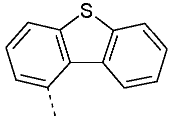 | 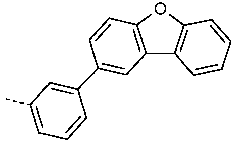 |
| Ar-69 | Ar-70 | Ar-71 |
| 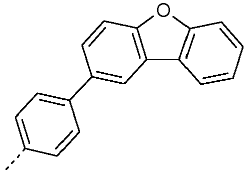 | 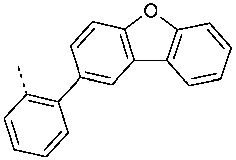 | 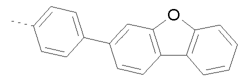 |
| Ar-72 | Ar-73 | Ar-74 |
| 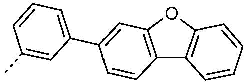 | 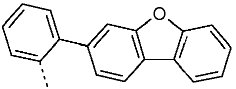 | 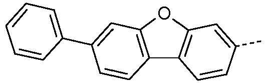 |
| Ar-75 | Ar-76 | Ar-77 |
| 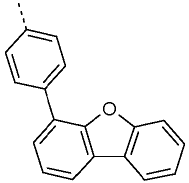 | 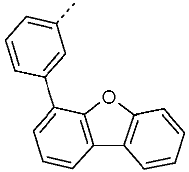 | 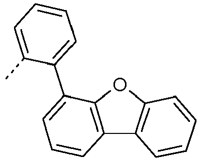 |
| Ar-78 | Ar-79 | Ar-80 |
| 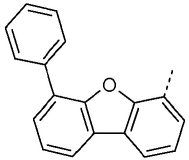 | 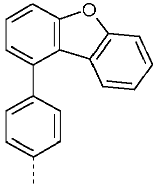 | 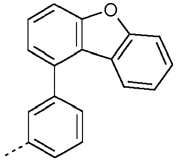 |
| Ar-81 | Ar-82 | Ar-83 |
| 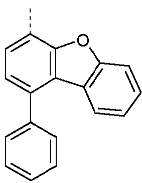 | 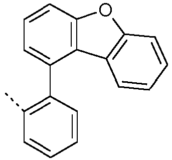 | 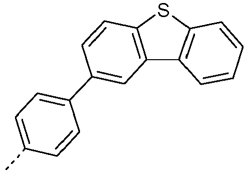 |
| Ar-84 | Ar-85 | Ar-86 |
| 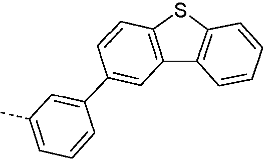 | 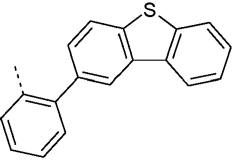 | 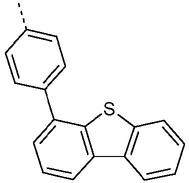 |
| Ar-87 | Ar-88 | Ar-89 |
| 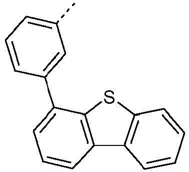 | 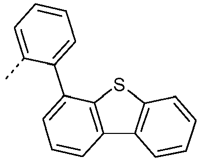 | 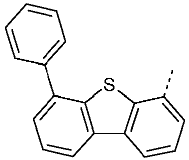 |
| Ar-90 | Ar-91 | Ar-92 |
| 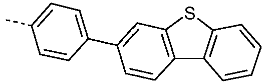 | 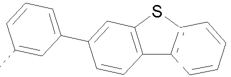 | 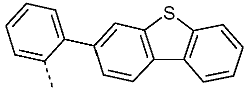 |
| Ar-93 | Ar-94 | Ar-95 |
| 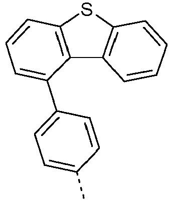 | 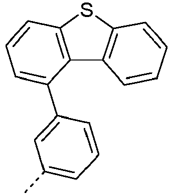 | 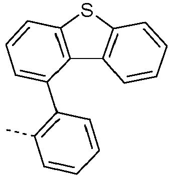 |
| Ar-96 | Ar-97 | Ar-98 |
| 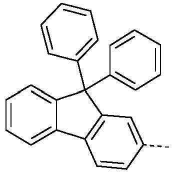 | 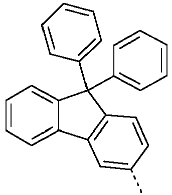 | 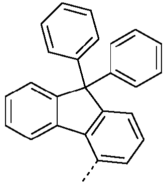 |
| Ar-99 | Ar-100 | Ar-101 |
| 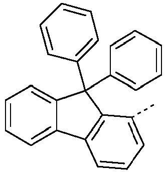 | 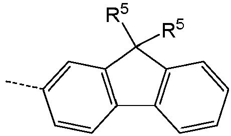 | 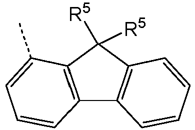 |
| Ar-102 | Ar-103 | Ar-104 |
| 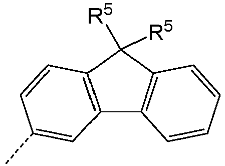 | 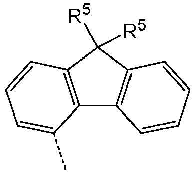 | 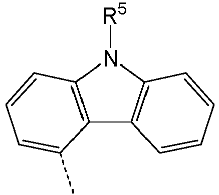 |
| Ar-105 | Ar-106 | Ar-107 |
| 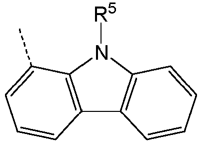 | 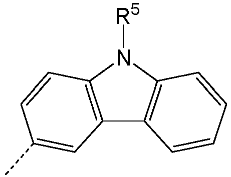 | 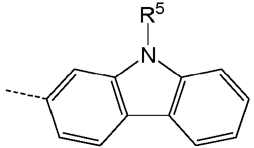 |
| Ar-108 | Ar-109 | Ar-110 |
| 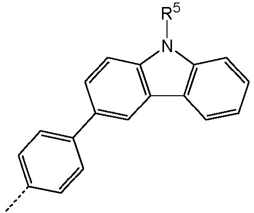 | 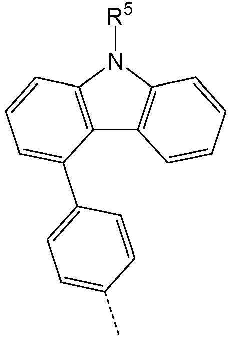 | 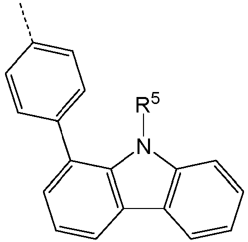 |
| Ar-111 | Ar-112 | Ar-113 |
| 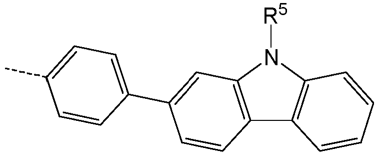 | | 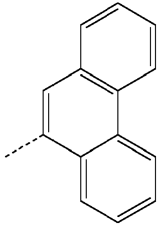 |
| Ar-114 | | Ar-115 |
| 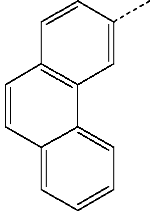 | 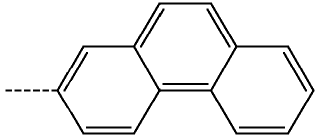 | |
| Ar-116 | Ar-117 | |
| 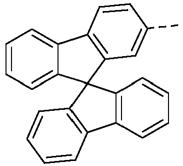 | 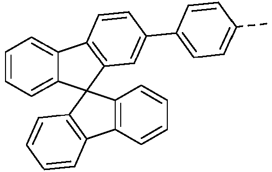 | |
| Ar-118 | Ar-119 | |
| 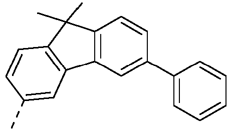 | 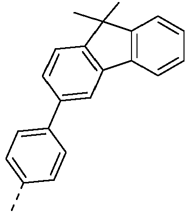 | |
| Ar-120 | Ar-120 | |
| 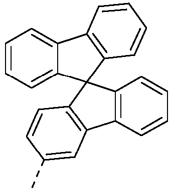 | 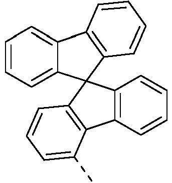 | |
| Ar-121 | Ar-122 | |
| 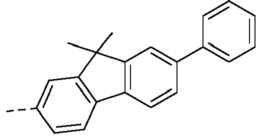 | | |
| Ar-123 | | |

where the dashed bond indicates the bond to the nitrogen, and the groups may be substituted, identically or differently, by one or more radicals R^{5a} as defined herein, but are preferably unsubstituted.

R⁵ in the groups of the formulae (Ar-103) to (Ar-114) has the same meaning as given above for R^{5a}.

Preferably, R⁵ in the groups of the formulae (Ar-103) to (Ar-106) stands, identically or differently, for an alkyl group having 1 to 10 C atoms, in particular for methyl, or a phenyl group, which may be substituted by one or more radicals R⁶.

Furthermore, R⁵ in the groups of the formulae (Ar-107) to (Ar-114), preferably stands for a phenyl group, which may be substituted by one or more radicals R⁶.

The two groups Ar¹ and Ar² of the above-mentioned formulae (Ar-1) to (Ar-123), which are bonded to the nitrogen, can be combined with one another as desired. The groups of the formulae (Ar-1), (Ar-2), (Ar-3), (Ar-4), (Ar-5), (Ar-6), (Ar-8), (Ar-9), (Ar-10), (Ar-12), (Ar-13), (Ar-15), (Ar-16), (Ar-17), (Ar-18), (Ar-19), (Ar-20), (Ar-31), (Ar-38), (Ar-41), (Ar-48), (Ar-49), (Ar-52), (Ar-63), (Ar-64), (Ar-65), (Ar-66), (Ar-71), (Ar-72), (Ar-73), (Ar-74), (Ar-75), (Ar-76), (Ar-77), (Ar-78), (Ar-79), (Ar-80), (Ar-81), (Ar-82), (Ar-83), (Ar-84), (Ar-85), (Ar-99), (Ar-100), (Ar-101), (Ar-103), (Ar-104), (Ar-105), (Ar-106), (Ar-107), (Ar-111), (Ar-115), (Ar-116), (Ar-117), (Ar-118), (Ar-119), (Ar-120), (Ar-121) and (Ar-122) are particularly preferred here.

Very particular preference for Ar¹ and Ar² is given to groups of the formulae (Ar-1), (Ar-2), (Ar-3), (Ar-4), (Ar-12), (Ar-16), (Ar-17), (Ar-18), (Ar-19), (Ar-38), (Ar-48), (Ar-49), (Ar-52), (Ar-63), (Ar-64), (Ar-65), (Ar-66), (Ar-71), (Ar-72), (Ar-73), (Ar-74), (Ar-75), (Ar-76), (Ar-77), (Ar-78), (Ar-79), (Ar-80), (Ar-81), (Ar-82), (Ar-83), (Ar-84), (Ar-85), (Ar-99), (Ar-100), (Ar-103), (Ar-105), (Ar-106), (Ar-107), (Ar-115), (Ar-116), (Ar-117), (Ar-118) and (Ar-119), which can be combined with one another as desired.

In a preferred embodiment of the invention, the groups Ar¹ and Ar² are different from one another.

If the groups Ar¹ and Ar² in the compounds selected from the formulae (2) to (5), (10) and (11) and (2a-1) to (2a-3), (3a-1) to (3a-3), (4a), (5a), (10a) and (11a) and (2b) to (5b), (10b) and (11b) are linked to one another by a group E, the group -NAr¹Ar² then preferably has the structure of one of the following formulae (Ar-124) to (Ar-128), 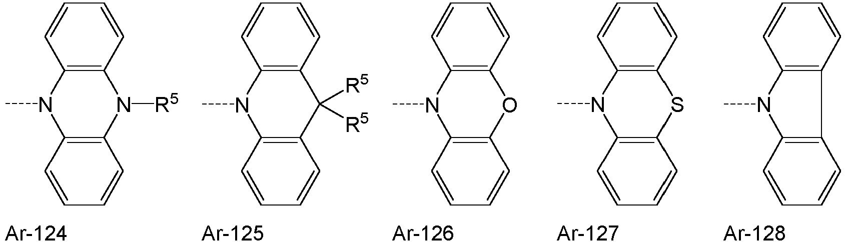 where the symbols used have the meanings given above, and the dashed bond indicates the bond to the spirobifluorene or to Ar. These groups may also be substituted by one or more radicals R^{5a}, but are preferably unsubstituted.

R⁵ in the groups of the formulae (Ar-124) and (Ar-125) has the same meaning as given above for R^{5a}.

Preferably, R⁵ in the group of the formula (Ar-124) stands for a phenyl group, which may be substituted by one or more radicals R⁶.

Furthermore, R⁵ in the group of the formula (Ar-125) preferably stands, identically or differently, for an alkyl group having 1 to 10 C atoms, in particular for methyl, or a phenyl group, which may be substituted by one or more radicals R⁶.

If the group Ar is linked to Ar¹ by a group E, the group -Ar-NAr¹Ar² then preferably has the structure of one of the following formulae (Ar-129) to (Ar-133), and the dashed bond indicates the bond to the spirobifluorene. An analogous situation applies to the linking of the group Ar to Ar². 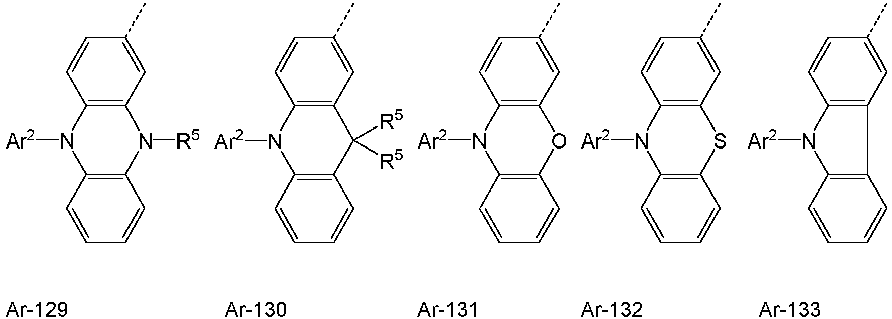 where the symbols used have the meanings given above, and the dashed bond indicates the bond to the spirobifluorene. These groups may also be substituted by one or more radicals R^{5a}, but are preferably unsubstituted.

R⁵ in the groups of the formulae (Ar-129) and (Ar-130) has the same meaning as given above for R^{5a}.

Preferably, R⁵ in the group of the formula (Ar-129) stands for a phenyl group, which may be substituted by one or more radicals R⁶.

Furthermore, R⁵ in the group of the formula (Ar-130) preferably stands, identically or differently, for an alkyl group having 1 to 10 C atoms, in particular for methyl, or a phenyl group, which may be substituted by one or more radicals R⁶.

In a further preferred embodiment of the invention, the index o = 1 or 2, more preferably o = 1, and the group -(Ar)ₒ- stands for a group of one of the following formulae (Ar-134) to (Ar-148):

| | | |
|---|---|---|
| 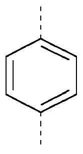 | 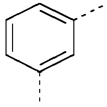 | 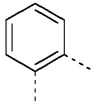 |
| Ar-134 | Ar-135 | Ar-136 |
| 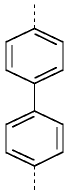 | 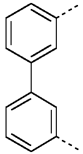 | 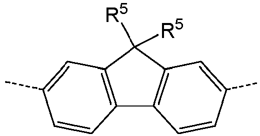 |
| Ar-137 | Ar-138 | Ar-139 |
| 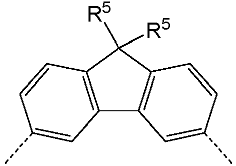 | 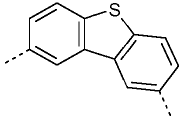 | 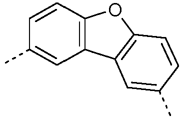 |
| Ar-140 | Ar-141 | Ar-142 |
| 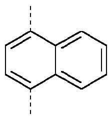 | 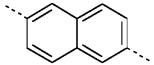 | 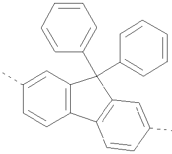 |
| Ar-143 | Ar-144 | Ar-145 |
| 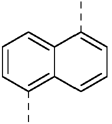 | 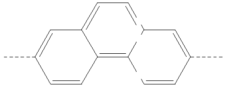 | 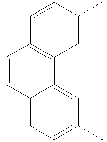 |
| Ar-146 | Ar-147 | Ar-148 |

where the symbols used have the meanings given above, and one dashed bond indicates the bond to the spirobifluorene and the other dashed bond indicates the bond to the nitrogen atom. These groups may also be substituted, identically or differently, by one or more radicals R^{5a} as defined herein, but are preferably unsubstituted.

The groups of the formulae (Ar-134), (Ar-135), (Ar-136), (Ar-137), (Ar-138), (Ar-139), (Ar-140), (Ar-142), (Ar-143), (Ar-144), (Ar-145), (Ar-146), (Ar-147) and (Ar-148) are particularly preferred here. Very particular preference for -(Ar)ₒ- is given to groups of the formulae (Ar-134), (Ar-135), (Ar-136), (Ar-137), (Ar-138), (Ar-139), (Ar-140), (Ar-142), (Ar-143) and (Ar-145).

R⁵ in the groups of the formulae (Ar-139) and (Ar-140) preferably stands, identically or differently, for an alkyl group having 1 to 10 C atoms, in particular for methyl, or a phenyl group, which may be substituted by one or more radicals R⁶.

Very particularly preferred are the compounds of the formulae (2), (4) and (10), or (2a-1), (2a-2), (2a-3), (4a) and (10a), or (2b), (4b) and (10b).

In a preferred embodiment of the invention, R¹ to R³ are selected, identically or differently on each occurrence, from the group consisting of H, D, F, Si(R⁶)₃, CN, a straight-chain alkyl or alkoxy group having 1 to 10 C atoms or a branched or cyclic alkyl or alkoxy group having 3 to 10 C atoms, each of which may be substituted by one or more radicals R⁶, where in each case one or more non-adjacent CH₂ groups may be replaced by O and where one or more H atoms may be replaced by D or F, an aromatic or heteroaromatic ring system having 6 to 24 aromatic ring atoms, which is preferably selected from the group consisting of benzene, naphthalene, phenanthrene, fluorene, spirobifluorene or a combination of two or three of these groups, and which may in each case be substituted by one or more radicals R⁶.

In a particularly preferred embodiment of the invention, R¹ to R³ are selected on each occurrence, identically or differently, from the group consisting of H, F, a straight-chain alkyl group having 1 to 5 C atoms or a branched or cyclic alkyl group having 3 to 6 C atoms, an aromatic or heteroaromatic ring system having 5 to 18 aromatic ring atoms, which is preferably selected from the group consisting of benzene, naphthalene, phenanthrene, fluorene, spirobifluorene or a combination of two or three of these groups, and which may in each case be substituted by one or more radicals R⁶.

In a preferred embodiment of the invention, R⁴ is selected, identically or differently on each occurrence, from the group consisting of H, D, F, Si(R⁶)₃, CN, a straight-chain alkyl or alkoxy group having 1 to 10 C atoms or a branched or cyclic alkyl or alkoxy group having 3 to 10 C atoms, each of which may be substituted by one or more radicals R⁶, where in each case one or more non-adjacent CH₂ groups may be replaced by O and where one or more H atoms may be replaced by D or F, an aromatic or heteroaromatic ring system having 6 to 24 aromatic ring atoms, which is preferably selected from the group consisting of benzene, naphthalene, phenanthrene, fluorene, spirobifluorene or a combination of two or three of these groups, and which may in each case be substituted by one or more radicals R⁶.

In a particularly preferred embodiment of the invention, R⁴ is selected on each occurrence, identically or differently, from the group consisting of H, F, a straight-chain alkyl group having 1 to 5 C atoms or a branched or cyclic alkyl group having 3 to 6 C atoms, an aromatic or heteroaromatic ring system having 5 to 18 aromatic ring atoms, which is preferably selected from the group consisting of benzene, naphthalene, phenanthrene, fluorene, spirobifluorene or a combination of two or three of these groups, and which may in each case be substituted by one or more radicals R⁶.

R¹ to R⁴ in the compounds of the formulae (2) to (5), (10) and (11) and (2a-1) to (2a-3), (3a-1) to (3a-3), (4a), (5a), (10a) and (11a) are very particularly preferably selected, identically or differently on each occurrence, from the group consisting of H, methyl, tert-butyl, phenyl and fluorine.

In a further preferred embodiment of the invention, the radical R^{5a} which is bonded to Ar, Ar¹ and/or Ar² is selected, identically or differently on each occurrence, from the group consisting of H, D, F, CN, a straight-chain alkyl group having 1 to 10 C atoms, a branched or cyclic alkyl group having 3 to 10 C atoms or an aromatic or heteroaromatic ring system having 5 to 24 aromatic ring atoms, each of which may be substituted by one or more radicals R⁶.

In a particularly preferred embodiment of the invention, the radical R^{5a} which is bonded to Ar, Ar¹ and/or Ar² is selected, identically or differently on each occurrence, from the group consisting of H, a straight-chain alkyl group having 1 to 5 C atoms, a branched or cyclic alkyl group having 3 to 6 C atoms or an aromatic or heteroaromatic ring system having 5 to 24 aromatic ring atoms, each of which may be substituted by one or more radicals R⁶.

In another particularly preferred embodiment, the radical R^{5a} which is bonded to Ar¹ and/or Ar² is D, and group Ar¹ and/or Ar² is fully or partially deuterated. In particular, the groups of the formulae (Ar-1) to (Ar-123) given above may be fully or partially deuterated.

The radicals R¹ to R⁶ here preferably contain no condensed aryl or heteroaryl groups in which more than two aromatic or heteroaromatic six-membered rings are condensed directly onto one another, i.e., for example, no anthracene or pyrene groups. The radicals R¹ to R⁶ particularly preferably contain absolutely no condensed aryl or heteroaryl groups in which aromatic or heteroaromatic six-membered rings are condensed directly onto one another, i.e. also, for example, no naphthalene groups.

It may furthermore be preferred for the two substituents R⁵ in the 9-position of a fluorene together to form a cycloalkyl ring, preferably having 3 to 8 C atoms, particularly preferably having 5 or 6 C atoms.

Likewise, the two substituents R⁵ in formula (Ar-125) or formula (Ar-130) may form a ring system with one another and thus form a spiro system, for example a cycloalkyl ring, preferably having 3 to 8 C atoms, particularly preferably having 5 or 6 C atoms.

In a preferred embodiment of the invention, R⁶ is selected, identically or differently on each occurrence, from the group consisting of H, a straight-chain alkyl group having 1 to 10 C atoms or a branched or cyclic alkyl group having 3 to 10 C atoms or an aromatic ring system having 6 to 24 C atoms. R⁶ is particularly preferably, identically or differently on each occurrence, H or a methyl group, very particularly preferably H.

Particular preference is given to compounds of the formulae (2) to (5), (10) and (11) and (2a-1) to (2a-3), (3a-1) to (3a-3), (4a), (5a), (10a) and (11a) and (2b) to (5b), (10b) and (11b) in which the preferred embodiments mentioned above occur simultaneously. Particular preference is therefore given to compounds for which:
- Ar: is, identically or differently on each occurrence, an aromatic ring system, where, for o = 1 or 2, -(Ar)ₒ- is selected from the groups of the formulae (Ar-134) to (Ar-148); each of which may also be substituted by one or more radicals R^{5a}; Ar here may also be connected to Ar¹ and/or Ar² by a group E;
- Ar¹, Ar²: are, identically or differently on each occurrence, an aromatic ring system selected from the groups of the formulae (Ar-1) to (Ar-123);
or -NAr¹Ar² stands for a group of one of the formulae (Ar-124) to (Ar-128);
or -Ar-NAr¹Ar² stands for a group of one of the formulae (Ar-129) to (Ar-133);
each of which may also be substituted by one or more radicals R^{5a}
- E: is on each occurrence, identically or differently, a single bond, C(R^{5a})₂, NR^{5a}, O or S;
- R¹ to R³: are selected, identically or differently on each occurrence, from the group consisting of H, D, F, Si(R⁶)₃, CN, a straight-chain alkyl or alkoxy group having 1 to 10 C atoms or a branched or cyclic alkyl or alkoxy group having 3 to 10 C atoms, each of which may be substituted by one or more radicals R⁶, where in each case one or more non-adjacent CH₂ groups may be replaced by O and where one or more H atoms may be replaced by D or F, an aromatic or heteroaromatic ring system having 6 to 24 aromatic ring atoms, which is preferably selected from the group consisting of benzene, naphthalene, phenanthrene, fluorene, spirobifluorene or a combination of two or three of these groups, and which may in each case be substituted by one or more radicals R⁶;
- R⁴: is selected, identically or differently on each occurrence, from the group consisting of H, D, F, Si(R⁶)₃, CN, a straight-chain alkyl or alkoxy group having 1 to 10 C atoms or a branched or cyclic alkyl or alkoxy group having 3 to 10 C atoms, each of which may be substituted by one or more radicals R⁶, where in each case one or more non-adjacent CH₂ groups may be replaced by O and where one or more H atoms may be replaced by D or F, an aromatic or heteroaromatic ring system having 6 to 24 aromatic ring atoms, which is preferably selected from the group consisting of benzene, naphthalene, phenanthrene, fluorene, spirobifluorene or a combination of two or three of these groups, and which may in each case be substituted by one or more radicals R⁶;
- R^{5a}: is, if the radical R^{5a} is bonded to Ar¹ or Ar², selected, identically or differently on each occurrence, from the group consisting of H, D, F, CN, a straight-chain alkyl group having 1 to 10 C atoms, a branched or cyclic alkyl group having 3 to 10 C atoms or an aromatic or heteroaromatic ring system having 5 to 24 aromatic ring atoms, each of which may be substituted by one or more radicals R⁶;
- R⁵: which is bonded to the carbon bridge in the formulae (Ar-103) to (Ar-106), and (Ar-125) and (Ar-130) is, identically or differently, an alkyl group having 1 to 10 C atoms, in particular methyl, or a phenyl group, which may be substituted by one or more radicals R⁶; or R⁵ which is bonded to the nitrogen bridge in the formulae (Ar-107) to (Ar-114), (Ar-124) and (Ar-129) is a phenyl group, which may be substituted by one or more radicals R⁶;
- R⁶: is selected on each occurrence, identically or differently, from the group consisting of H, a straight-chain alkyl group having 1 to 10 C atoms or a branched or cyclic alkyl group having 3 to 10 C atoms or an aromatic ring system having 6 to 24 C atoms;
- m: is 0, 1 or 2, preferably 0 or 1, more preferably 0;
- n: is 0, 1 or 2, preferably 0 or 1;
- o: is on each occurrence, identically or differently, 0, 1 or 2;
- r: is 0, 1 or 2, preferably 0 or 1;
- s: is 0, 1 or 2, preferably 0 or 1.

Examples of suitable compounds according to the invention are the compounds shown in the following table:

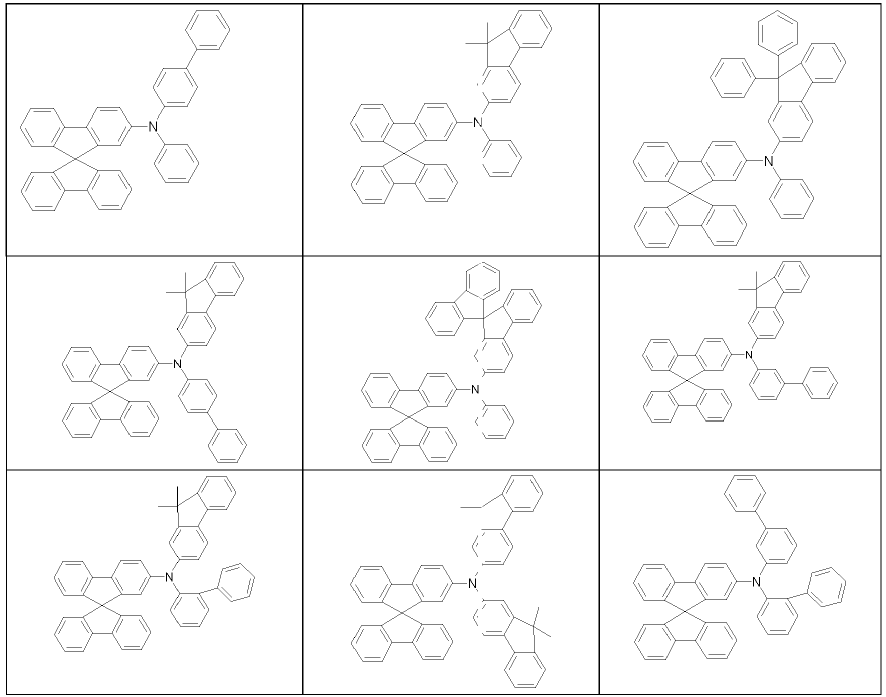

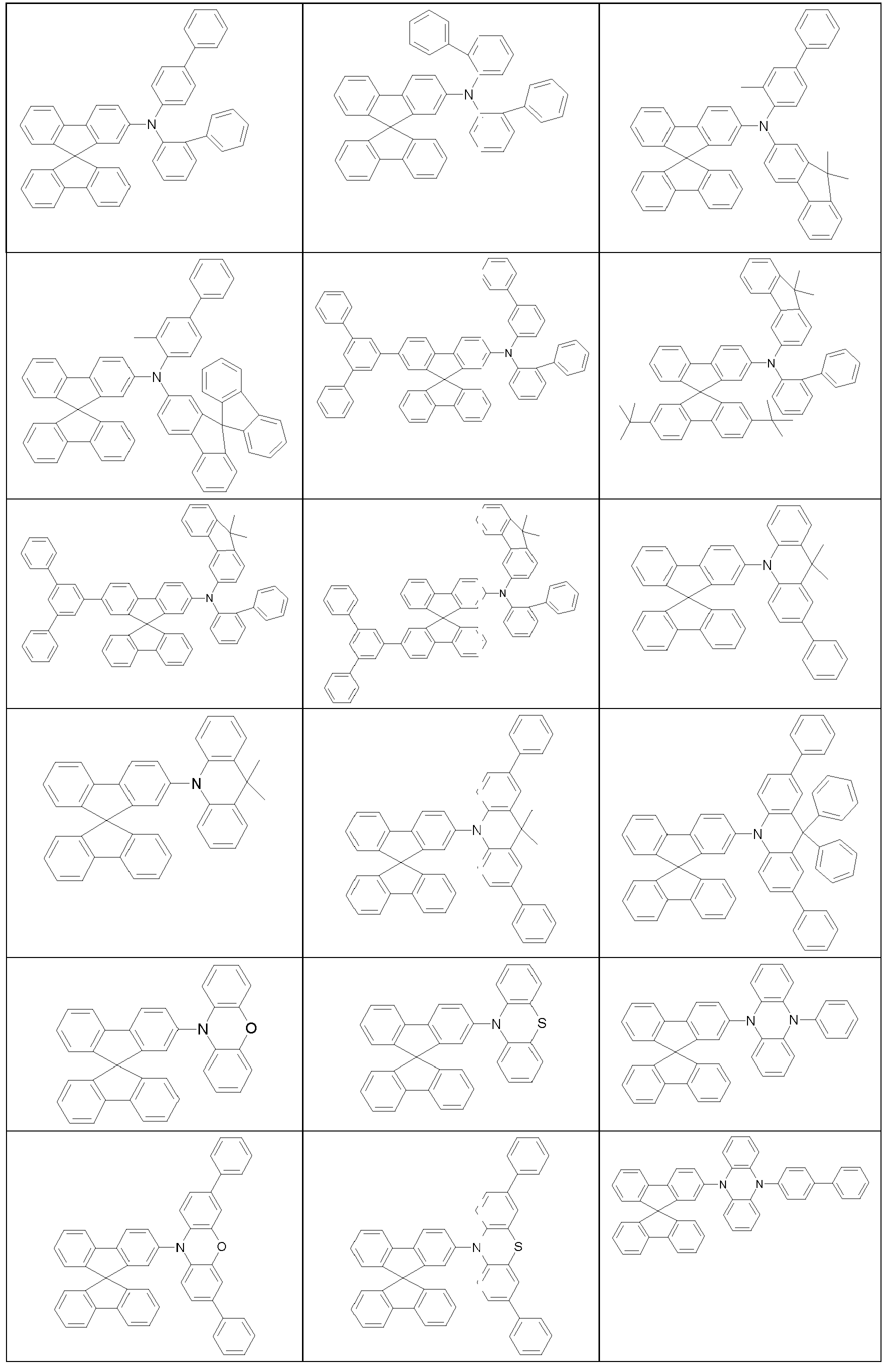

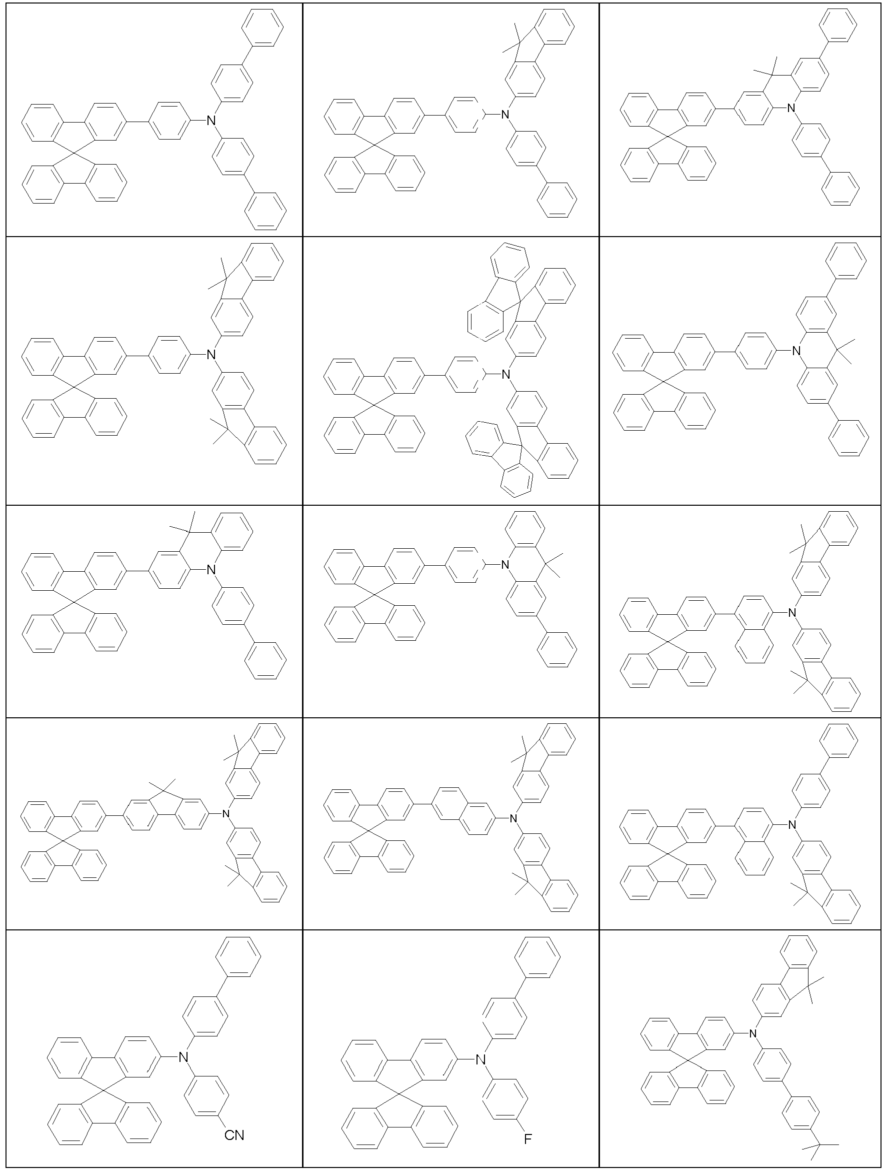

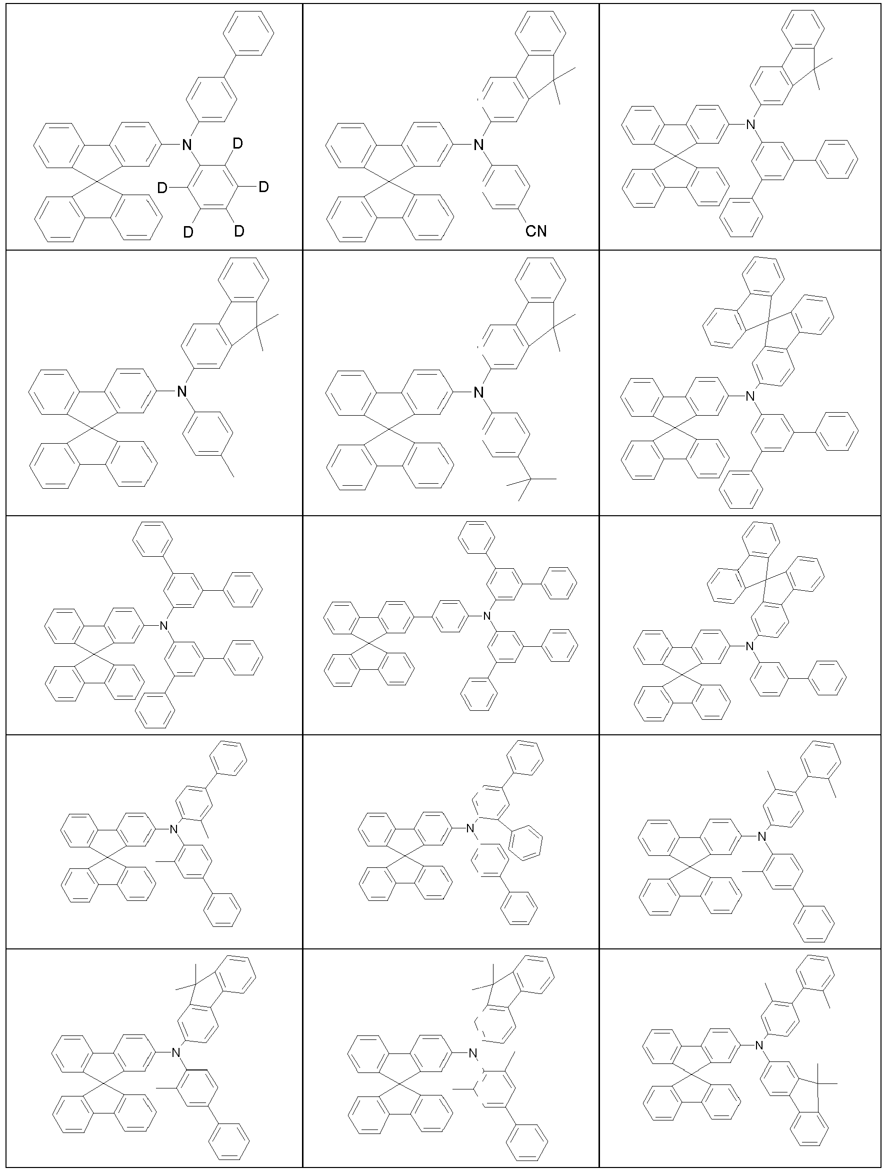

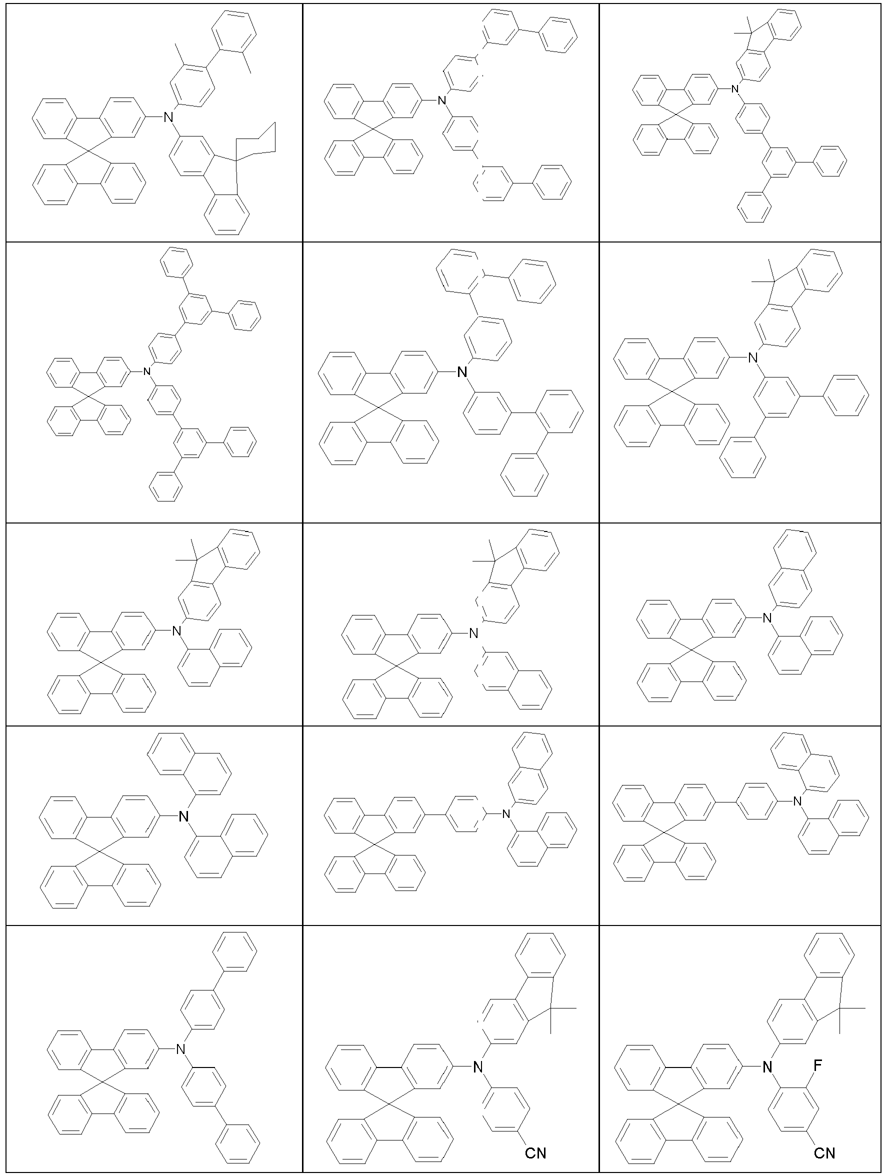

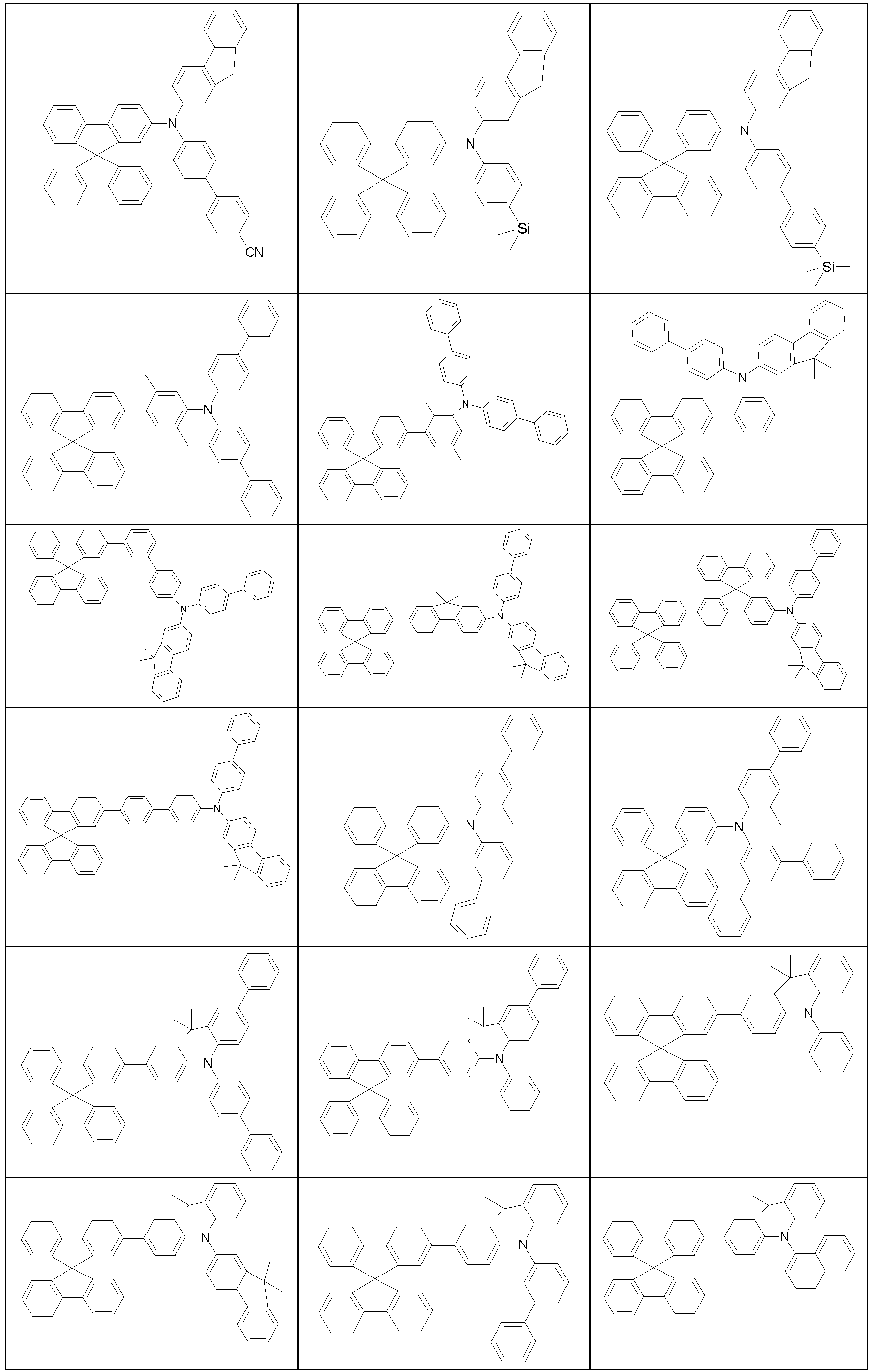

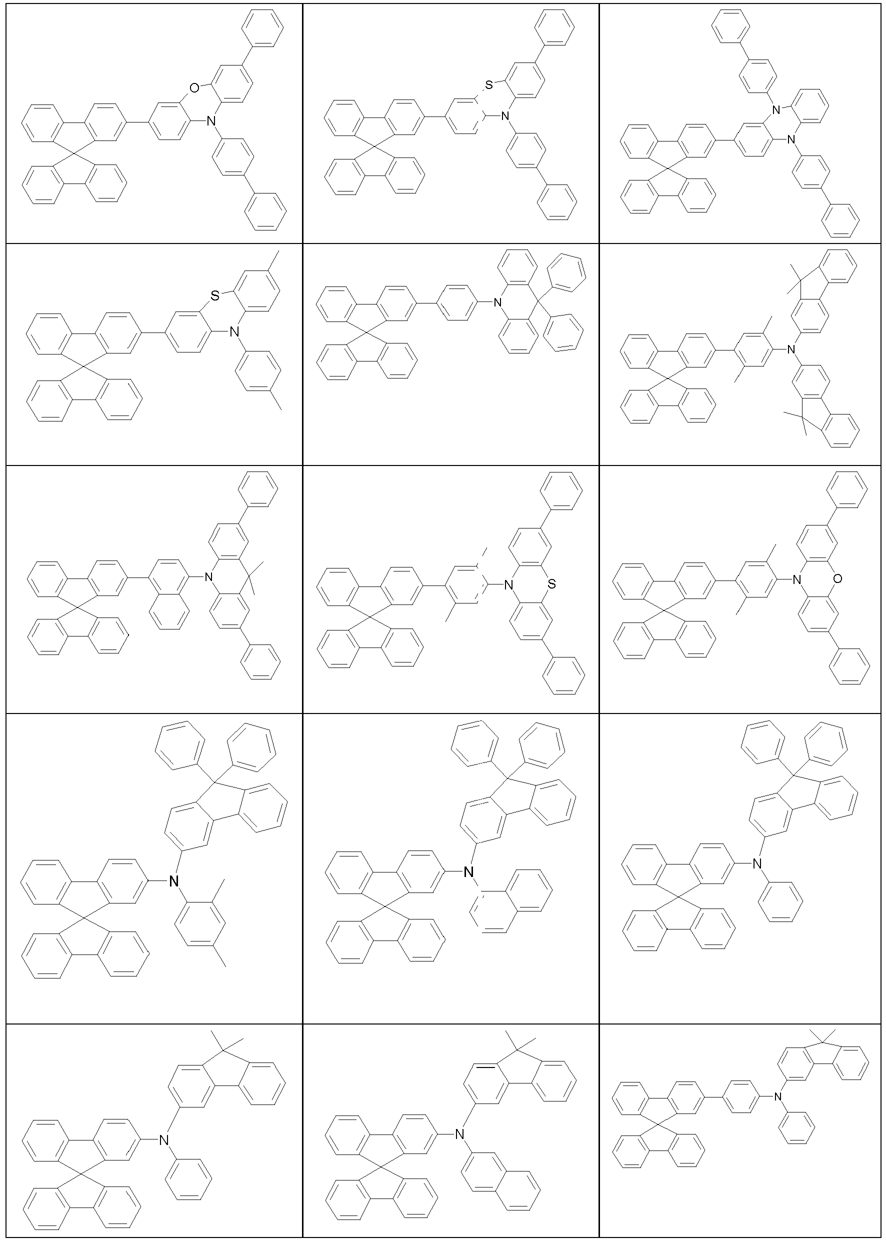

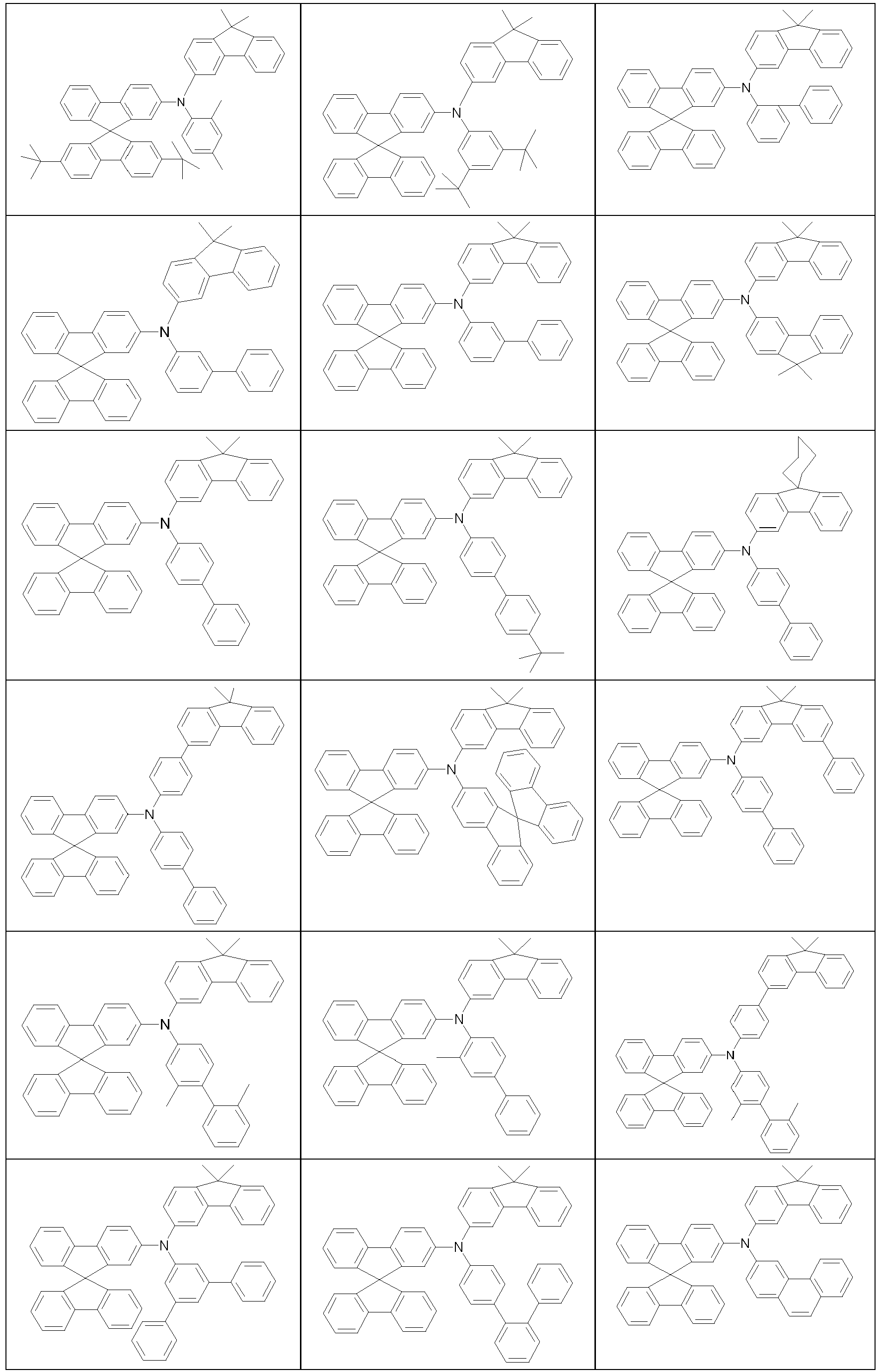

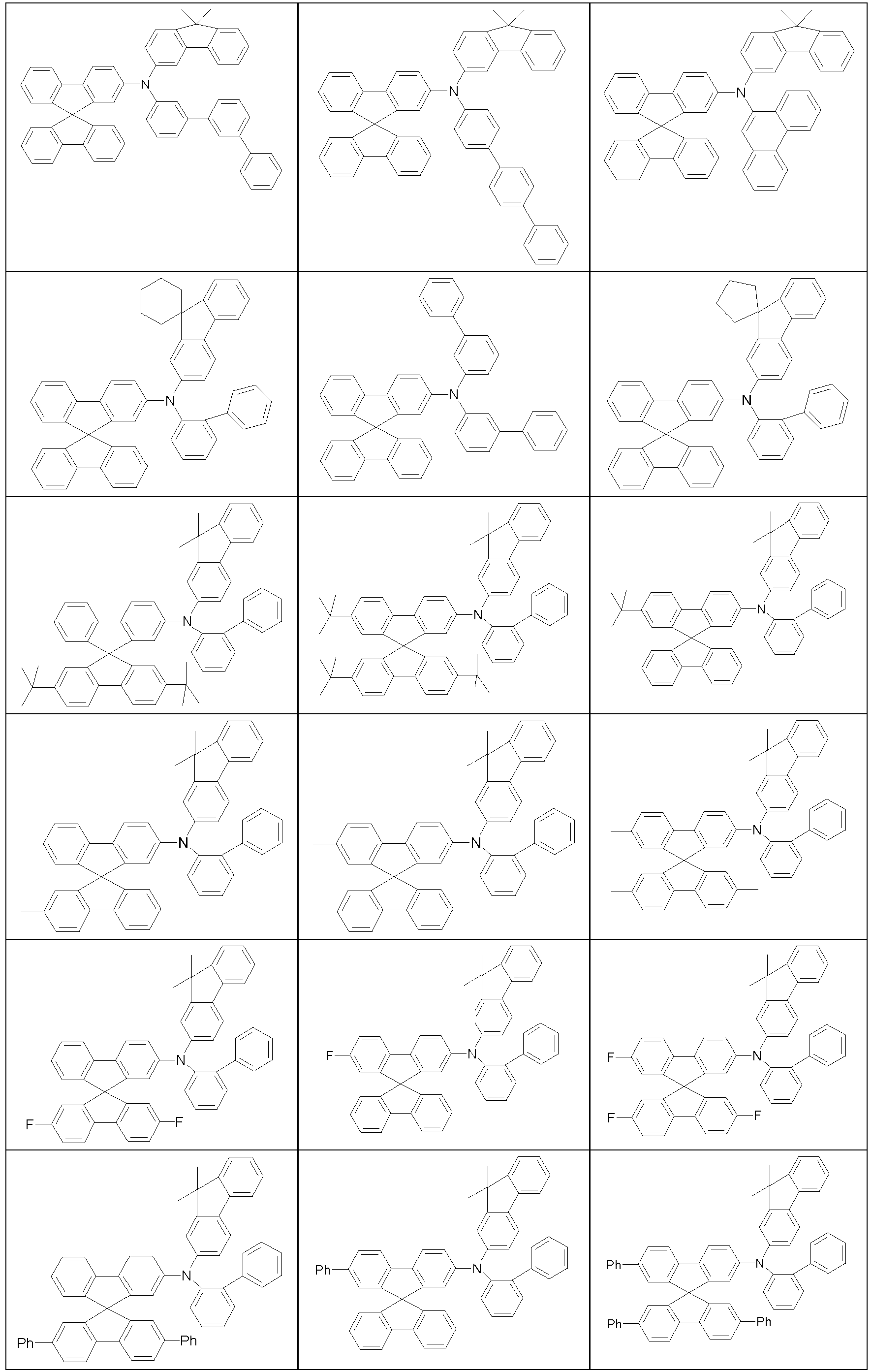

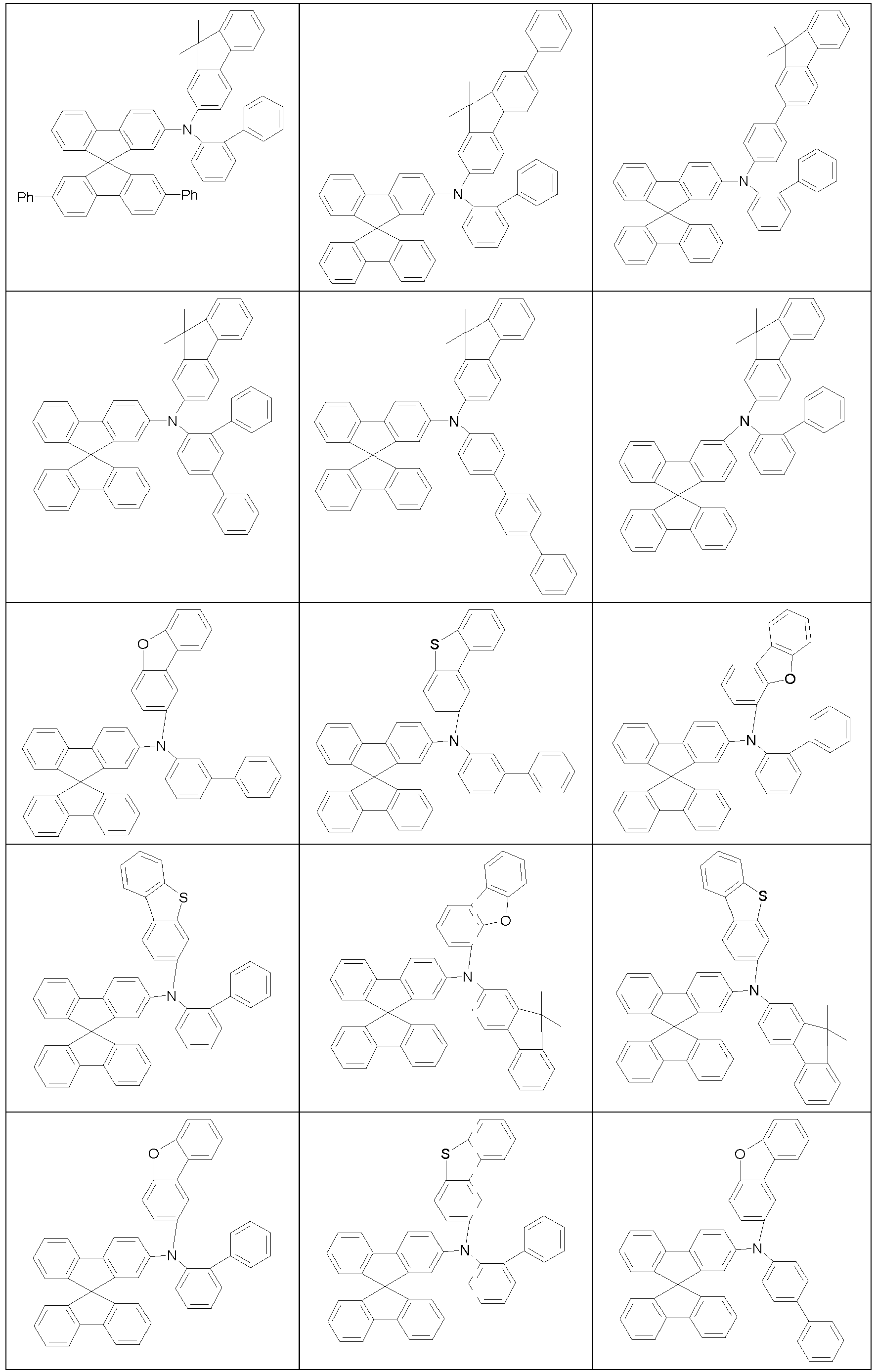

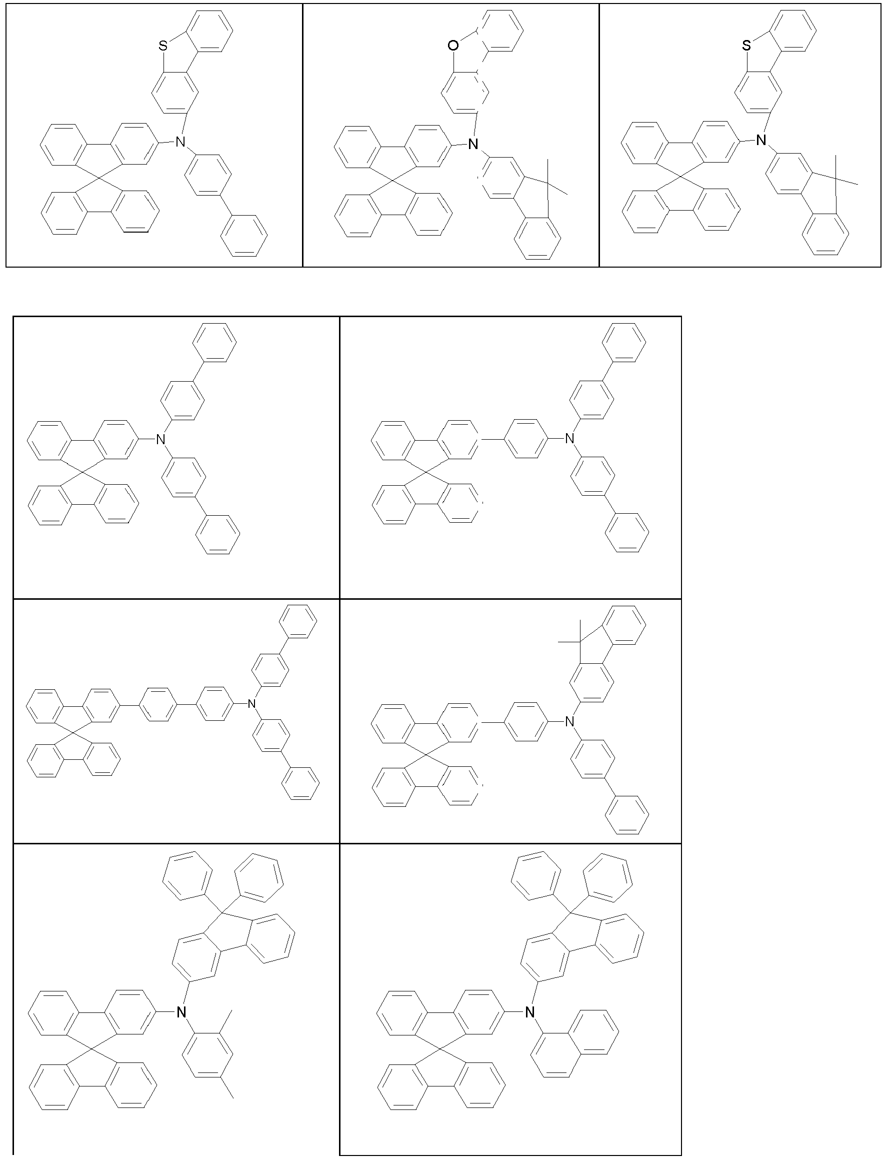

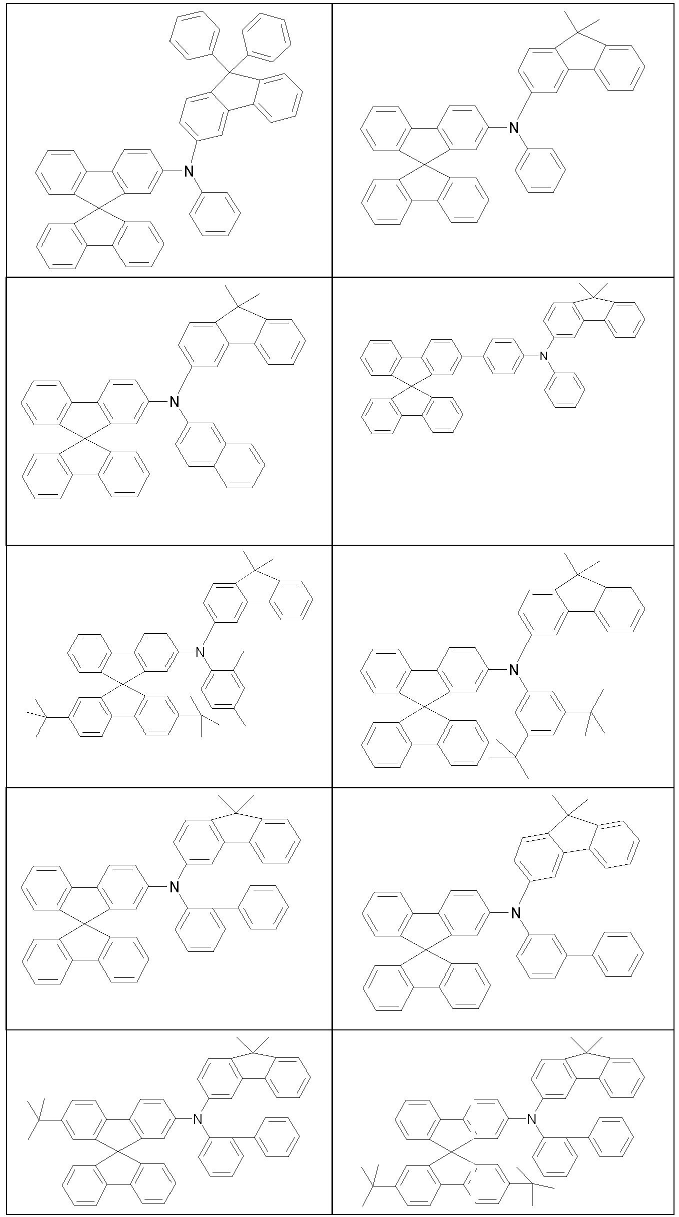

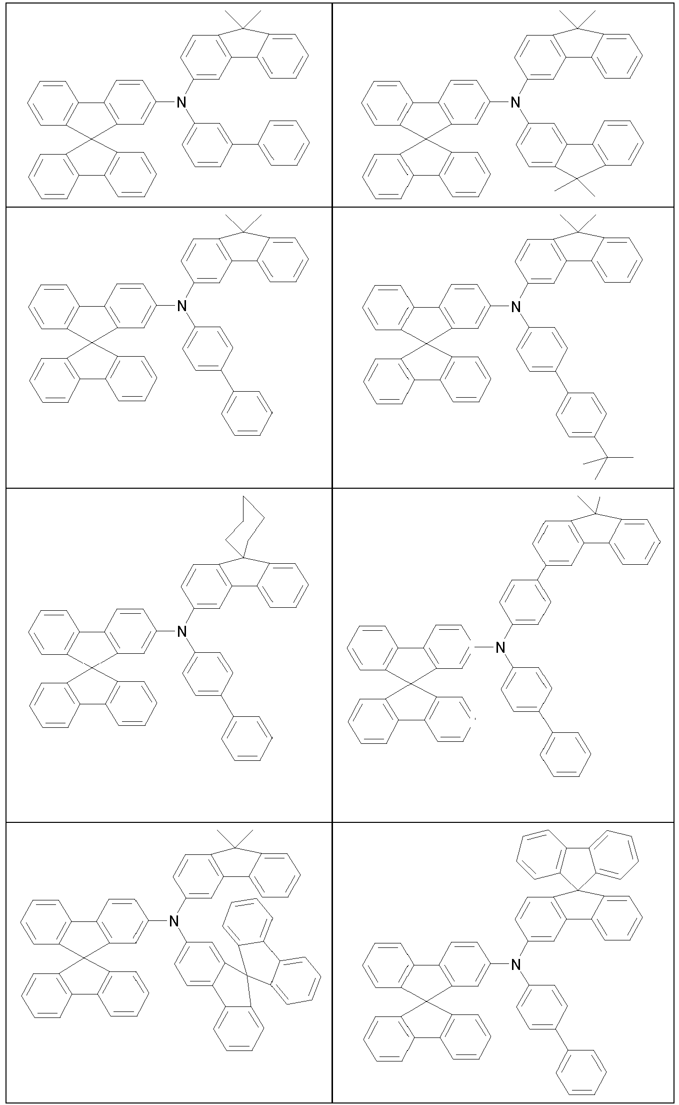

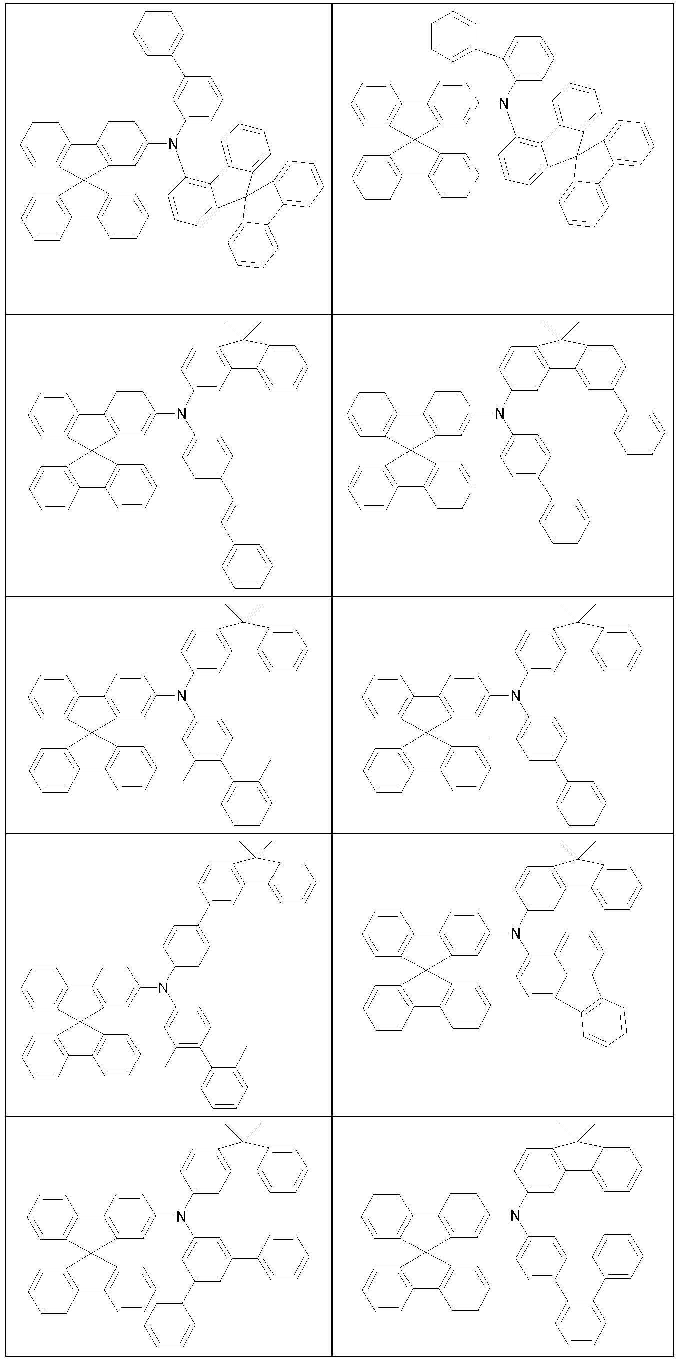

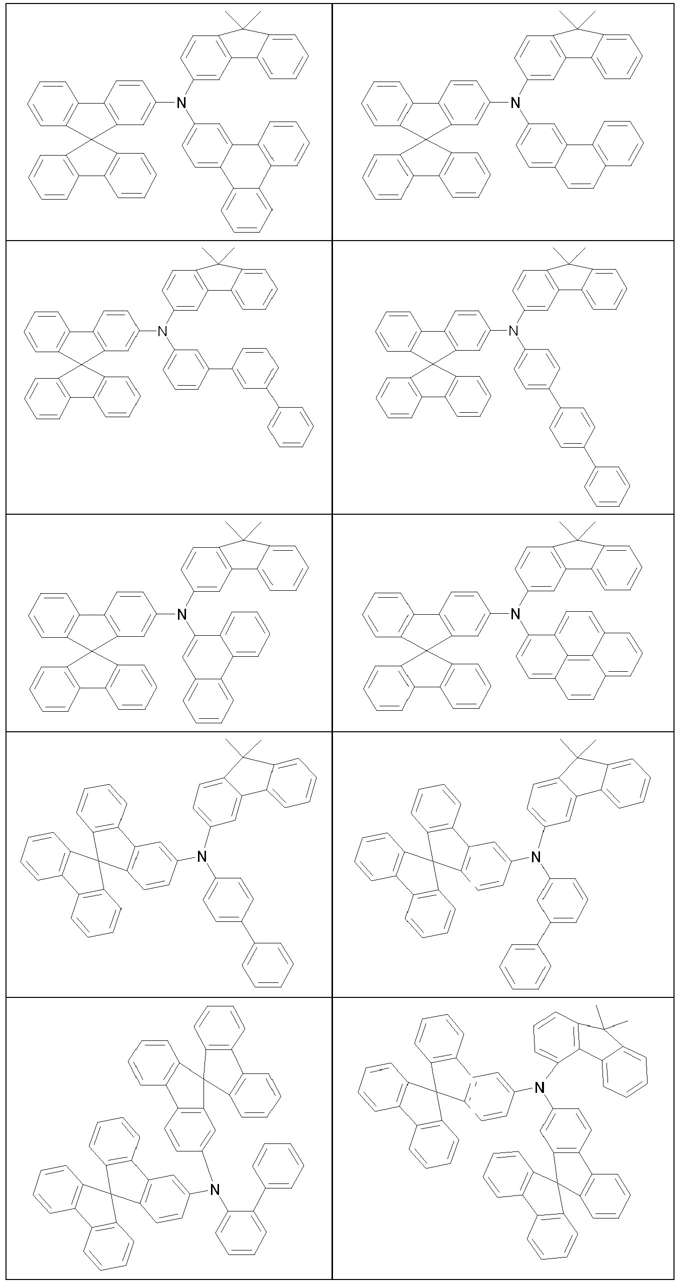

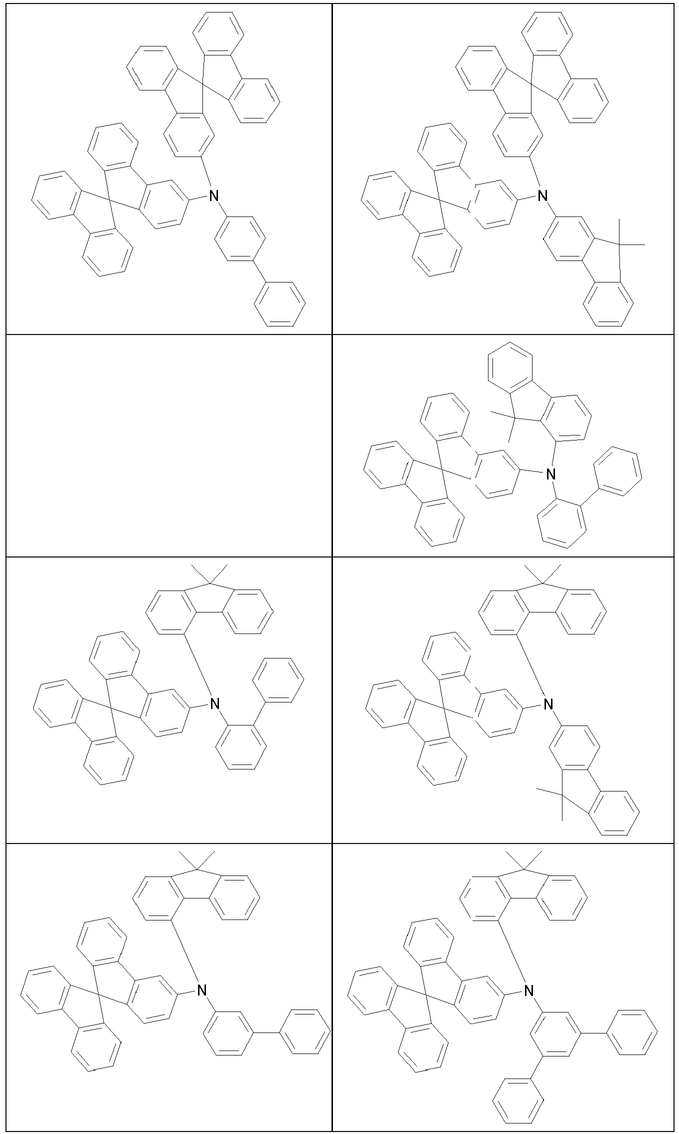

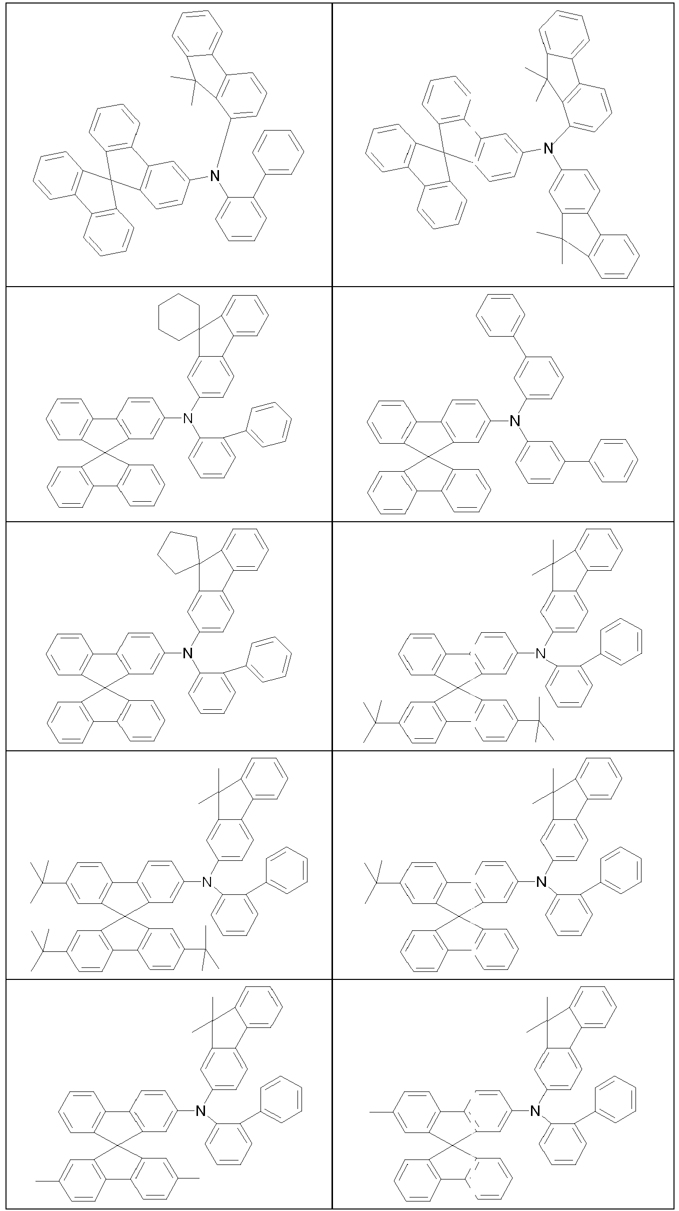

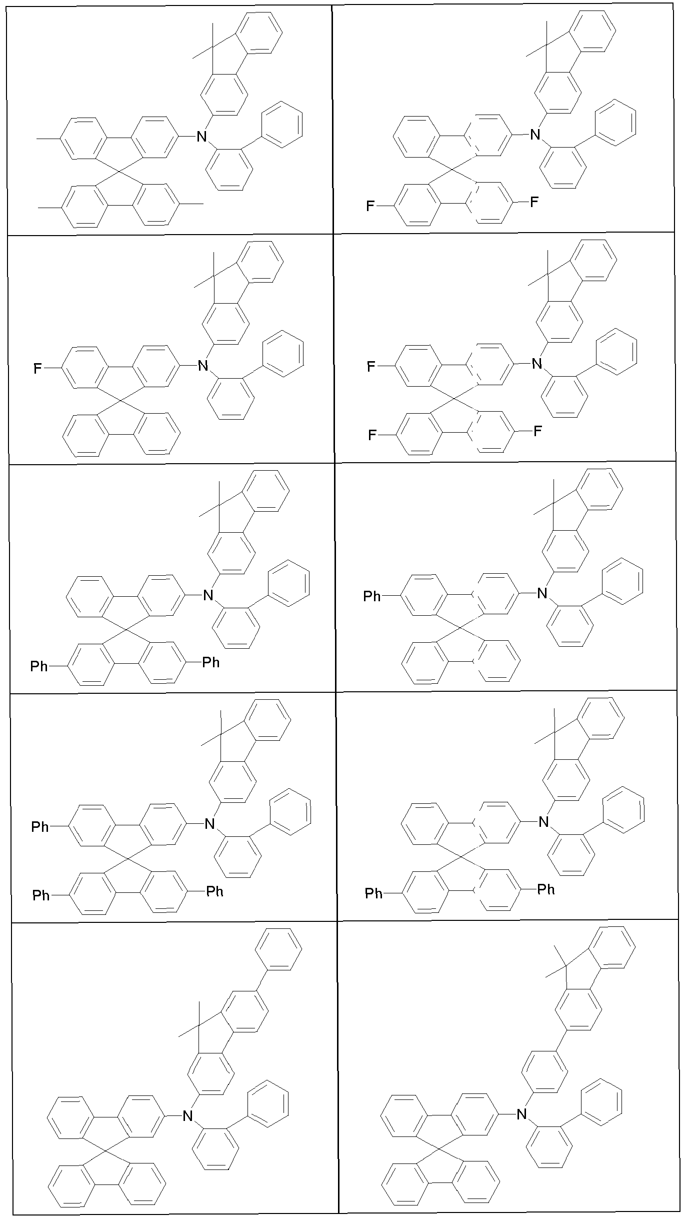

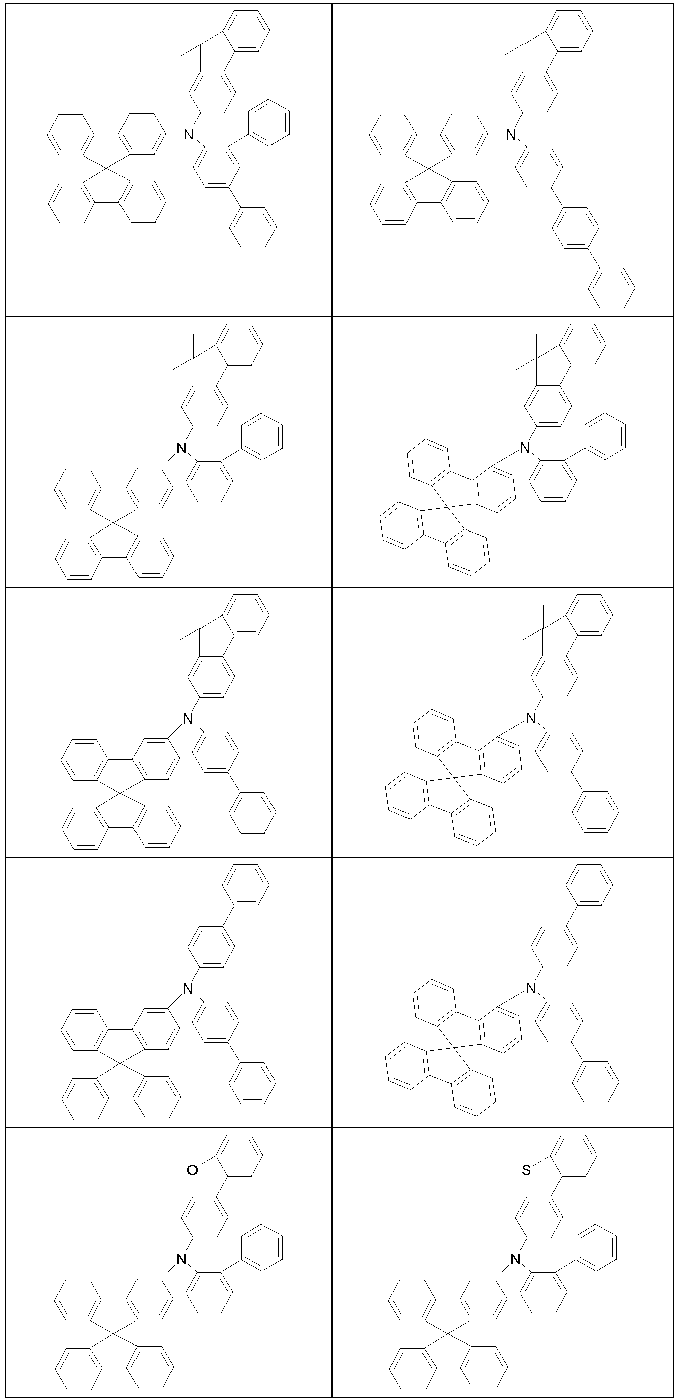

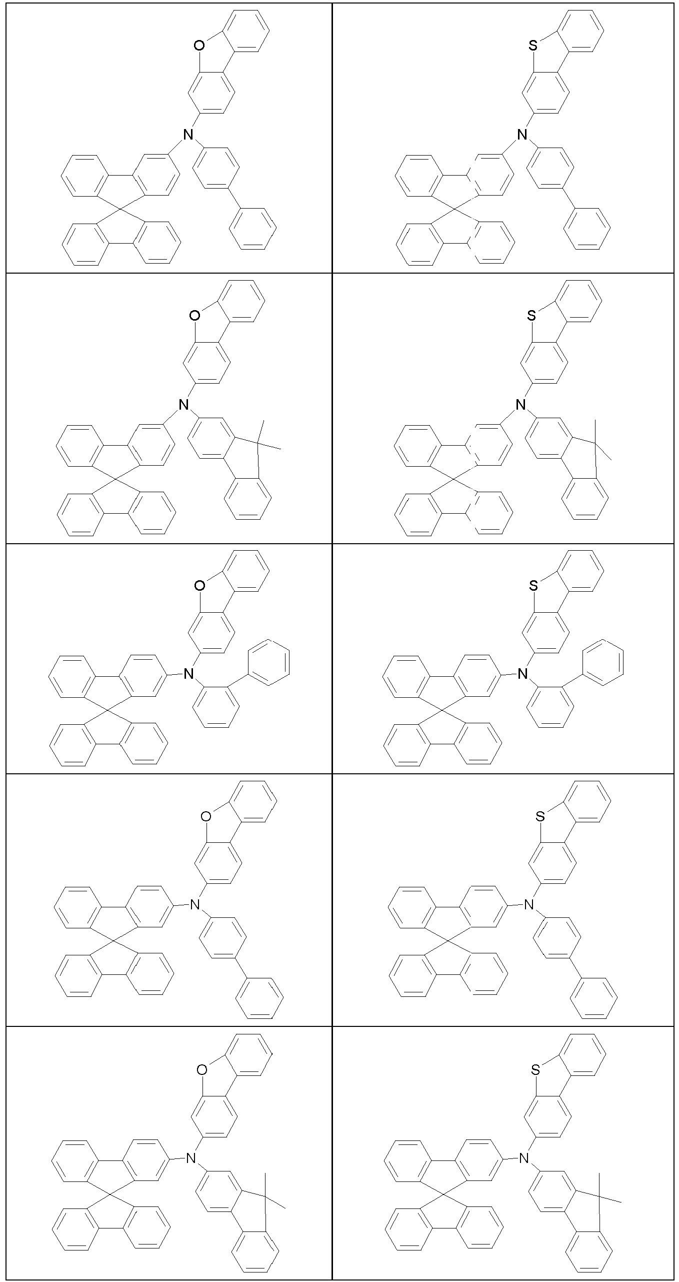

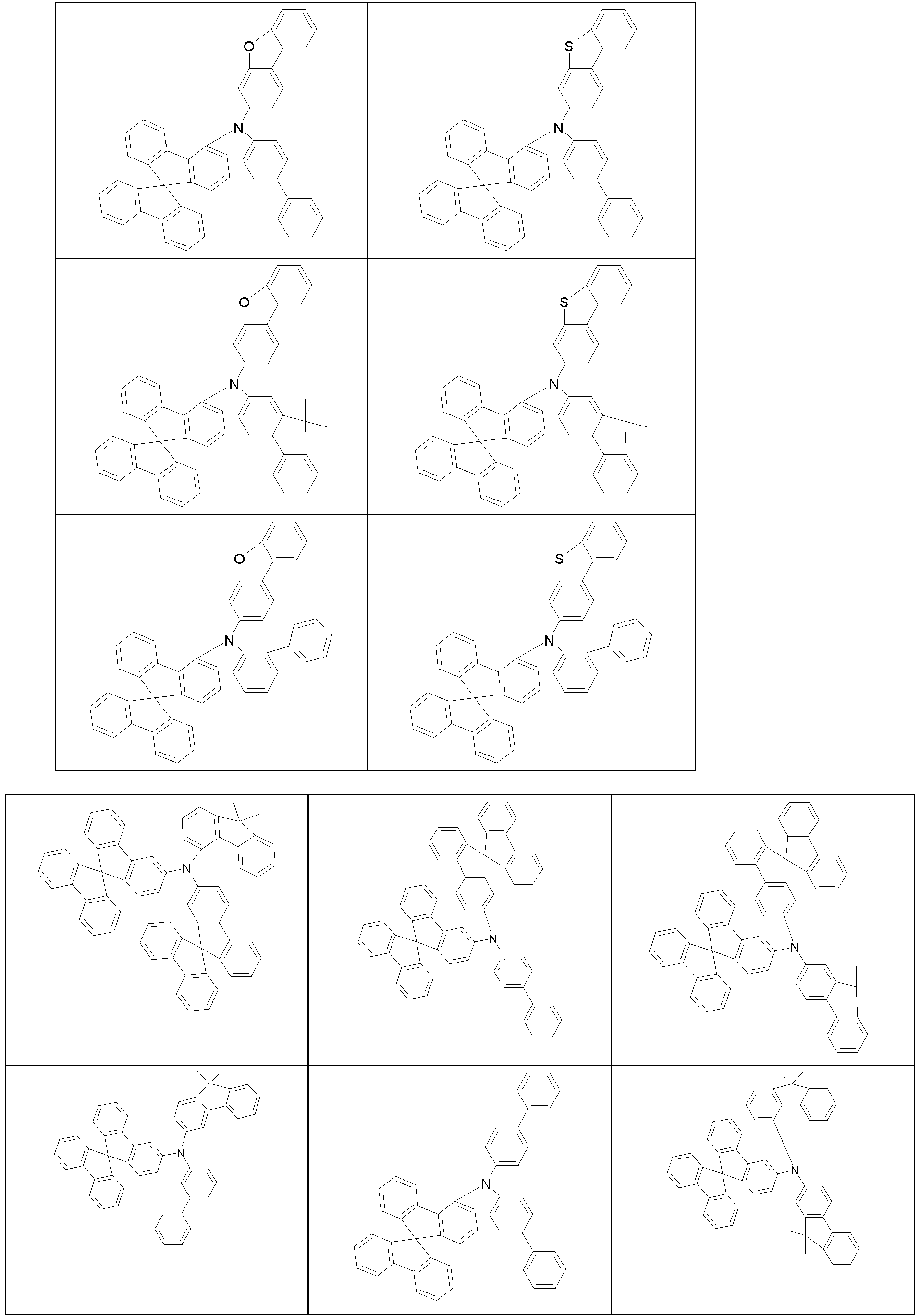

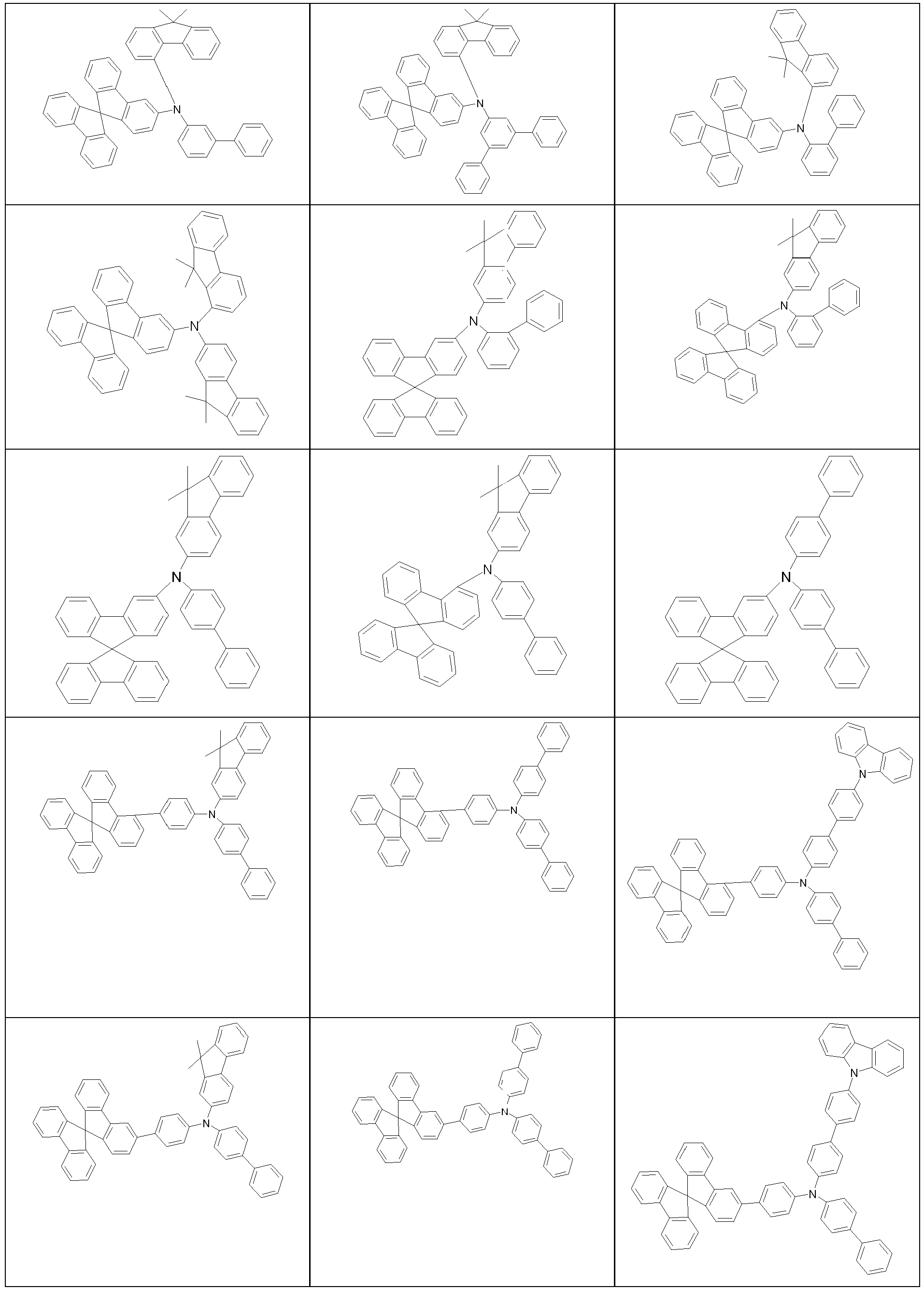

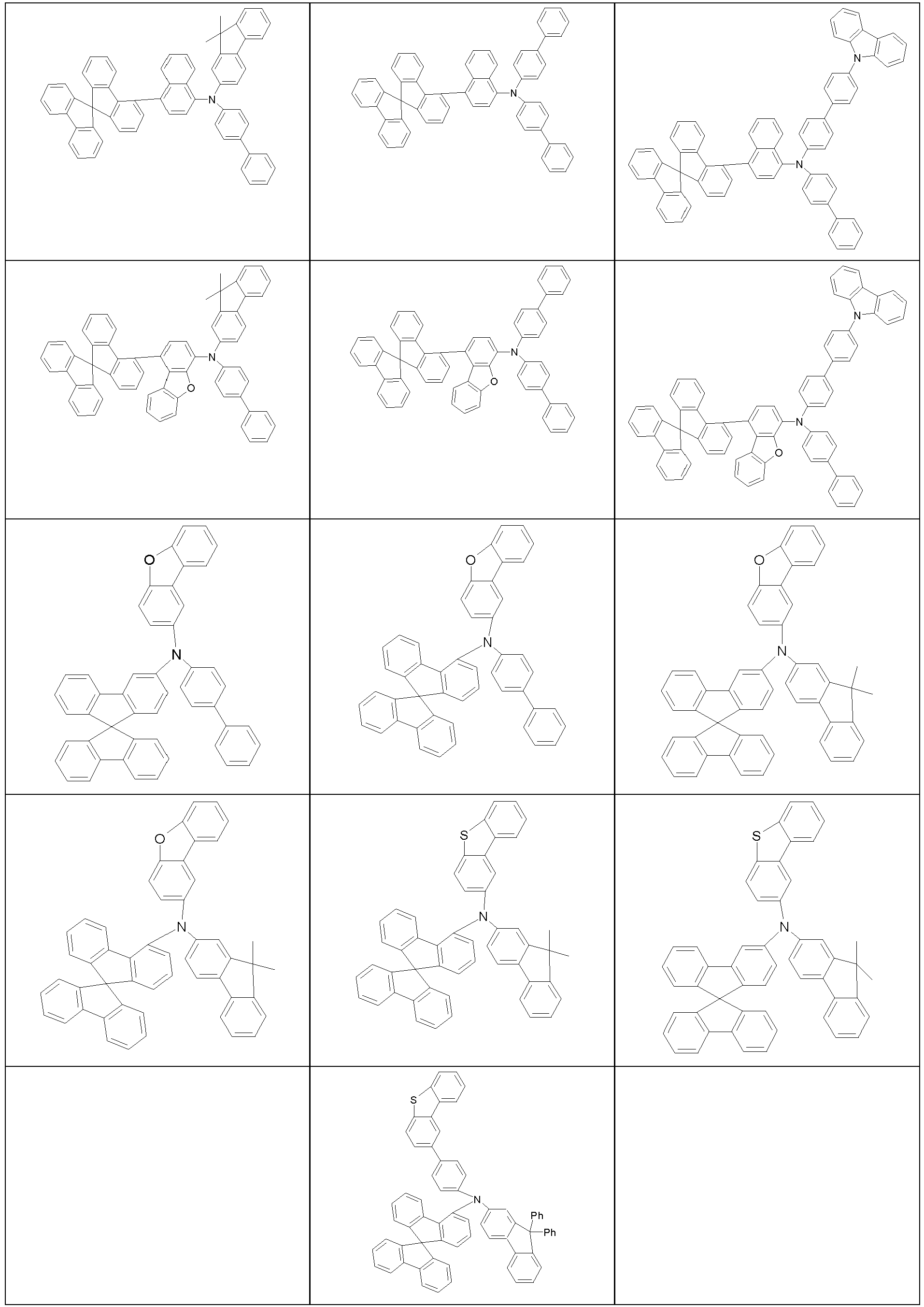

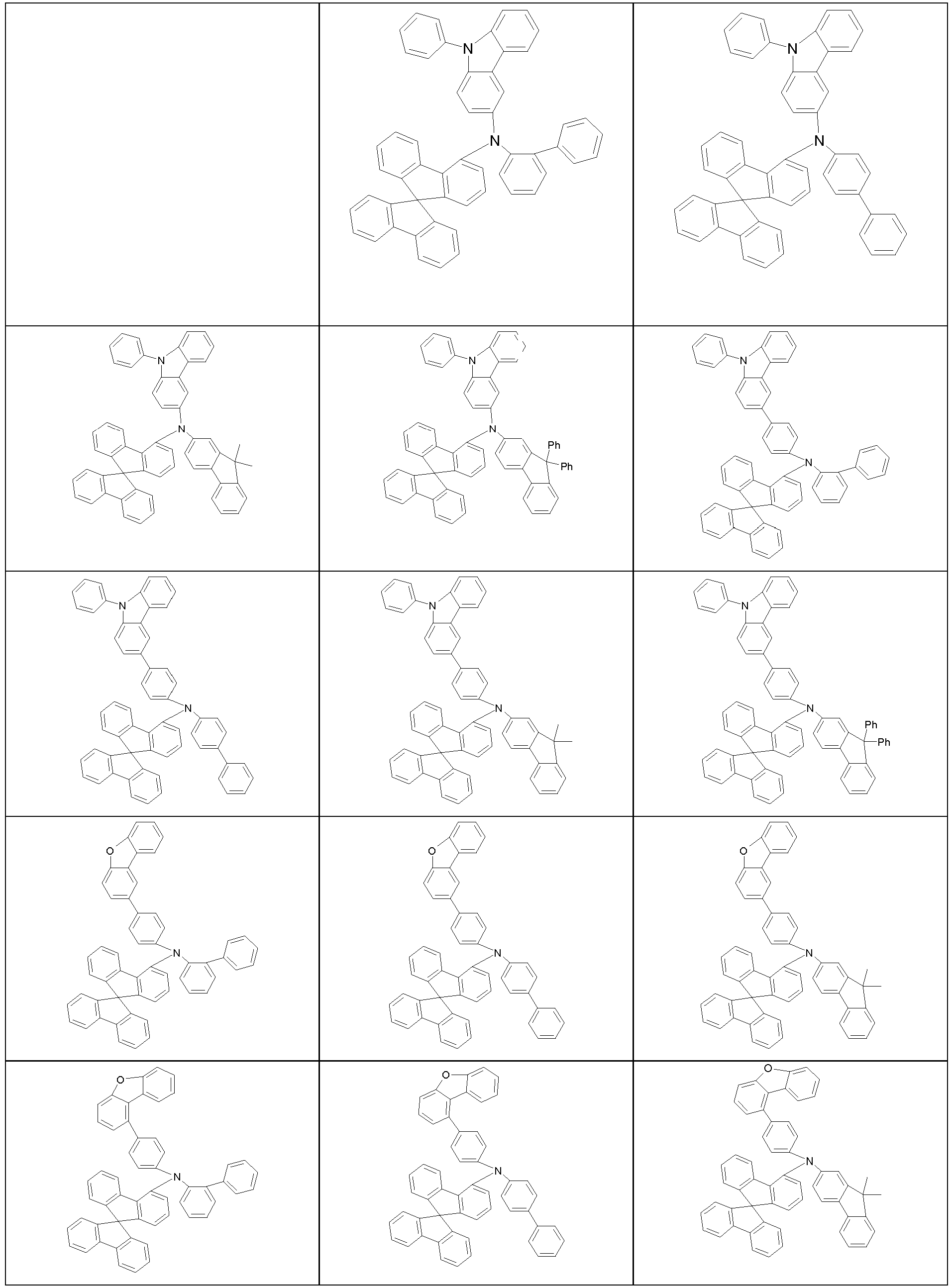

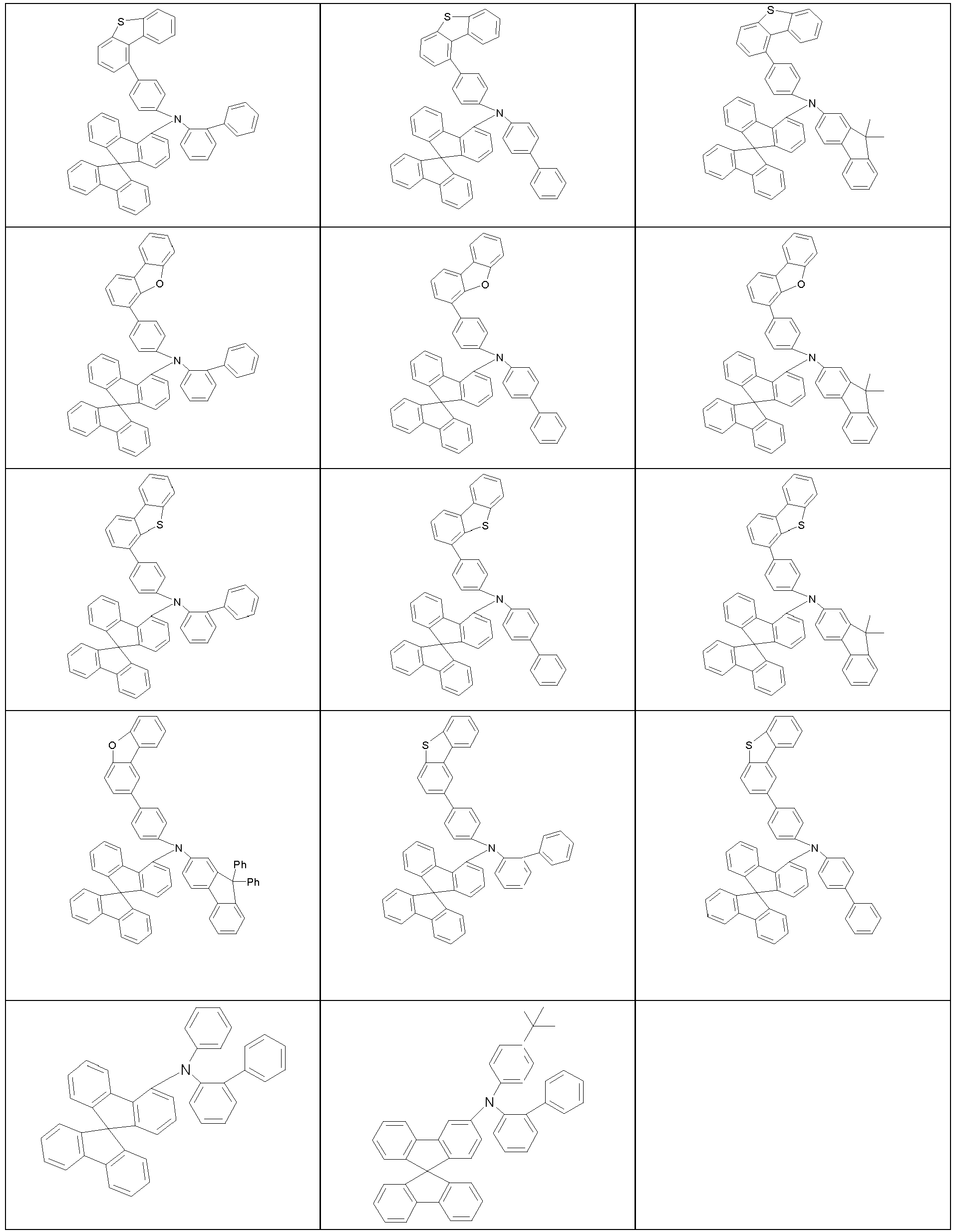

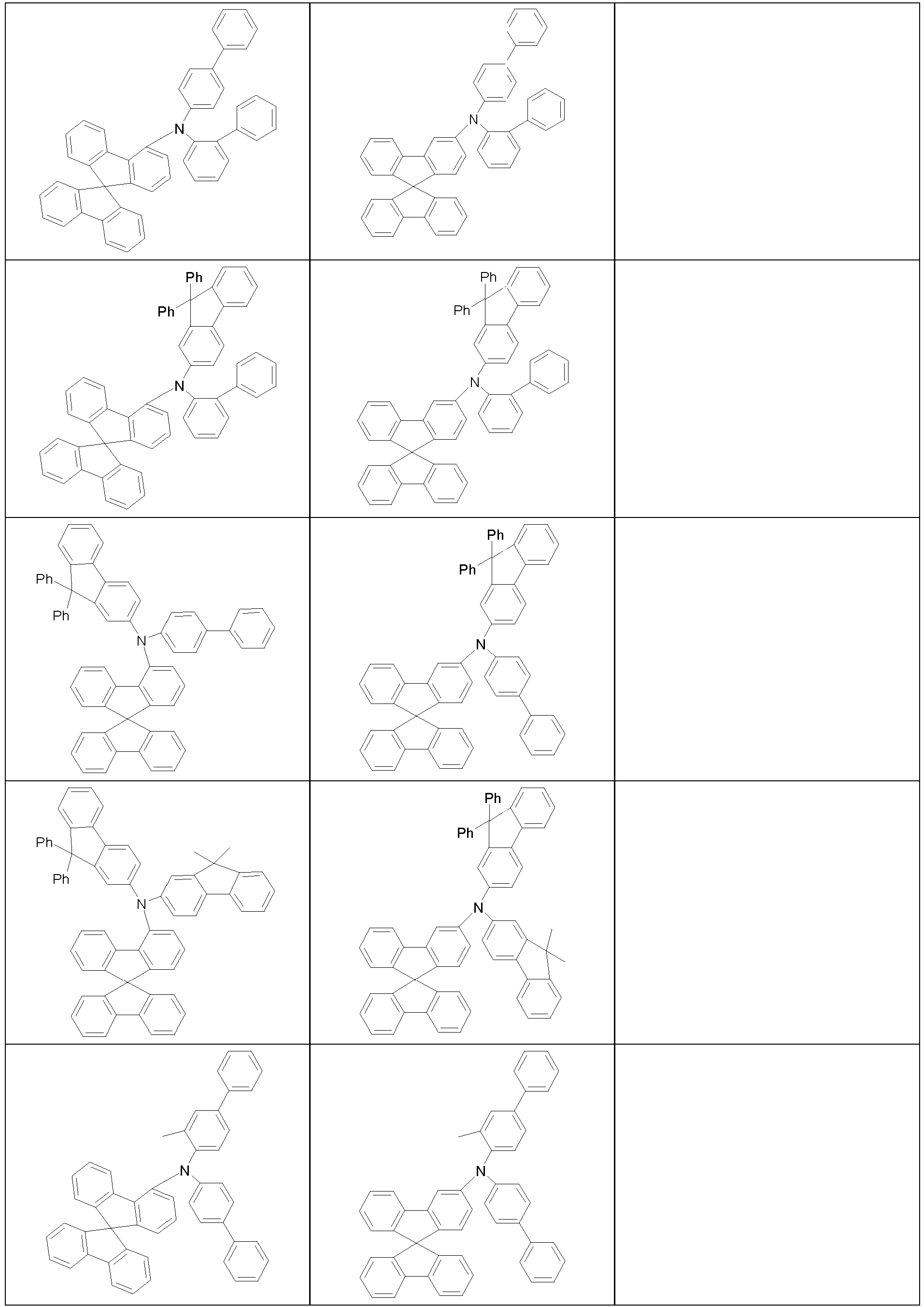

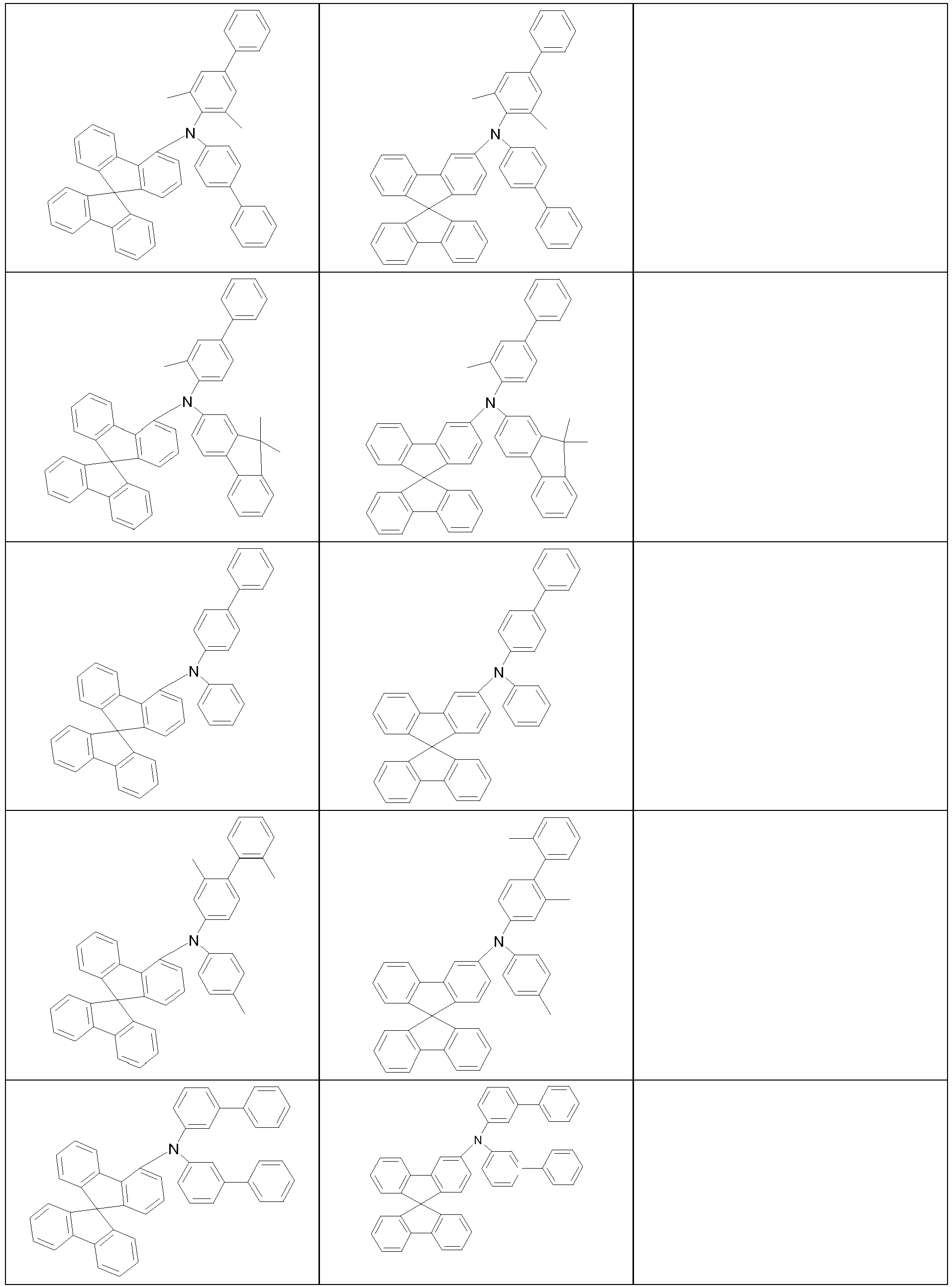

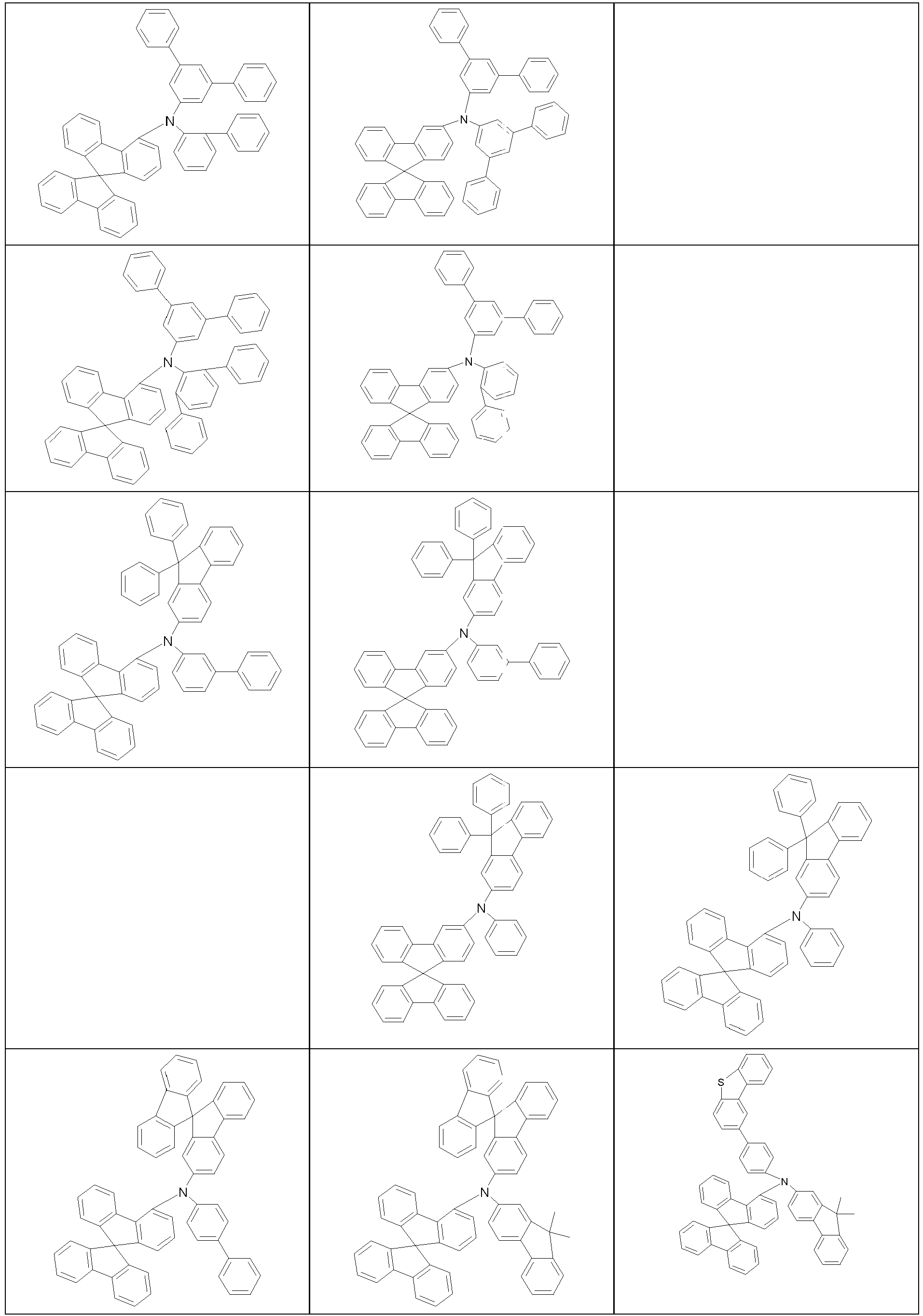

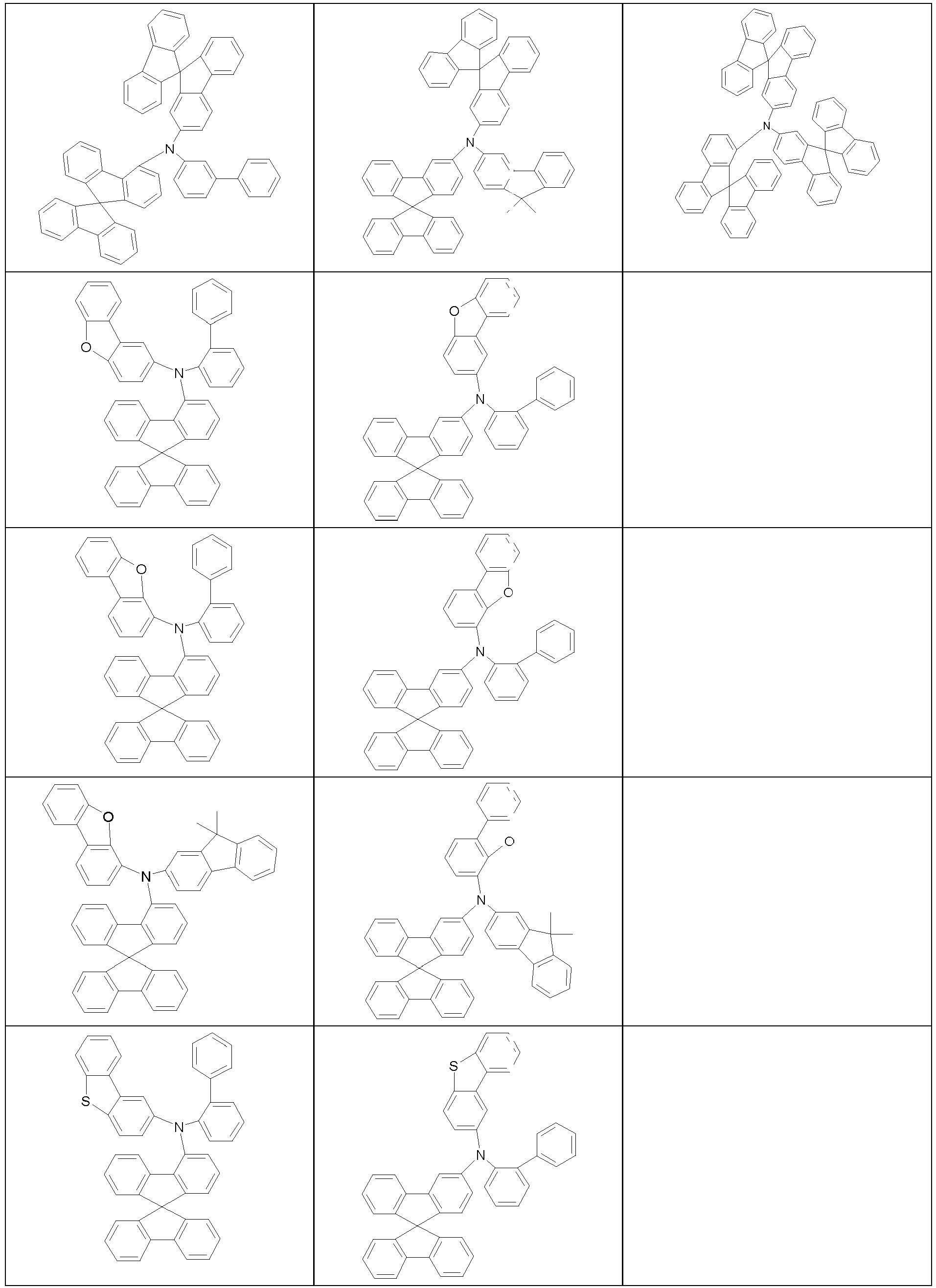

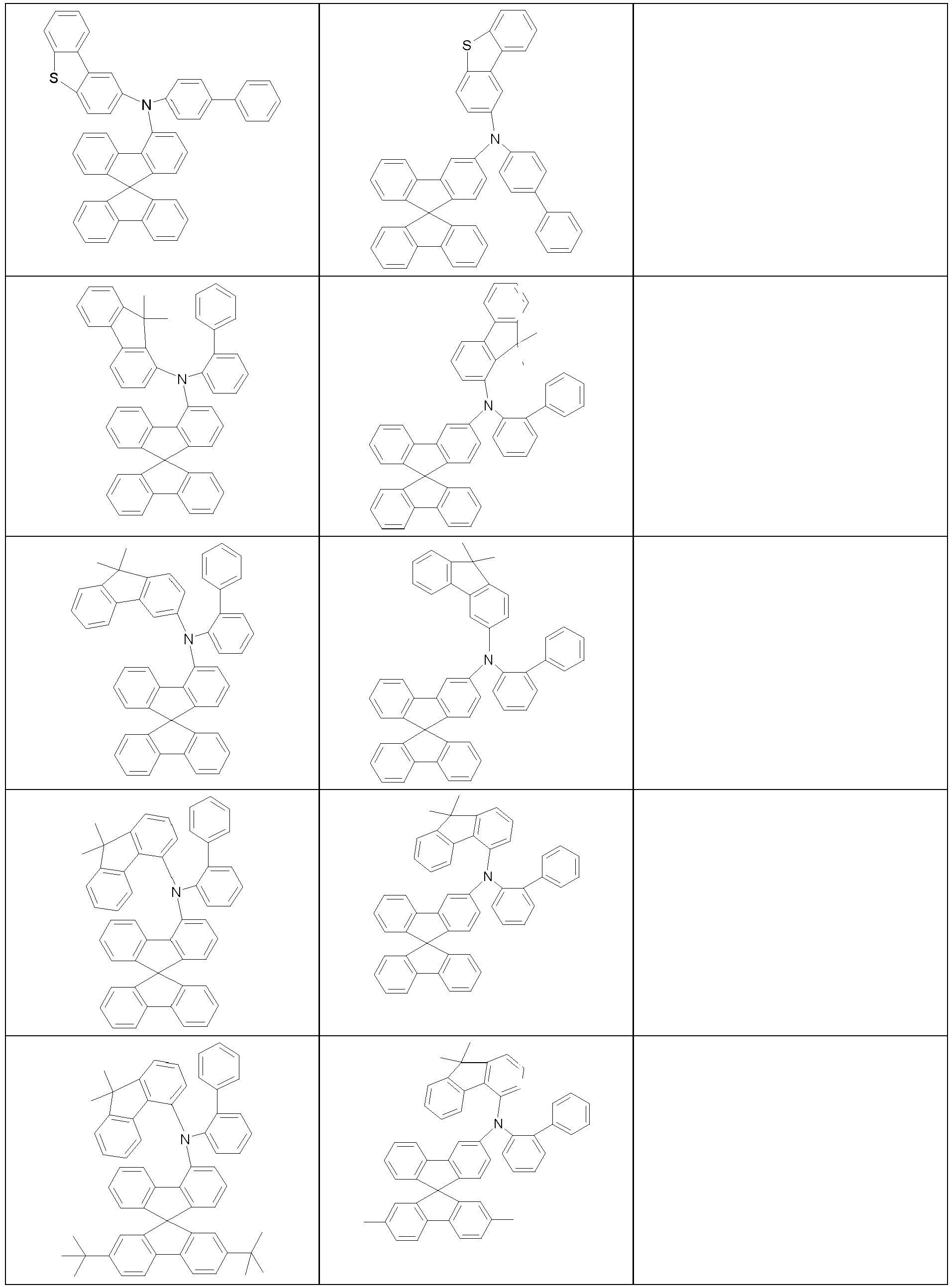

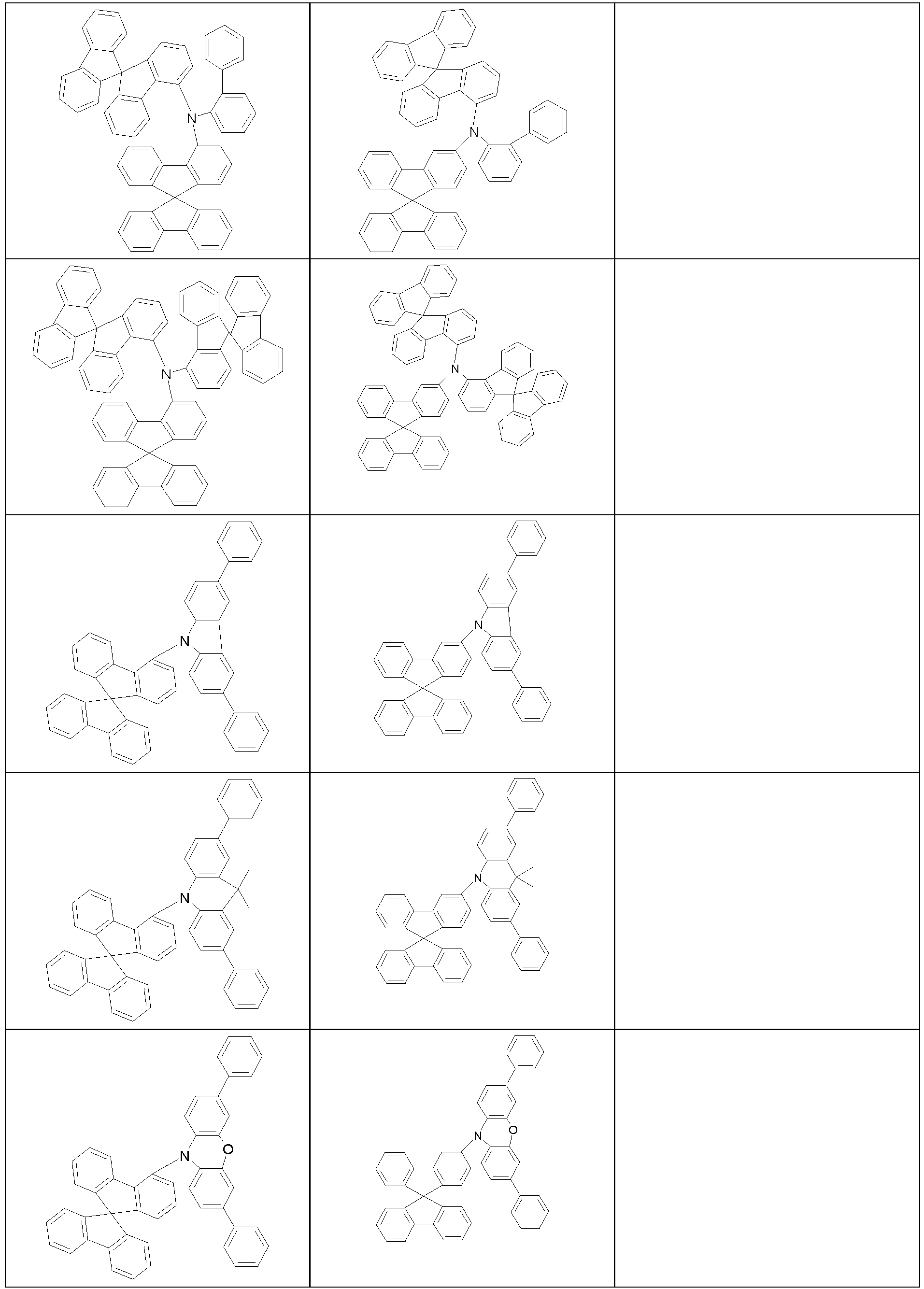

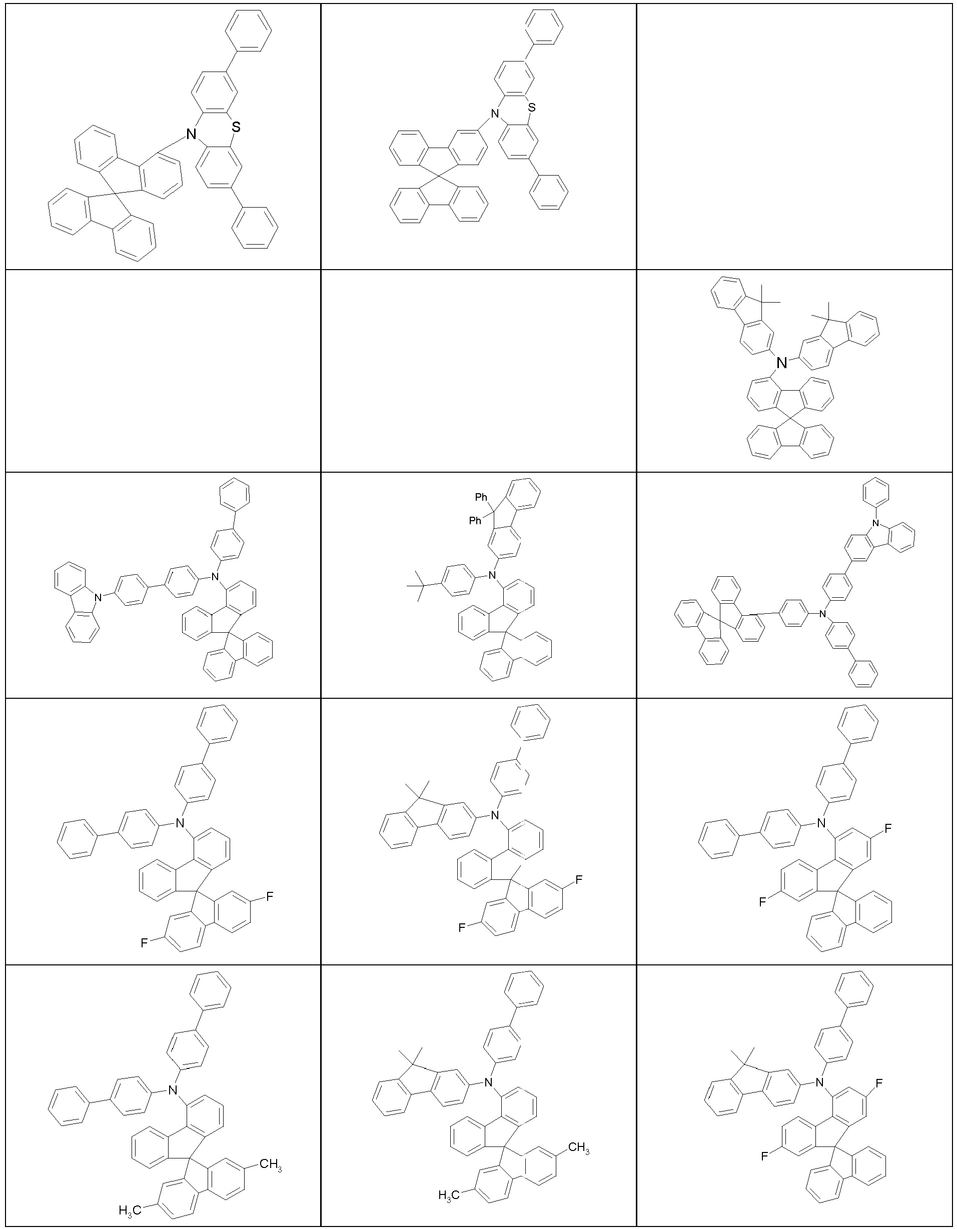

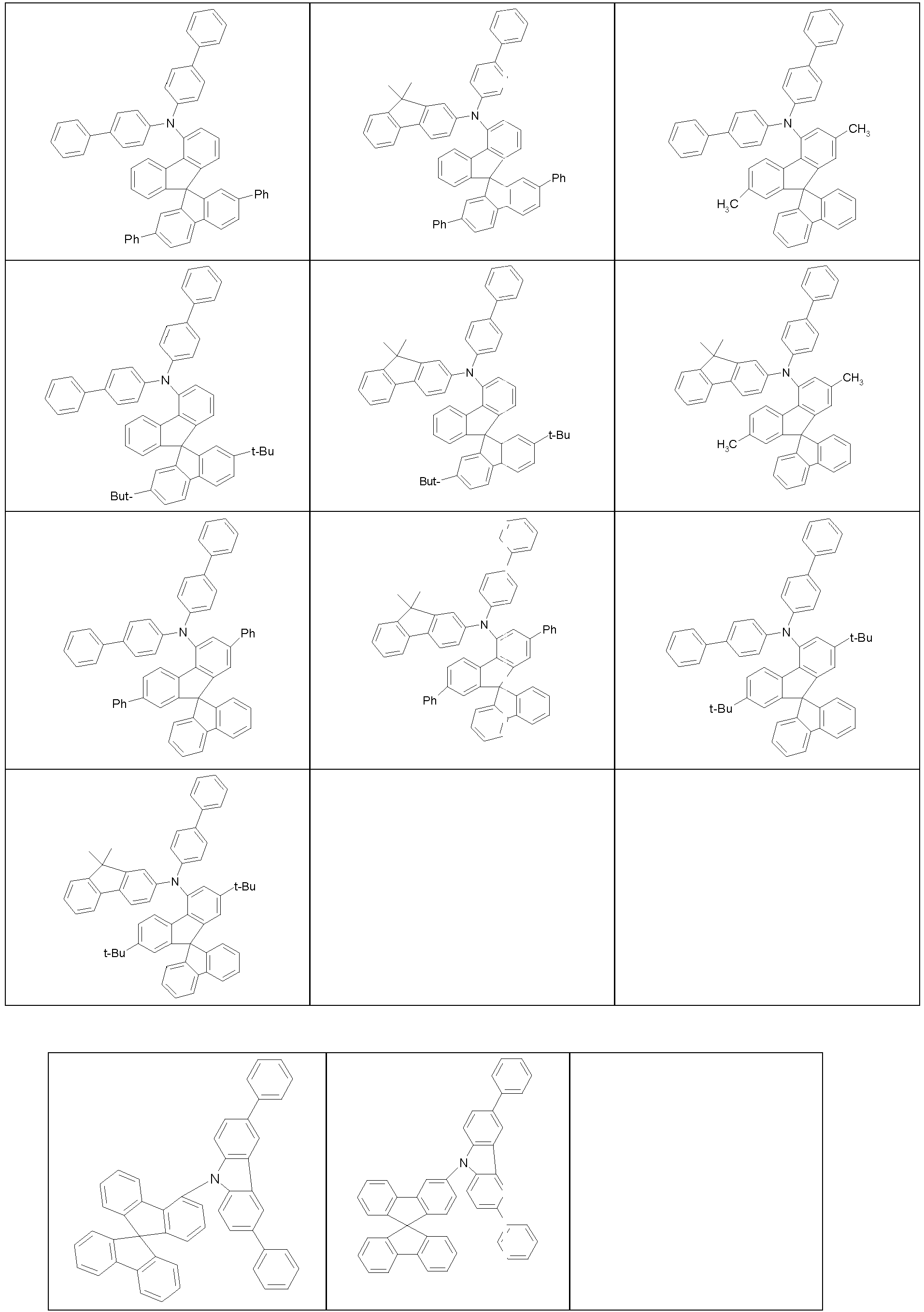

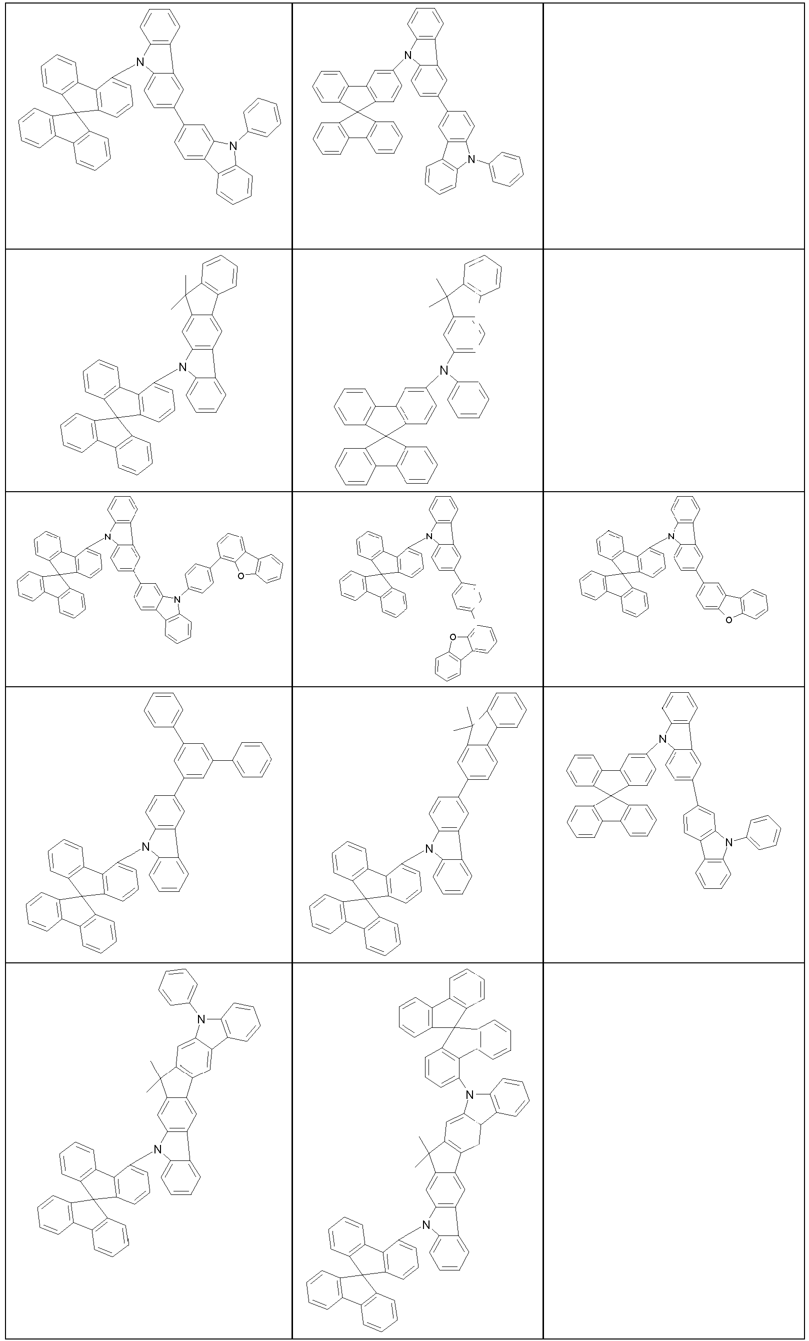

The compounds according to the invention can be prepared by synthetic steps known to the person skilled in the art, such as, for example, bromination, Ullmann arylation, Hartwig-Buchwald coupling, Suzuki coupling etc. as disclosed, e.g., in WO2012/034627 or WO2013/120577.

The syntheses generally start from the 1-, 2-, 3- or 4-halogenated, in particular brominated, spirobifluorene derivatives, followed by a C-N coupling reaction, for example a Hartwig-Buchwald coupling or an Ullmann coupling, for introduction of the diarylamino group. Analogously, another suitable leaving group, for example tosylate or triflate, can be used instead of the halogen. The synthesis of 1-diarylaminospirobifluorene is shown in Scheme 1, where two different access routes to the brominated starting compound are shown.

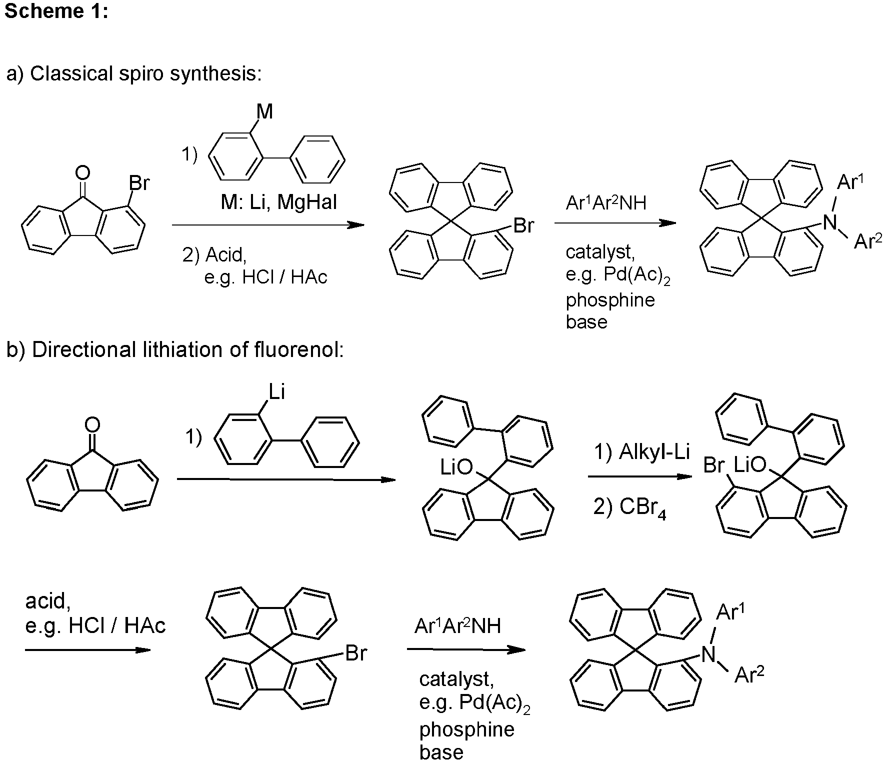

Instead of introducing the secondary amine Ar¹Ar²NH directly in one step, it is likewise possible here firstly to introduce a primary amine having a substituent Ar¹ (i.e. Ar¹-NH) and to introduce the group Ar² in a further coupling reaction using e.g. a compound (Ar²-Br).

Analogously to the classical spiro synthesis shown above, the corresponding spirobifluorene derivatives which are halogenated in the 2-, 3- or 4-position can be synthesised by employing the corresponding 2-, 3- or 4-halogen-substituted fluorenone as starting material. Likewise, corresponding substituted structures can also be synthesised entirely analogously.

For compounds where o = 1 or 2, the group Ar-NAr¹Ar² can likewise be introduced via a metal-catalysed coupling reaction, for example via a Suzuki coupling or a Stille coupling.

According to the present invention, as an inorganic part of the at least one semiconducting light emitting nanoparticle, a wide variety of publically known semiconducting light emitting nanoparticles can be used as desired.

As used herein, the term "nano" means a size of 200 nm or smaller, such as the range from 0.1 nm to 200 nm, preferably 0.5 nm to 150 nm.

According to the present invention, the term "size" means the average diameter of the longest axis of the light emitting nanoparticles. The size of the nanoparticles can be measured by using the standard technique like transmission electron microscopy (TEM) or dynamic light scattering.

A type of shape of the semiconducting light emitting nanoparticles of the present invention is not particularly limited. For example, the nanoparticles may be spherical shaped, elongated shaped, star shaped, polyhedron shaped, cube shaped, tetrapod shaped, tetrahedron shaped, platelet shaped, cone shaped, and irregularly shaped, without being limited thereto.

In a preferred embodiment of the present invention, the at least one semiconducting light emitting nanoparticle is a semiconducting quantumsized light emitting material, which is also called a "quantum material" and which terms are used interchangeably herein.

As used herein, the term "quantumsized" means the size of the inorganic, semiconducting light emitting material itself, i.e., without ligands or any other surface modification, which can show the quantum confinement effect, like described in, for example, ISBN:978-3-662-44822-9. Generally, it is said that quantumsized materials or quantum materials such as quantum dots and quantum rods can emit tunable, sharp and vivid colored light due to "quantum confinement" effect. Quantum dots (QDs) can emit light in the visible wavelength range. Further QDs can emit blue, green and red light.

A type of shape of the quantum material of the present invention is not particularly limited, and the above-mentioned shapes related to nanoparticles can be used. In a further preferred embodiment of the present invention, the quantum material is selected from quantum dots and quantum rods, but quantum dots (QDs) are particularly preferred.

Preferably, the size of the quantum sized materials such as quantum dots (i.e., of the inorganic, semiconducting light emitting material without ligands) is from 0.1 nm to 100 nm, more preferably from 0.5 nm to 50 nm, even more preferably from 1 nm to 20 nm, and particularly preferably from 3 nm to 20 nm.

As a quantum dot, publically available quantum dots, for examples, CdSeS/ZnS alloyed quantum dots with product number 753793, 753777, 753785, 753807, 753750, 753742, 753769, 753866, InP/ZnS quantum dots with product number 776769, 776750, 776793, 776777, 776785, PbS core-type quantum dots with product number 747017, 747025, 747076, 747084, or CdSe/ZnS alloyed quantum dots with product number 754226, 748021, 694592, 694657, 694649, 694630, 694622 from Sigma-Aldrich can be used as desired. Preferably, the quantum dots are selected from Cd-free quantum dots.

In another preferred embodiment of the present invention, the at least one semiconducting light emitting nanoparticle has a core-shell-structure, wherein an inorganic core is surrounded by one or more inorganic shell layers.

According to the present invention, said one or more shell layers of the semiconducting light emitting nanoparticle can be a single shell layer, a double shell layer, or multishell layers having more than two shell layers, but preferably is a double shell layer.

As used herein, the term "shell layer" means a layer fully or partially covering said core. Preferably, said one or more shell layers fully cover said core. The terms "core" and "shell" are well known in the art and typically used in the field of quantum materials, such as US 8221651 B2.

Further preferably, said at least one semiconducting light emitting nanoparticle of the present invention having the core-shell-structure is a quantum material, and in particular a quantum dot.

According to the present invention, said core material of the semiconducting light emitting nanoparticle, such as a quantum dot, is not particularly limited. Suitable core materials are, for example, CdS, CdSe, CdTe, ZnS, ZnSe, ZnSeS, ZnTe, ZnO, GaAs, GaP, GaSb, HgS, HgSe, HgSe, HgTe, InAs, InP, InPS, InPZnS, InPZn, InPGa, InSb, AlAs, AlP, AlSb, Cu₂S, Cu₂Se, CulnS2, CulnSe₂, Cu₂(ZnSn)S₄, Cu₂(InGa)S₄, TiO₂ alloys, and a combination of any of these.

Particularly preferably, said core of the semiconducting light emitting nanoparticle according to this embodiment of the present invention, for example a quantum dot, comprises one or more elements of group 12, 13 or 14 of the periodic table of elements and one or more elements of group 15 or 16 of the periodic table of elements. Preferred are the combinations of one or more elements of group 13 and of group 15, of group 12 and of group 16, of group 13 and of group 16, and of group 14 and of group 16, more preferred one or more elements of group 13 and of group 15, of group 12 and of group 16, and of group 13 and of group 16. Particularly preferred examples of the core are selected from GaAs, GaP, GaSb, InAs, InP, InPS, InPZnS, InPZn, InPGa, InSb, AlAs, AlP, AlSb, CulnS2, CulnSe₂, Cu₂(InGa)S₄, and a combination of any of these. In a very particularly preferred embodiment, the core comprises In and P atoms, for example, InP, InPS, InPZnS, InPZn or InPGa. Preferably, the core material is Cd-free.

According to the present invention, said at least one of the shell layers comprises a first element of group 12, 13 or 14 of the periodic table of elements, and a second element of group 15 or 16 of the periodic table of elements. Preferably, all shall layers comprises a first element of group 12, 13 or 14 of the periodic table of elements and a second element of group 15 or 16 of the periodic table of elements. In preferred combinations, the first element is of group 13 and the second of group 15, or the first element is of group 12 and the second of group 16, or the first element is of group 13 and the second of group 16, or the first element is of group 14 and the second of group 16. In more preferred combinations, the first element is of group 13 and the second of group 15, or the first element is of group 12 and the second of group 16, or the first element is of group 13 and the second of group 16. Preferably, the shell material is Cd-free.

Particularly preferably, at least one shell layer, preferably all shell layers, is represented by following formula (I),

ZnSₓSe_{y}Te_{z}, formula (I),

in which 0≤x≤1, 0≤y≤1, 0≤z≤1, and x+y+z=1, with 0≤x≤1, 0≤y≤1, z=0, and x+y=1 being even more preferred.

ZnS, ZnSe, ZnSeS, ZnSeSTe, CdS/ZnS, ZnSe/ZnS, ZnS/ZnSe shell layers are most preferably used.

Particularly preferred core-shell semiconducting light emitting nanoparticles, such as quantum dots, are selected from, CdSe/CdS, CdSeS/CdZnS, CdSeS/CdS/ZnS, ZnSe/CdS, CdSe/ZnS, InP/ZnS, InP/ZnSe, InP/ZnSe/ZnS, InP/ZnS/ZnSe, InPZn/ZnS, InPZn/ZnSe/ZnS, InPZn/ZnS/ZnSe, ZnSe/CdS, ZnSe/ZnS semiconducting light emitting nanoparticles or combination of any of these. Preferably, the core-shell semiconducting light emitting nanoparticle is Cd-free.

Very particular preference is given to InP/ZnS, InP/ZnSe, InP/ZnSe/ZnS, InP/ZnS/ZnSe, InPZn/ZnS, InPZn/ZnSe/ZnS and InPZn/ZnS/ZnSe core-shell semiconducting light emitting nanoparticles, such as quantum dots.

Such semiconducting light emitting nanoparticles are publically available, for example, from Sigma-Aldrich and / or described in, for example, ACS Nano, 2016, 10 (6), pp 5769-5781, Chem. Mater. 2015, 27, 4893-4898, and the international patent application No. WO 2010/095140 A2.

In a preferred embodiment of the present invention, the at least one semiconducting light emitting nanoparticle is a quantumsized light emitting material, in particular a quantum dot, which is further preferably Cd-free.

Thus, in a further preferred embodiment of the present invention, the electronic device comprises anode, cathode and at least one layer which comprises the following compounds:
a) at least one semiconducting light emitting nanoparticle selected from quantumsized light emitting materials, preferably from quantum dots and quantum rods, more preferably quantum dots, and particularly preferably selected from core-shell-structured quantum dots, as defined above; and
b) at least one compound selected from the formulae (2) to (5), (10) and (11) or the preferred embodiments as defined above.

The at least one semiconducting light emitting nanoparticle, such as a quantum dot, quantum rod, or core-shell structured semiconducting light emitting nanoparticle, may further have one or more different types of surface modifying ligands attached to its surface. Thus, the outermost surface of the light emitting material or the shell layers of the semiconducting light emitting nanoparticles may be over coated with one or more kinds of surface modifying ligands, particularly in order to improve dispersibility of the semiconducting light emitting nanoparticle in a solvent. Preferred examples of such surface ligands include, without being limited thereto, polyethylenimine (PEI), phosphines and phosphine oxides such as Trioctylphosphine oxide (TOPO), Trioctylphosphine (TOP), and Tributylphosphine (TBP); phosphonic acids such as Dodecylphosphonic acid (DDPA), Tridecylphosphonic acid (TDPA), Octadecylphosphonic acid (ODPA), and Hexylphosphonic acid (HPA); amines such as Oleylamine, Dedecyl amine (DDA), Tetradecyl amine (TDA), Hexadecyl amine (HDA), and Octadecyl amine (ODA), Oleylamine (OLA), 1-Octadecene (ODE), thiols such as hexadecane thiol, dodecanethiol and hexane thiol; mercapto carboxylic acids such as mercapto propionic acid and mercaptoundecanoicacid; carboxylic acids such as oleic acid, stearic acid, myristic acid, palmitic acid, acetic acid; and a combination of any of these.

Preferred examples of surface ligands have also been described, for example, in the international patent application No. WO 2012/059931 A.

As mentioned above, the electronic device according to the invention comprises anode, cathode and at least one layer which comprises the at least one semiconducting light emitting nanoparticle and the at least one compound selected from the formulae (2) to (5), (10) and (11) as defined above.

The electronic device is preferably an EL device selected from the group consisting of organic integrated circuits (OICs), organic field-effect transistors (OFETs), organic thin-film transistors (OTFTs), organic solar cells (OSCs), organic optical detectors, organic photoreceptors and, more preferably, organic electroluminescent devices. Preferred organic electroluminescent devices are organic light-emitting transistors (OLETs), organic field-quench devices (OFQDs), organic light-emitting electrochemical cells (OLECs, LECs, LEECs), organic laser diodes (O-lasers) and organic light emitting diodes (OLEDs), of which OLEDs are most preferred.

As mentioned above, the term organic electroluminescent devices in the context of the present application is understood to also include such hybrid systems of organic electroluminescent devices, such as OLEDs, which employ inorganic light emitting materials such as quantum dots (QD) as light emitting materials, and additionally may include one or more further inorganic layer, for example ZnO as the electron transport material (ETM) in OLEDs.

The electronic device here may comprise, apart from anode, cathode and one or more emission or emitting layers, which terms are used interchangeably herein, hole-injection layers, hole-transport layers, hole-blocking layers, electron-transport layers, electron-injection layers, exciton-blocking layers, electron-blocking layers and/or charge-generation layers (IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer)*.* Interlayers, which have, for example, an exciton-blocking function, may likewise be introduced between two emitting layers. However, it should be pointed out that each of these layers does not necessarily have to be present.

According to a preferred embodiment of the invention, the at least one layer, which comprises the at least one semiconducting light emitting nanoparticle and the at least one compound selected from the formulae (2) to (5), (10) and (11) as defined above, is an emitting layer (EML). Besides the at least one semiconducting light emitting nanoparticle, the EML preferably comprises one or more host or matrix materials, at least one of which has hole-transporting properties.

In this preferred embodiment of the invention, the at least one compound selected from the formulae (2) to (5), (10) and (11) as defined above is preferably employed in the EML as a host or matrix material for the at least one semiconducting light emitting nanoparticle, and more preferably a host or matrix material having hole transporting properties. The electronic device here may comprise one emitting layer or a plurality of emitting layers, where according to this embodiment at least one emitting layer comprises the at least one semiconducting light emitting nanoparticle and the at least one compound selected from the formulae (2) to (5), (10) and (11) as defined above as matrix material. If a plurality of emission layers is present, these preferably have in total a plurality of emission maxima between 380 nm and 750 nm, resulting overall in white emission, i.e. various emitting compounds and/or materials besides the at least one semiconducting light emitting nanoparticle which are able to fluoresce or phosphoresce are used in the emitting layers.

In a further preferred embodiment of the invention, the at least one layer comprising the at least one semiconducting light emitting nanoparticle and the at least one compound selected from the formulae (2) to (5), (10) and (11) or the preferred embodiments as defined above comprises from 5 to 95% by weight, preferably from 10 to 90% by weight, particularly preferably from 20 to 80% by weight, in particular from 25 to 75% by weight, of the at least one semiconducting light emitting nanoparticle, based on all components comprised in the layer.

In a particularly preferred embodiment of the present invention, the proportion of the at least one semiconducting light emitting nanoparticle in the emitting layer is from 5 to 95% by weight, preferably from 10 to 90% by weight, particularly preferably from 20 to 80% by weight, in particular from 25 to 75% by weight, and the proportion of the one or more host or matrix materials, preferably the at least one compound selected from the formulae (2) to (5), (10) and (11) or the preferred embodiments as defined above, is from 95 to 5 % by weight, preferably from 90 to 10% by weight, particularly preferably from 80 to 20% by weight, in particular from 75 to 25% by weight.

Further preferably, the at least one layer which comprises the at least one semiconducting light emitting nanoparticle and the at least one compound selected from the formulae (2) to (5), (10) and (11) or the preferred embodiments as defined above, which is preferably an emitting layer, may comprise at least one further material preferably selected from host materials, matrix materials, electron transporting materials, electron injecting materials, hole transporting materials, hole injecting materials, electron blocking materials, hole blocking materials and wide band gap materials, as typically used according to the prior art.

Within the present invention, wide band gap materials are understood to mean a material as disclosed in US 7,294,849, which is characterized in having a band gap of at least 3.5 eV, wherein the term "band gap" means the energy gap between the highest occupied molecular orbital (HOMO) and the lowest unoccupied molecular orbital (LUMO). Such systems exhibit particularly advantageous performance characteristics in electroluminescent devices.

There may be provided a use of the compound selected from the formulae (2) to (5), (10) and (11) or the preferred embodiments as defined above in the emitting layer as host or matrix material for the at least one semiconducting light emitting nanoparticle, such as a quantum dot, in combination with one or more further materials, preferably one or more further host or matrix materials. Particularly suitable further host or matrix materials which can be employed in combination with the compounds selected from the formulae (2) to (5), (10) and (11) or the preferred embodiments as host or matrix components of a mixed matrix or host system are aromatic ketones, aromatic phosphine oxides or aromatic sulfoxides or sulfones, for example in accordance with WO 2004/013080, WO 2004/093207, WO 2006/005627 or WO 2010/006680, triarylamines, carbazole derivatives, for example CBP (N,N-bis-carbazolylbiphenyl), m-CBP or the carbazole derivatives disclosed in WO 2005/039246, US 2005/0069729, JP 2004/288381, EP 1205527 or WO 2008/086851, indolocarbazole derivatives, for example in accordance with WO 2007/063754 or WO 2008/056746, indenocarbazole derivatives, for example in accordance with WO 2010/136109 or WO 2011/000455, azacarbazole derivatives, for example in accordance with EP 1617710, EP 1617711, EP 1731584, JP 2005/347160, bipolar matrix materials, for example in accordance with WO 2007/137725, silanes, for example in accordance with WO 2005/111172, azaboroles or boronic esters, for example in accordance with WO 2006/117052, triazine derivatives, for example in accordance with WO 2010/015306, WO 2007/063754 or WO 08/056746, zinc complexes, for example in accordance with EP 652273 or WO 2009/062578, fluorene derivatives, for example in accordance with WO 2009/124627, diazasilole or tetraazasilole derivatives, for example in accordance with WO 2010/054729, diazaphosphole derivatives, for example in accordance with WO 2010/054730, or bridged carbazole derivatives, for example in accordance with US 2009/0136779, WO 2010/050778, WO 2011/042107 or WO 2011/088877. Preferably, in this case, one of the materials is a material having hole-transporting properties and another material is a material having electron-transporting properties. It is furthermore possible to use an electronically neutral co-host which has neither hole-transporting nor electron-transporting properties, as described, for example, in WO 2010/108579.The compound selected from the formulae (2) to (5), (10) and (11) is preferably the host or matrix material having hole-transporting properties.

It is likewise possible to use one or more phosphorescent emitters in addition to the at least one semiconducting light emitting nanoparticle such as a quantum dot in the emitting layer. In this case, the emitter which emits at shorter wavelength acts as co-host.

Suitable phosphorescent compounds (= triplet emitters) are, in particular, compounds which emit light, preferably in the visible region, on suitable excitation and in addition contain at least one atom having an atomic number greater than 20, preferably greater than 38 and less than 84, particularly preferably greater than 56 and less than 80, in particular a metal having this atomic number. The phosphorescent emitters used are preferably compounds which contain copper, molybdenum, tungsten, rhenium, ruthenium, osmium, rhodium, iridium, palladium, platinum, silver, gold or europium, in particular compounds which contain iridium, platinum or copper.

Examples of the emitters described above are revealed by the applications WO 2000/70655, WO 2001/41512, WO 2002/02714, WO 2002/15645, EP 1191613, EP 1191612, EP 1191614, WO 2005/033244, WO 2005/019373, US 2005/0258742, WO 2009/146770, WO 2010/015307, WO 2010/031485, WO 2010/054731, WO 2010/054728, WO 2010/086089, WO 2010/099852, WO 2010/102709, WO 2011/157339 or WO 2012/007086. In general, all phosphorescent complexes as used in accordance with the prior art for phosphorescent OLEDs and as are known to the person skilled in the art in the area of organic electroluminescence are suitable, and the person skilled in the art will be able to use further phosphorescent complexes without inventive step.

The at least one semiconducting light emitting nanoparticle and the at least one compound selected from the formulae (2) to (5), (10) and (11) or the preferred embodiments as defined above may also be present, additionally or exclusively, in another layer of the electronic device than the emitting layer, preferably in a layer adjoining the emitting layer, for example a hole- or electron-blocking layer. In a further embodiment of the invention the at least one compound selected from the formulae (2) to (5), (10) and (11) is exclusively used as hole-transport material in a hole-transport or hole-injection or exciton-blocking layer, or is used both in a hole-transport or hole-injection or exciton-blocking layer and as a matrix material in the emitting layer. In the first case, the emitting layer comprises another organic compound, which preferably has hole transporting properties, as matrix material for the at least one semiconducting light emitting nanoparticle, which is preferably selected from the further matrix materials described above.

In a further embodiment of the invention, the electroluminescent device according to the invention does not comprise a separate hole-injection layer and/or hole-transport layer and/or hole-blocking layer and/or electron-transport layer, i.e. the emitting layer is directly adjacent to the hole-injection layer or the anode, and/or the emitting layer is directly adjacent to the electron-transport layer or the electron-injection layer or the cathode, as described, for example, in WO 2005/053051.

In the further layers of the electronic device of the invention besides the at least one layer comprising the at least one semiconducting light emitting nanoparticle and the at least one compound selected from the formulae (2) to (5), (10) and (11) as defined above, especially in the emitting layer, in the hole injection (HIL) and hole transport layers (HTL) and in the electron injection (EIL) and electron transport layers (ETL), it is possible to use any materials as typically used according to the prior art. The hole transport layers may also be p-doped and/or the electron transport layers may also be n-doped. A p-doped layer is understood to mean a layer in which free holes are generated and which has increased conductivity as a result. A comprehensive discussion of doped transport layers in OLEDs can be found in Chem. Rev. 2007, 107, 1233. More preferably, the p-dopant is capable of oxidizing the hole transport material in the hole transport layer, i.e. has a sufficiently high redox potential, especially a higher redox potential than the hole transport material. Suitable dopants are in principle any compounds which are electron acceptor compounds and which can increase the conductivity of the organic layer by oxidizing the host. The person skilled in the art, in the context of his common knowledge in the art, is able to identify suitable compounds without any great effort. Especially suitable dopants are the compounds disclosed in WO 2011/073149, EP 1968131, EP 2276085, EP 2213662, EP 1722602, EP 2045848, DE 102007031220, U.S. Pat. No. 8,044,390, U.S. Pat. No. 8,057,712, WO 2009/003455, WO 2010/094378, WO 2011/120709 and US 2010/0096600.

The person skilled in the art will therefore be able, without exercising inventive skill, to use all the materials known for electronic device, in particular electroluminescent devices, in combination with the at least one layer comprising the at least one semiconducting light emitting nanoparticle and the at least one compound selected from the formulae (2) to (5), (10) and (11) as defined above.

Preferred cathodes are metals having a low work function, metal alloys or multilayer structures composed of various metals, for example alkaline earth metals, alkali metals, main group metals or lanthanoids (e.g. Ca, Ba, Mg, Al, In, Mg, Yb, Sm, etc.). Additionally suitable are alloys composed of an alkali metal or alkaline earth metal and silver, for example an alloy composed of magnesium and silver. In the case of multilayer structures, in addition to the metals mentioned, it is also possible to use further metals having a relatively high work function, for example Ag, in which case combinations of the metals such as Mg/Ag, Ca/Ag or Ba/Ag, for example, are generally used. It may also be preferred to introduce a thin interlayer of a material having a high dielectric constant between a metallic cathode and the layer comprising the at least one semiconducting light emitting nanoparticle. Suitable for this purpose are, for example, alkali metal fluorides or alkaline-earth metal fluorides, but also the corresponding oxides or carbonates (for example LiF, Li₂O, BaF₂, MgO, NaF, CsF, Cs₂CO₃, etc.). Furthermore, lithium quinolinate (LiQ) can be used for this purpose. The layer thickness of this layer is preferably between 0.5 and 5 nm.

Preferred anodes are materials having a high work function. Preferably, the anode has a work function of greater than 4.5 eV versus vacuum. Firstly, metals having a high redox potential are suitable for this purpose, for example Ag, Pt or Au. On the other hand, metal/metal oxide electrons (e.g. Al/Ni/NiOx, Al/PtOx) may also be preferred. In this case, at least one of the electrodes has to be transparent or semitransparent in order to enable the emission of light. A preferred structure uses a transparent anode. Preferred anode materials here are conductive mixed metal oxides. Particular preference is given to indium tin oxide (ITO), aluminium doped zinc oxide (AZO) or indium zinc oxide (IZO). Preference is further given to conductive doped organic materials, especially conductive doped polymers.

In a further preferred embodiment of the invention, the electronic device is characterized in that one or more layers are coated by a sublimation method. In this case, the materials are applied by vapor deposition in vacuum sublimation systems at an initial pressure of less than 10⁻⁵ mbar, preferably less than 10⁻⁶ mbar. It is also possible that the initial pressure is even lower, for example less than 10⁻⁷ mbar.

In a further preferred embodiment of the invention, the electronic device is characterized in that one or more layers are coated by the OVPD (organic vapor phase deposition) method or with the aid of a carrier gas sublimation. In this case, the materials are applied at a pressure between 10⁻⁵ mbar and 1 bar. A special case of this method is the OVJP (organic vapor jet printing) method, in which the materials are applied directly by a nozzle and thus structured (for example, M. S. Arnold et al., Appl. Phys. Lett. 2008, 92, 053301).

In a further preferred embodiment of the invention, the electronic device is characterized in that one or more layers are applied from solution, for example by spin-coating, flood coating, dip coating, spray coating, or by any printing method, for example screen printing, relief printing, gravure printing, rotary printing, roller coating, flexographic printing, offset printing, LITI (light-induced thermal imaging, thermal transfer printing), inkjet printing or nozzle printing. For this purpose, soluble compounds are needed, which are obtained, for example, through suitable substitution. These methods are also particularly suitable for preparing the electronic device according to the invention, since the compounds selected from the formulae (2) to (5), (10) and (11) generally have very good solubility in organic solvents.

Also possible are hybrid processes, in which, for example, one or more layers are applied from solution and one or more further layers are applied by vapour deposition. Thus, for example, the emitting layer can be applied from solution and the electron-transport layer by vapour deposition.

These methods are known in general terms to those skilled in the art and can be applied by those skilled in the art without exercising inventive skill to electronic devices, in particular electroluminescent device, comprising the compounds and materials of the invention.

The present invention therefore further provides a method for preparing an an electronic device according to the present invention, characterized in that at least one layer is coated by a sublimation method and/or in that at least one layer is coated by an OVPD (organic vapor phase deposition) method or by means of a carrier gas sublimation and/or in that at least one layer is applied from solution by spin-coating or by a printing method. Preferably, the at least one layer coated or applied by the methods outlined above is the layer which comprises the at least one semiconducting light emitting nanoparticle and the at least one compound selected from the formulae (2) to (5), (10) and (11) as defined herein.

The electronic device comprising anode, cathode and at least one layer which comprises at least one semiconducting light emitting nanoparticle and at least one compound selected from the formulae (2) to (5), (10) and (11) as defined herein is appropriately (depending on its application) structured, provided with contacts and finally sealed, since the lifetime of the devices according to the invention is shortened in the presence of water and/or air.

For the processing of the compounds selected from the formulae (2) to (5), (10) and (11) as defined herein, or compositions comprising at least one semiconducting light emitting nanoparticle and at least one compound selected from the formulae (2) to (5), (10) and (11), from a liquid phase, for example by spin-coating or by printing methods, formulations of the compounds or compositions are required. These formulations may, for example, be solutions, dispersions or emulsions. For this purpose, it may be preferable to use mixtures of two or more solvents, for example mixtures of 1 to 5 solvents, or 1 to 4 solvents, more preferably organic solvents.

Suitable solvents are selected from the group consisting of alcohols, aldehydes, ketones, ethers, esters, amides such as dialkylformamides, sulfur compounds, nitro compounds, hydrocarbons, halogenated hydrocarbons, for example, chlorinated hydrocarbons, aromatic or heteroaromatic hydrocarbons, halogenated aromatic or heteroaromatic hydrocarbons and (cyclic)siloxanes, and mixtures of one or more thereof.

Preferred organic solvents are, for example, n-octane, n-decane, n-dodecane, iso-octane, iso-decane, iso-dodecane, 1,2,3,4-tetramethylbenzene, 1,2,3,5-tetramethylbenzene, 1,2,3-trimethylbenzene, 1,2,4-trichlorobenzene, 1,2,4-trimethylbenzene, 1,2-dihydronaphthalene, 1,2-dimethylnaphthalene, 1,3-benzodioxolane, 1,3-diisopropylbenzene , 1,3-dimethylnaphthalene, 1,4-benzodioxane, 1,4-diisopropylbenzene , 1,4-dimethylnaphthalene, 1,5-dimethyltetralin, 1-benzothiophene, 1-bromonaphthalene, 1-chloromethylnaphthalene, 1-ethylnaphthalene, 1-methoxynaphthalene, 1-methylnaphthalene, 1-methylindole, 2,3-benzofuran, 2,3-dihydrobenzofuran, 2,3-dimethyl-anisole, 2,4-dimethylanisole, 2,5-dimethylanisole, 2,6-dimethylanisole, 2,6-dimethylnaphthalene, 2-bromo-3-bromomethylnaphthalene, 2-bromomethylnaphthalene, 2-bromonaphthalene, 2-ethoxynaphthalene, 2-ethylnaphthalene, 2-isopropylanisole , 2-methylanisole, 2-methylindole, 3,4-dimethylanisole, 3,5-dimethylanisole, 3-bromoquinoline, 3-methylanisole, 4-methylanisole, 5-decanolide, 5-methoxyindane, 5-methoxyindole, 5-tert-butyl-m-xylene, 6-methylquinoline, 8-methylquinoline, acetophenone, anisole, benzonitrile, benzothiazole, benzyl acetate, bromobenzene, butyl benzoate, butyl phenyl ether, cyclohexylbenzene, decahydronaphthol, dimethoxytoluene, 3-phenoxytoluene, diphenyl ether, propiophenone, ethylbenzene, ethyl benzoate, γ-terpinene, hexylbenzene, indane, hexamethylindane, indene, isochroman, cumene, m-cymene, mesitylene, methyl benzoate, *o-, m-, p*-xylene, propyl benzoate, propylbenzene, o-dichlorobenzene, pentylbenzene, phenetol, ethoxybenzene, phenyl acetate, *p*-cymene, propiophenone, sec-butylbenzene, t-butylbenzene, thiophene, toluene, ethylbenzene, veratrol, monochlorobenzene, o-dichlorobenzene, pyridine, pyrazine, pyrimidine, pyrrolidinone, morpholine, dimethylacet-amide, dimethyl sulfoxide, decaline, and mixtures of one or more of these compounds.

The present invention furthermore relates to a composition comprising at least one semiconducting light emitting nanoparticle and at least one compound selected from the formulae (2) to (5), (10) and (11) or the preferred embodiments as defined herein.

The at least one semiconducting light emitting nanoparticle is preferably a semiconducting light emitting nanoparticle as defined above.

The at least one semiconducting light emitting nanoparticle and the at least one compound selected from the formulae (2) to (5), (10) and (11) or the preferred embodiments as defined herein may be used or applied together with further materials. A great variety of suitable organic functional materials is known to those skilled in the art in the field of electronic devices. Therefore, in a further preferred embodiment of the invention, the composition comprises one or more further materials, which are more preferably selected from from host materials, matrix materials, electron transporting materials, electron injecting materials, hole transporting materials, hole injecting materials, electron blocking materials, hole blocking materials and wide band gap materials, as typically used according to the prior art. Preferred further host or matrix materials are selected from the further host or matrix materials defined above.

Within the present invention, wide band gap materials are understood to mean a material as disclosed in US 7,294,849, which is characterized in having a band gap of at least 3.5 eV, wherein the term "band gap" means the energy gap between the highest occupied molecular orbital (HOMO) and the lowest unoccupied molecular orbital (LUMO). Such systems exhibit particularly advantageous performance characteristics in electroluminescent devices.

The present invention furthermore relates to a formulation, in particular a solution, dispersion or emulsion, comprising a composition as defined above, and at least a first solvent, in particular an organic solvent, which is more preferably selected from the group consisting of alcohols, aldehydes, ketones, ethers, esters, amides such as dialkylformamides, sulfur compounds, nitro compounds, hydrocarbons, halogenated hydrocarbons, for example, chlorinated hydrocarbons, aromatic or heteroaromatic hydrocarbons, halogenated aromatic or heteroaromatic hydrocarbons and (cyclic)siloxanes, and mixtures of one or more thereof.

That is, the formulation according to the invention comprises at least one semiconducting light emitting nanoparticle and at least one compound selected from the formulae (2) to (5), (10) and (11) as defined herein, and at least a first solvent, in particular an organic solvent, as defined above. The at least one semiconducting light emitting nanoparticle is preferably a semiconducting light emitting nanoparticle as defined above. The way in which solutions of this type can be prepared is known to the person skilled in the art and is described, for example, in WO 2002/072714, WO 2003/019694 and the literature cited therein.

In a further preferred embodiment of the invention, the first solvent has a surface tension of ≥ 20 mN/m.

The surface tension can be measured using a commonly and commercially available high precision drop shape analysis tool, namely FTA1000 from First Ten Ångstrom. The surface tension is determined by the software FTA1000. All measurements were performed at room temperature which is in the range between 20°C and 25°C. The standard operating procedure includes the determination of the surface tension of each formulation using a fresh disposable drop dispensing system (syringe and needle). Each drop is measured over the duration of one minute with sixty measurements which are later on averaged. For each formulation three drops are measured. The final value is averaged over said measurements. The tool is regularly cross-checked against various liquids having well known surface tensions.

In a still further preferred embodiment of the invention, the first solvent has a boiling point in the range from 150 to 350°C.

In a further preferred embodiment of the invention, the formulation comprises a second solvent, which is different from the first solvent and is preferably selected from the group defined above in relation to the first solvent.

It is particularly preferred according to the invention, that the content of the first solvent is in the range from 50 to 100 vol.-%, based on the total amount of solvents in the formulation.

In a still further preferred embodiment of the invention, the second solvent has a boiling point in the range from 150 to 350°C.

In a preferred embodiment of the formulation of the invention, the at least one compound selected from the formulae (2) to (5), (10) and (11) or the preferred embodiments as defined herein has a solubility in the first solvent in the range from 1 to 250 g/l.

In a further preferred embodiment of the invention, the formulation has a surface tension in the range from 15 to 80 mN/m.

In a further preferred embodiment of the invention, the formulation has a viscosity in the range from 1 to 50 mPas.

The viscosity of the formulations and solvents can be measured with a 1° cone-plate rotational rheometer of the type Discovery AR3 (Thermo Scientific). The equipment allows a precise control of the temperature and sheer rate. The measurement of the viscosity is carried out at a temperature of 25.0°C (+/- 0.2°C) and a sheer rate of 500
s⁻¹. Each sample is measured three times and the obtained measured values are averaged.

In a preferred embodiment of the formulation of the invention, the content of the at least one compound selected from the formulae (2) to (5), (10) and (11) as defined herein and the semiconducting light emitting nanoparticle in the formulation is in the range from 0.001 to 50 weight-%, preferably 0.001 to 20 weight-% , based on the total weight of the formulation.

The electronic devices according to the invention and the compositions and formulations according to the invention are distinguished by one or more of the following surprising advantages over the prior art:
1. By using a compound selected from the formulae (2) to (5), (10) and (11) in combination with a semiconducting light emitting nanoparticle, such as a quantum dot, which is in particular Cd-free, improved layer film homogeneity and morphology can be achieved. The electronic devices according to the invention, in particular Cd-free devices, which contain a compound selected from the formulae (2) to (5), (10) and (11) in combination with a semiconducting light emitting nanoparticle, such as a quantum dot, in particular in the emission layer, exhibit improved device performance, in particular reduced voltage, high efficiencies, longer lifetime and improved transport characteristics.
2. The formulations according to the invention, which contain a compound selected from the formulae (2) to (5), (10) and (11) in combination with a semiconducting light emitting nanoparticle, such as a quantum dot, which is in particular Cd-free, exhibit long-term stability, so that improved ink and film stability can be achieved.
3. The formulations according to the invention, which contain a compound selected from the formulae (2) to (5), (10) and (11) in combination with a semiconducting light emitting nanoparticle, such as a quantum dot, which is in particular Cd-free, exhibit excellent processability by inkjet printing and good wetting properties on a wide variety of substrates including transparent conductive oxides, hole injection materials, hole transporting materials, electron blocking, hole blocking, electron transporting and electron injecting materials. The formulation can be dried to form a smooth and continuous film with a homogenous composition and thickness.

The invention is explained in greater detail by the following examples, without wishing to restrict it thereby. On the basis of the descriptions, the person skilled in the art will be able to carry out the invention throughout the range disclosed and prepare further compounds according to the invention without inventive step and use them in electronic devices or use the process according to the invention.

### Examples:

### Fabrication of solution processed QD-OLED

The production of solution-based OLEDs has already been described in for example in WO 2004/037887 and WO 2010/097155. The process is adapted to the circumstances described below (layer-thickness variation, materials).

The inventive material combinations are used in the following layer sequence:
- substrate,
- ITO (50 nm),
- Hole injection layer (HIL) (20 nm),
- hole transport layer (HTL) (20 nm),
- emission layer (EML) (30 nm),
- electron-transport layer (ETL) (red: 60 nm; green: 50nm),
- electron injection layer (EIL) (3 nm),
- cathode (Al) (100 nm).

Glass plates coated with structured ITO (indium tin oxide) in a thickness of 50 nm serve as substrate. These are coated with the hole injection material (PEDOT) Clevios P VP Al 4083 (Heraeus Clevios GmbH, Leverkusen) by spin-coating in air. The layer is subsequently dried in air at 180°C for 10 minutes.

For the hole transport layer, the polymer of the structure shown in Table 1 (HTM) is used, which is synthesised in accordance with WO 2010/097155. The polymer is dissolved in toluene with a solid concentration of 5 g/l, in order to prepare a 20 nm thick layer. The layer is applied by spin-coating and dried at 225°C for 30 min. The deposition and drying are done under argon atmosphere.

**Table 1: Structural formulae of the additional materials used for solution processed layer preparation**

| |
|---|
| 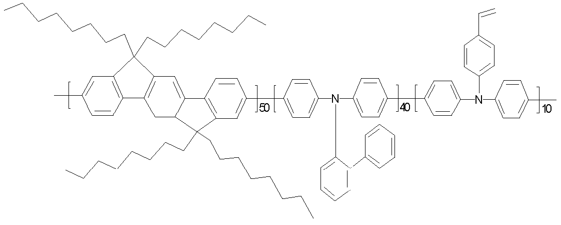 |
| HTM |

The emission layer is composed of a host material H (see the structures in Table 2) and the emitting material. The emitting material are InP/ZnS nanoparticles (quantum dots), which either emit red light (QD₆₂₇; PLₘₐₓ 627 nm) or green light (QD₅₃₂; PLₘₐₓ 532 nm). The quantum dots are synthesized according to US 2017/0009134 A1, Example 3 for red QDs and Example 5 for the green QDs.

The solids are dissolved in toluene and the solid content of such a solution is 9 g/L, a layer thickness of 30nm is achieved by spin-coating. The layers are applied by spin-coating in an inert-gas atmosphere, and dried by heating at 120°C for 10min. The materials used to prepare the EML in the devices and the ratios of host material and quantum dots are shown in Table 3a and Table 3b.

**Table 2: Chemical structures of the organic host materials used for solution processed EML preparation**

| | |
|---|---|
| 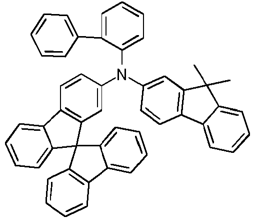 | 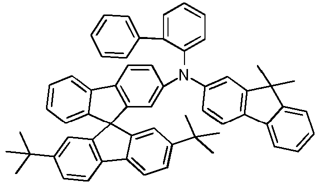 |
| H1 | H2 |
| 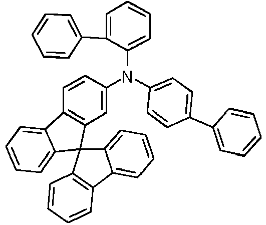 | 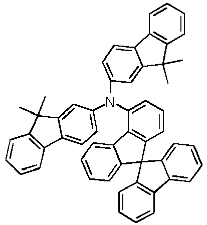 |
| H3 | H4 |
| 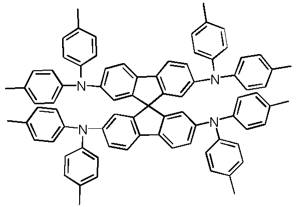 | |
| Ref H1 | |
| 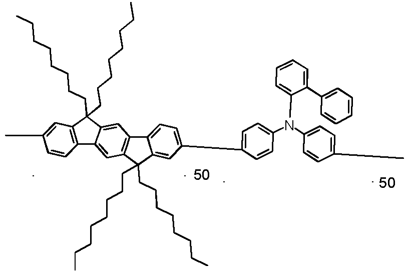 | |
| Ref H2 | |

**Table 3a: red EML compositions**

| Example | EML | |
|---|---|---|
| | Red QD₆₂₇ | Host |
| Ref1 | 100 wt-% | |
| Ref2 | 50 wt-% | 50% Ref H1 |
| Ref3 | 50 wt-% | 50% Ref H2 |
| E1 | 75 wt-% | H1 (25%) |
| E2 | 50 wt-% | H1 (50%) |
| E3 | 50 wt-% | H3 (50%) |
| E4 | 60 wt-% | H2 (40%) |
| E5 | 45 wt-% | H4 (55%) |

**Table 3b: green EML compositions**

| Example | EML | |
|---|---|---|
| | Green QD₅₂₄ | Host |
| gRef | 100 wt-% | |
| gE1 | 50 wt-% | H1 (50%) |

The materials for the electron-transport layer and the electron injection layer are likewise applied by thermal vapour deposition in a vacuum chamber and are shown in Table 4. The electron-transport layer is composed of the compound ETM, and the electron injection layer is composed of compound EIM. The cathode is formed by thermal evaporation of an aluminium layer with a thickness of 100 nm.

**Table 4: Chemical structures of the materials used for thermally evaporated layers**

| | |
|---|---|
| 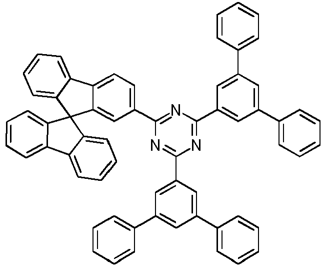 | 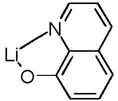 |
| ETM | EIM |

### Device characterization

The QD-OLEDs are characterised by standard methods. For this purpose, the electroluminescence spectra are recorded and the external quantum efficiencies (EQE, in percent) as a function of the luminous density assuming Lambert emission characteristics are calculated from current/voltage/luminous density characteristic lines (UIL characteristic lines). The electroluminescence (EL) spectra are recorded at a luminous density of 50 cd/m², and the CIE 1931 x and y colour coordinates are calculated from this data. The device data of the QD-OLEDs are summarized in Table 5.

**Table 5a: Device data of solution processed red QD-OLEDs**

| ***Example*** | ***Voltage @ 10mA*/*cm²*** | ***EQE @10cd*/*m²*** | ***EL max*** |
|---|---|---|---|
| | *V* | % | nm |
| Ref1 | 5.5 | 1.4 | 638 |
| Ref2 | 4.5 | 4.3 | 633 |
| Ref3 | 5.0 | 3.5 | 633 |
| E1 | 4.0 | 6.4 | 633 |
| E2 | 3.9 | 6.8 | 633 |
| E3 | 4.1 | 5.9 | 633 |
| E4 | 4.2 | 6.6 | 633 |
| E5 | 3.5 | 5.2 | 633 |

**Table 5b: Device data of solution processed green QD-OLEDs**

| ***Example*** | ***Voltage @ 10mA*/*cm²*** | ***EQE @10cd*/*m²*** | ***EL max*** |
|---|---|---|---|
| | *V* | % | nm |
| gRef1 | 5.2 | 2.2 | 527 |
| gE1 | 4.7 | 8.1 | 525 |

Table 5a shows that the use of a hole-transporting host materials H1 to H4 (Examples E1 to E5), according to the present invention give rise in efficiency while keeping the colour similar compared to the reference devices (Ref, Ref1, Ref2) when used as host materials in red Quantum dot-OLED devices.

Devices with green light emitting quantum dots instead of red light emitting quantum dots show results with a similar effect, when including the hole transporting host materials (see Table 5b).

### Fabrication of inkjet printable solutions

### Example 7

A solution of red quantum dots synthesized according to US 170009134 A1 Example 3 in toluene was concentrated under reduced pressure to obtain 5 g of solid Quantum dots. To the solid, an identical amount (5 g) of H1 is added and the combined solids are dissolved in a total of 500 ml of Cyclohexylbenzene to obtain an ink with the concentration of 20 g/l.

### Example 8

A solution of red quantum dots synthesized according to US 170009134 A1 Example 3 in toluene was concentrated under reduced pressure to obtain 5 g of solid Quantum dots. To the solid, an identical amount (5 g) of H1 is added and the combined solids are dissolved in a total of 500 ml of 3,4-Dimethylanisole to obtain an ink with the concentration of 20 g/l.

### Example 9

A solution of red quantum dots synthesized according to US 170009134 A1 Example 3 in toluene was concentrated under reduced pressure to obtain 5 g of solid Quantum dots. To the solid, an identical amount (5 g) of H1 is added and the combined solids are dissolved in a total of 500 ml of Cyclohexylbenzene/3,4-Dimethylanisole (50/50 V/V) to obtain an ink with the concentration of 20 g/l.

The jetting performance of the inks of Ex. 7-9 are tested with a Dimatix DMP-2831 printer with 10 pl cartridges. The ligament length and the voltage is recorded for different droplet speeds while keeping the pulse width and the pulse shape constant. Also the maximum drop ejection frequency with stable drop ejection and drop volume is recorded.

The inks of Ex. 7-9 have very good properties for inkjet printing, the high boiling point of the solvents prevents nozzle clogging and ensures formation of a homogenous and smooth film upon drying.

## Claims

1. Electronic device comprising anode, cathode and at least one layer which comprises the following compounds:
a) at least one semiconducting light emitting nanoparticle; and
b) at least one compound selected from the following formulae (2) to (5), (10) and (11): 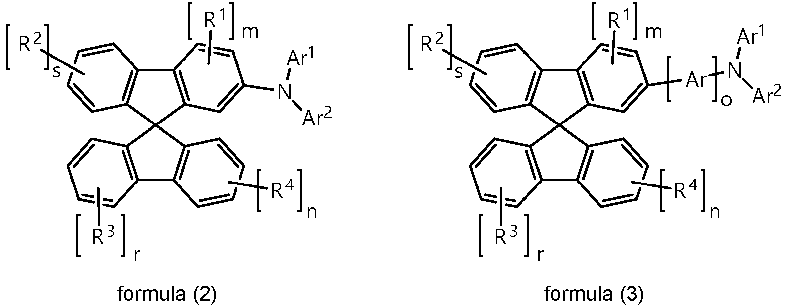 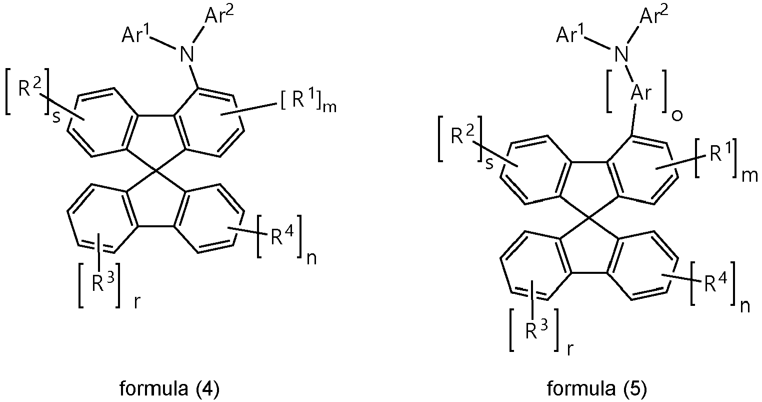 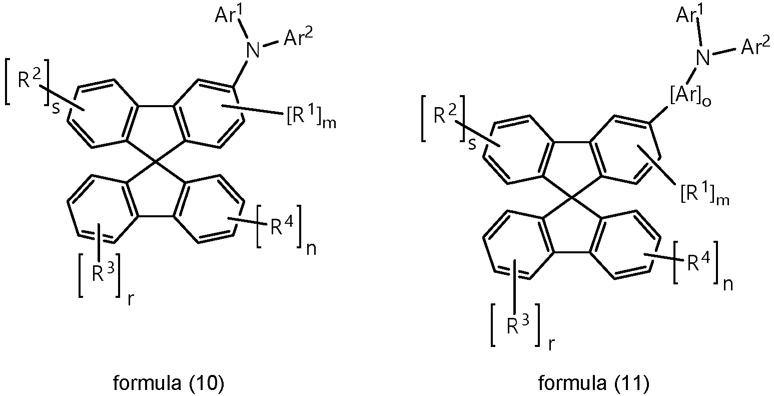 where the following applies to the symbols and indices used:
Ar is, identically or differently on each occurrence, an aromatic ring system selected from the group consisting of benzene, naphthalene, phenanthrene, fluorene, spirobifluorene, dibenzofuran and dibenzothiophene, each of which may be substituted by one or more radicals R^{5a}; Ar may also be connected to Ar¹ and/or to Ar² here by a group E;
Ar¹, Ar² are, identically or differently on each occurrence, an aromatic or heteroaromatic ring system having 6 to 60 C, each of which may also be substituted by one or more radicals R^{5a}; Ar¹ and Ar² here may also be connected to one another and/or Ar¹ may be connected to Ar and/or Ar² may be connected to Ar by a group E;
E is on each occurrence, identically or differently, a single bond, C(R^{5a})₂, NR^{5a}, O or S;
R¹, R², R³ are selected on each occurrence, identically or differently, from the group consisting of H, D, F, Cl, Br, I, CN, Si(R⁶)₃, a straight-chain alkyl, alkoxy or thioalkyl group having 1 to 40 C atoms or a branched or cyclic alkyl, alkoxy or thioalkyl group having 3 to 40 C atoms, each of which may be substituted by one or more radicals R⁶, where in each case one or more non-adjacent CH₂ groups may be replaced by Si(R⁶)₂, C=NR⁶, P(=O)(R⁶), SO, SO₂, NR⁶, O, S or CONR⁶ and where one or more H atoms may be replaced by D, F, Cl, Br or I, an aromatic or heteroaromatic ring system having 6 to 60 C atoms, which may in each case be substituted by one or more radicals R⁶, an aryloxy group having 5 to 60 aromatic ring atoms, which may be substituted by one or more radicals R⁶, or an aralkyl group having 5 to 60 aromatic ring atoms, which may in each case be substituted by one or more radicals R⁶, where two or more adjacent substituents R¹ or R² or R³ may optionally form a mono- or polycyclic, aliphatic ring system, which may be substituted by one or more radicals R⁶;
R⁴ is selected, identically or differently on each occurrence, from the group consisting of H, D, F, Cl, Br, I, CN, Si(R⁶)₃, a straight-chain alkyl, alkoxy or thioalkyl group having 1 to 40 C atoms or a branched or cyclic alkyl, alkoxy or thioalkyl group having 3 to 40 C atoms, each of which may be substituted by one or more radicals R⁶, where in each case one or more non-adjacent CH₂ groups may be replaced by Si(R⁶)₂, C=NR⁶, P(=O)(R⁶), SO, SO₂, O, S or CONR⁶ and where one or more H atoms may be replaced by D, F, Cl, Br or I, an aromatic or heteroaromatic ring system having 6 to 60 C atoms, which may in each case be substituted by one or more radicals R⁶, an aryloxy group having 5 to 60 aromatic ring atoms, which may be substituted by one or more radicals R⁶, or an aralkyl group having 5 to 60 aromatic ring atoms, which may in each case be substituted by one or more radicals R⁶, where two or more adjacent substituents R⁴ may optionally form a mono- or polycyclic, aliphatic ring system, which may be substituted by one or more radicals R⁶;
R^{5a} is selected on each occurrence, identically or differently, from the group consisting of H, D, F, Cl, Br, I, CN, Si(R⁶)₃, a straight-chain alkyl, alkoxy or thioalkyl group having 1 to 40 C atoms or a branched or cyclic alkyl, alkoxy or thioalkyl group having 3 to 40 C atoms, each of which may be substituted by one or more radicals R⁶, where in each case one or more non-adjacent CH₂ groups may be replaced by Si(R⁶)₂, C=NR⁶, P(=O)(R⁶), SO, SO₂, NR⁶, O, S or CONR⁶ and where one or more H atoms may be replaced by D, F, Cl, Br or I, an aromatic or heteroaromatic ring system having 6 to 60 C atoms, which may in each case be substituted by one or more radicals R⁶, an aryloxy group having 5 to 60 aromatic ring atoms, which may be substituted by one or more radicals R⁶, or an aralkyl group having 5 to 60 aromatic ring atoms, which may in each case be substituted by one or more radicals R⁶, where two or more adjacent substituents R^{5a} may optionally form a mono- or polycyclic, aliphatic ring system, which may be substituted by one or more radicals R⁶;
R⁶ is selected from the group consisting of H, D, F, an aliphatic hydrocarbon radical having 1 to 20 C atoms or an aromatic or heteroaromatic ring system having 5 to 30 C atoms, in which one or more H atoms may be replaced by D or F, where two or more adjacent substituents R⁶ may form a mono- or polycyclic, aliphatic ring system with one another;
m is 0, 1, 2 or 3;
n is on each occurrence, identically or differently, 0, 1, 2, 3 or 4;
o is on each occurrence, identically or differently, 0, 1 or 2;
r, s are on each occurrence, identically or differently, 0, 1, 2, 3 or 4.

2. Electronic device according to claim 1, **characterised in that** the at least one compound b) is selected from the following compounds of formulae (2a-1) to (2a-3), (3a-1) to (3a-3), (4a), (5a), (10a) and (11a): 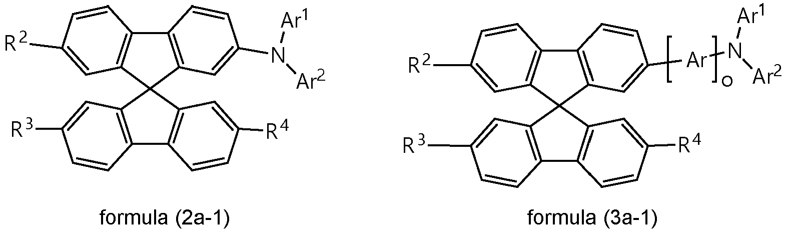 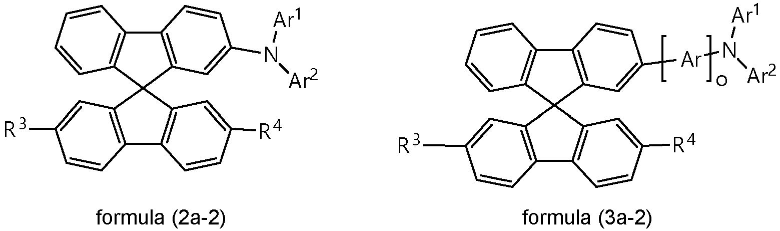 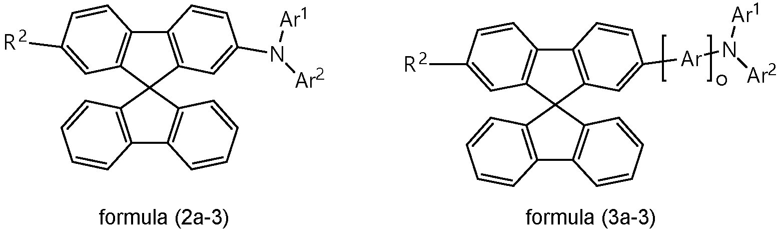 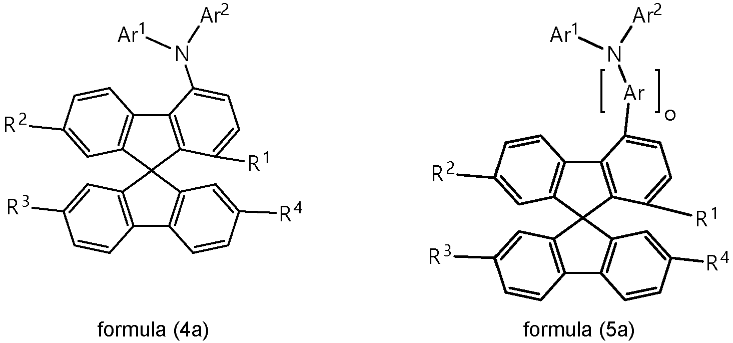 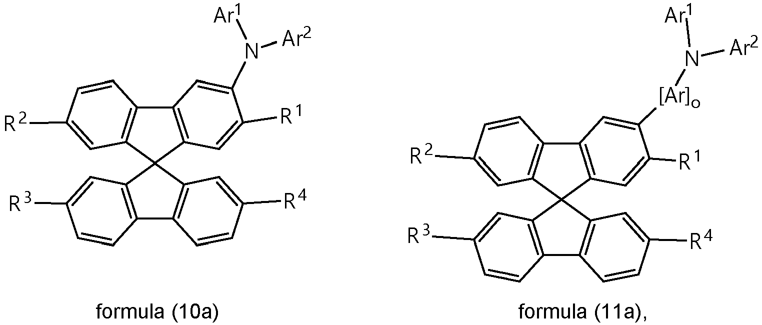 where the symbols and indices are as defined in claim 1.

3. Electronic device according to claim 1 or 2, **characterised in that** the at least one compound b) is selected from the following compounds of formulae (2b) to (5b), (10b) and (11b): 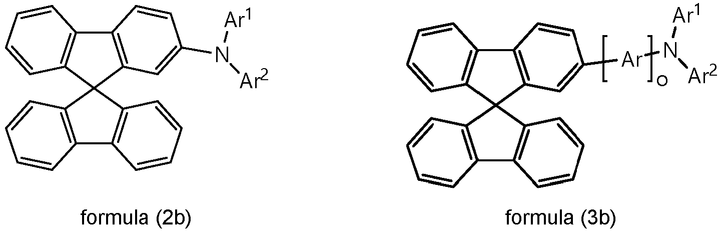 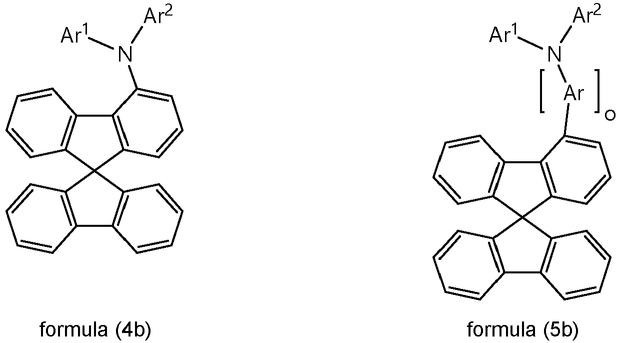 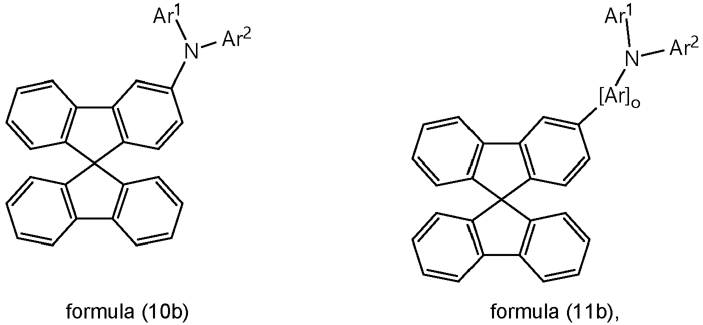 where the symbols and indices are as defined in claim 1.

4. Electronic device according to one or more of claims 1 to 3, **characterised in that** the groups Ar¹ and Ar² are selected, identically or differently on each occurrence, from the group consisting of fluorenyl, spirobifluorenyl, phenyl, biphenyl, terphenyl, quaterphenyl, carbazolyl, dibenzofuranyl, dibenzothiophenyl, naphthyl and phenantryl, each of which may be substituted, identically or differently, by one or more radicals R^{5a}.

5. Electronic device according to one or more of claims 1 to 4, **characterised in that** the groups Ar¹ and Ar² are selected, identically or differently on each occurrence, from the groups of the formulae (Ar-1) to (Ar-123),
| | | |
|---|---|---|
| 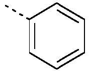 | 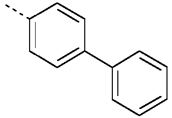 | 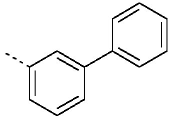 |
| Ar-1 | Ar-2 | Ar-3 |
| 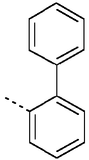 | 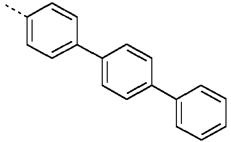 | 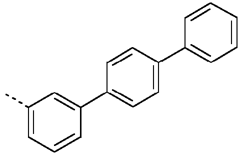 |
| Ar-4 | Ar-5 | Ar-6 |
| 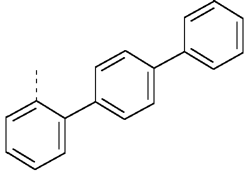 | 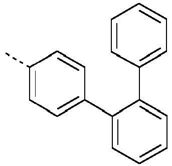 | 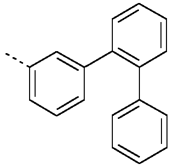 |
| Ar-7 | Ar-8 | Ar-9 |
| 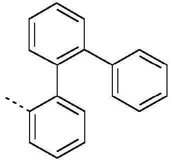 | 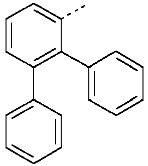 | 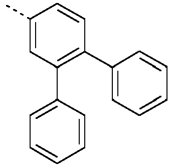 |
| Ar-10 | Ar-11 | Ar-12 |
| 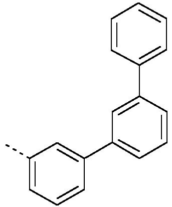 | 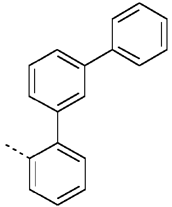 | 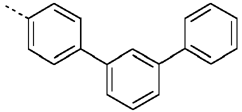 |
| Ar-13 | Ar-14 | Ar-15 |
| 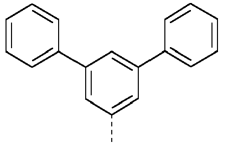 | 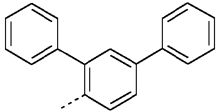 | 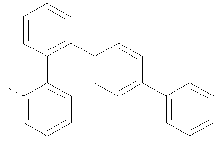 |
| Ar-16 | Ar-17 | Ar-18 |
| 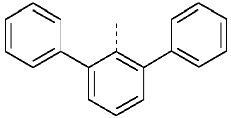 | | |
| Ar-19 | | |
| 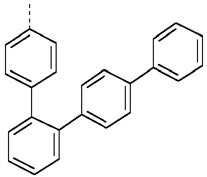 | 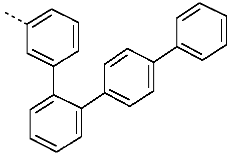 | 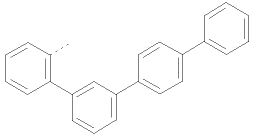 |
| Ar-20 | Ar-21 | Ar-22 |
| 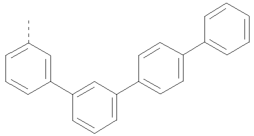 | 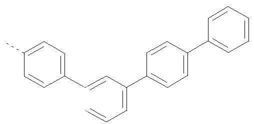 | 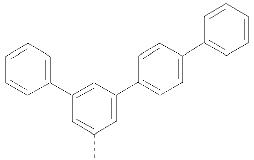 |
| Ar-23 | Ar-24 | Ar-25 |
| 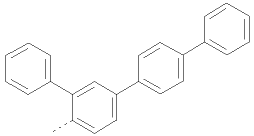 | 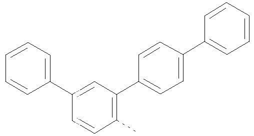 | 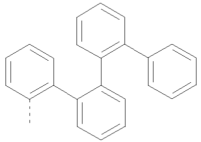 |
| Ar-26 | Ar-27 | Ar-28 |
| 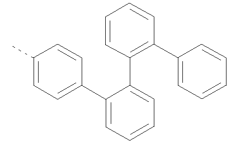 | 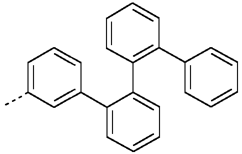 | 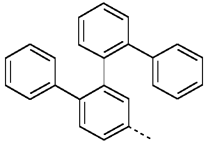 |
| Ar-29 | Ar-30 | Ar-31 |
| 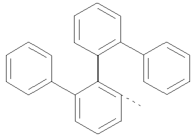 | 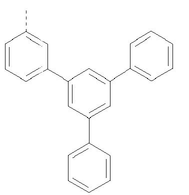 | 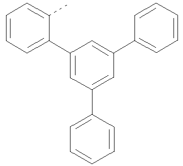 |
| Ar-32 | Ar-33 | Ar-34 |
| 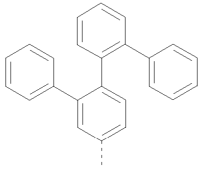 | 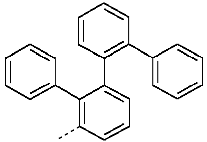 | 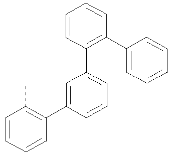 |
| Ar-35 | Ar-36 | Ar-37 |
| 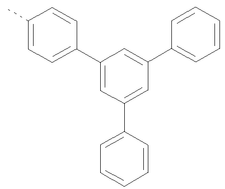 | 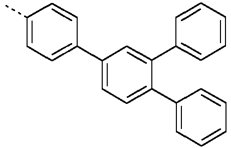 | 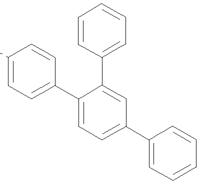 |
| Ar-38 | Ar-39 | Ar-40 |
| 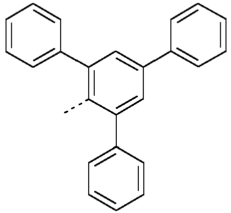 | 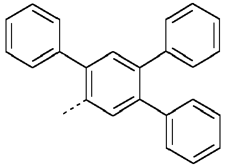 | 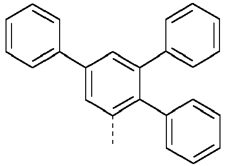 |
| Ar-41 | Ar-42 | Ar-43 |
| 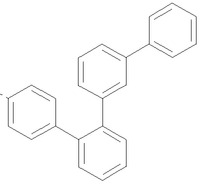 | 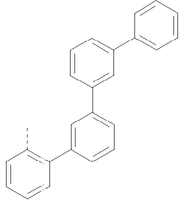 | 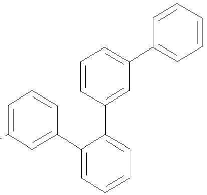 |
| Ar-44 | Ar-45 | Ar-46 |
| 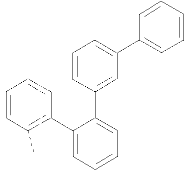 | | |
| Ar-47 | | |
| 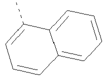 | 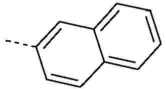 | 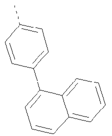 |
| Ar-48 | Ar-49 | Ar-50 |
| 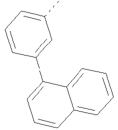 | 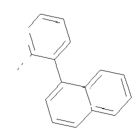 | 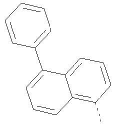 |
| Ar-51 | Ar-52 | Ar-53 |
| 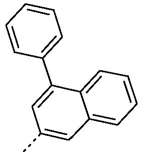 | 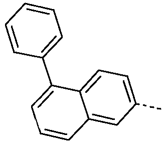 | 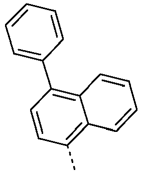 |
| Ar-54 | Ar-55 | Ar-56 |
| 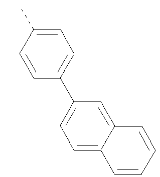 | 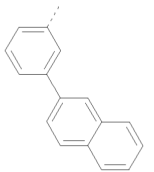 | 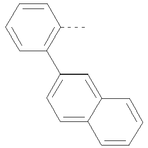 |
| Ar-57 | Ar-58 | Ar-59 |
| 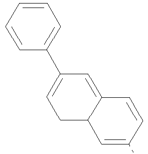 | 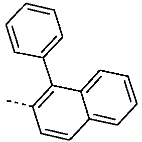 | 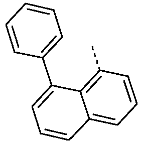 |
| Ar-60 | Ar-61 | Ar-62 |
| 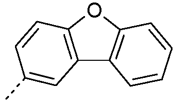 | 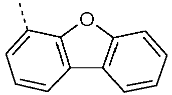 | 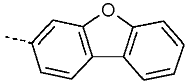 |
| Ar-63 | Ar-64 | Ar-65 |
| 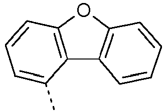 | 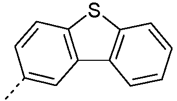 | 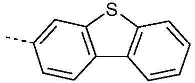 |
| Ar-66 | Ar-67 | Ar-68 |
| 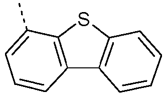 | 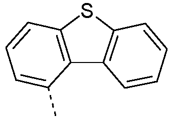 | 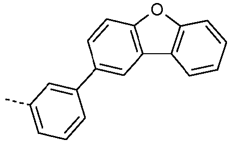 |
| Ar-69 | Ar-70 | Ar-71 |
| 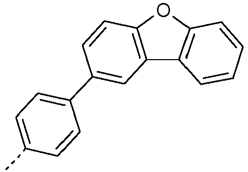 | 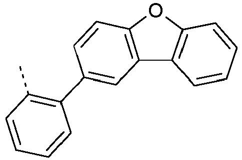 | 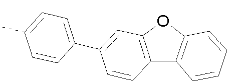 |
| Ar-72 | Ar-73 | Ar-74 |
| 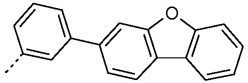 | 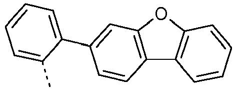 | 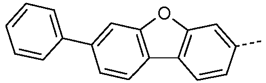 |
| Ar-75 | Ar-76 | Ar-77 |
| 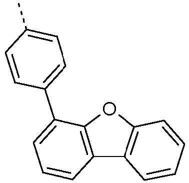 | 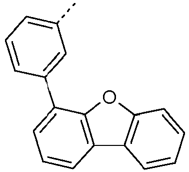 | 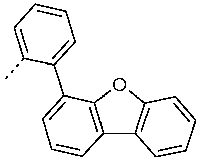 |
| Ar-78 | Ar-79 | Ar-80 |
| 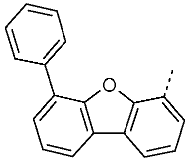 | 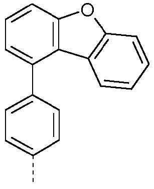 | 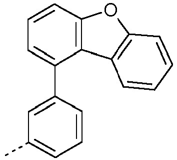 |
| Ar-81 | Ar-82 | Ar-83 |
| 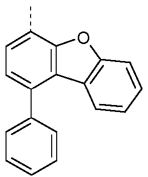 | 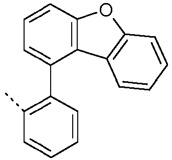 | 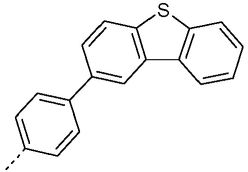 |
| Ar-84 | Ar-85 | Ar-86 |
| 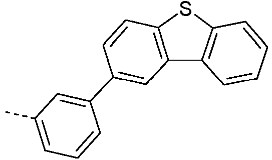 | 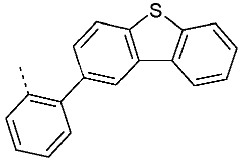 | 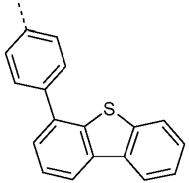 |
| Ar-87 | Ar-88 | Ar-89 |
| 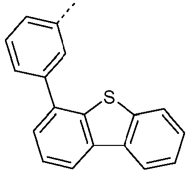 | 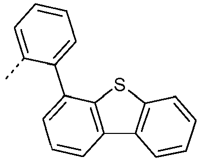 | 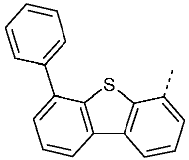 |
| Ar-90 | Ar-91 | Ar-92 |
| 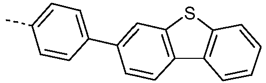 | 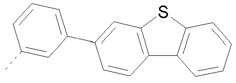 | 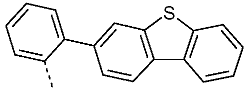 |
| Ar-93 | Ar-94 | Ar-95 |
| 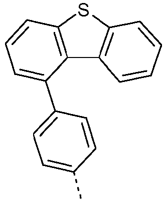 | 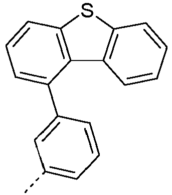 | 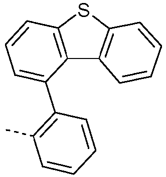 |
| Ar-96 | Ar-97 | Ar-98 |
| 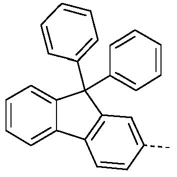 | 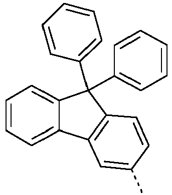 | 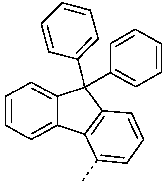 |
| Ar-99 | Ar-100 | Ar-101 |
| 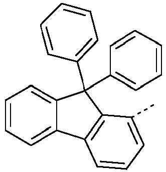 | 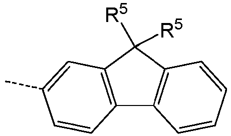 | 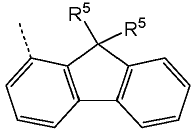 |
| Ar-102 | Ar-103 | Ar-104 |
| 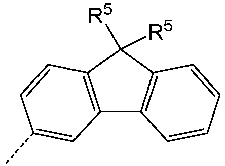 | 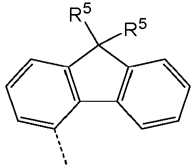 | 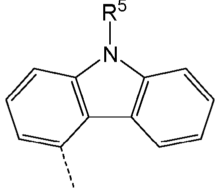 |
| Ar-105 | Ar-106 | Ar-107 |
| 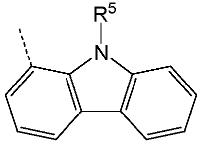 | 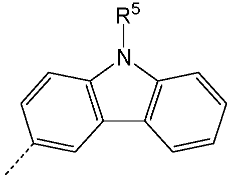 | 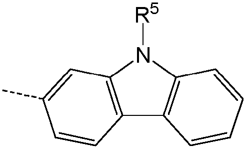 |
| Ar-108 | Ar-109 | Ar-110 |
| 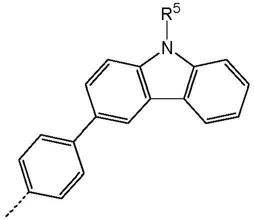 | 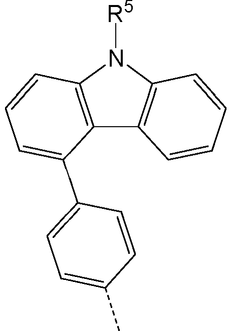 | 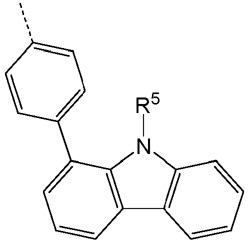 |
| Ar-111 | Ar-112 | Ar-113 |
| 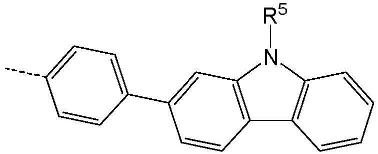 | | 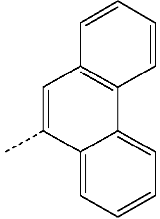 |
| Ar-114 | | Ar-115 |
| 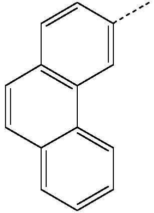 | 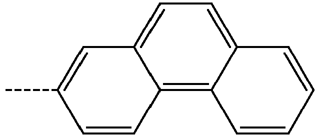 | |
| Ar-116 | Ar-117 | |
| 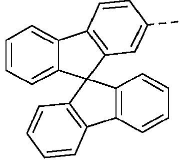 | 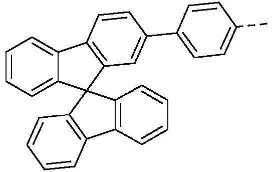 | |
| Ar-118 | Ar-119 | |
| 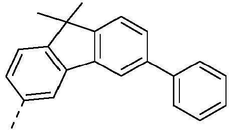 | 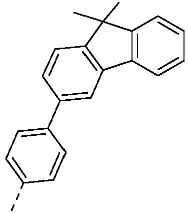 | |
| Ar-120 | Ar-120 | |
| 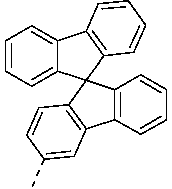 | 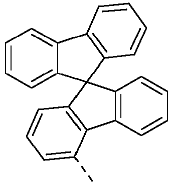 | |
| Ar-121 | Ar-122 | |
| 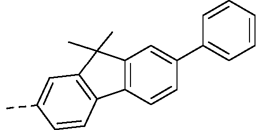 | | |
| Ar-123 | | |
where the dashed bond indicates the bond to the nitrogen, the groups may be substituted, identically or differently, by one or more radicals R^{5a} as defined in claim 1, but are preferably unsubstituted, and R⁵ in the groups of the formulae (Ar-103) to (Ar-114) has the same meaning as defined in claim 1 for R^{5a}.

6. Electronic device according to one or more of claims 1 to 5, **characterised in that** Ar¹ and Ar² are selected, identically or differently on each occurrence, from the groups of the formulae (Ar-1), (Ar-2), (Ar-3), (Ar-4), (Ar-5), (Ar-6), (Ar-8), (Ar-9), (Ar-10), (Ar-12), (Ar-13), (Ar-15), (Ar-16), (Ar-17), (Ar-18), (Ar-19), (Ar-20), (Ar-31), (Ar-38), (Ar-41), (Ar-48), (Ar-49), (Ar-52), (Ar-63), (Ar-64), (Ar-65), (Ar-66), (Ar-71), (Ar-72), (Ar-73), (Ar-74), (Ar-75), (Ar-76), (Ar-77), (Ar-78), (Ar-79), (Ar-80), (Ar-81), (Ar-82), (Ar-83), (Ar-84), (Ar-85), (Ar-99), (Ar-100), (Ar-101), (Ar-103), (Ar-104), (Ar-105), (Ar-106), (Ar-107), (Ar-111), (Ar-115), (Ar-116), (Ar-117), (Ar-118), (Ar-119), (Ar-120), (Ar-121) and (Ar-122).

7. Electronic device according to one or more of claims 1 to 6, **characterised in that** Ar¹ and Ar² are different from one another.

8. Electronic device according to one or more of claims 1 to 7, **characterised in that** R^{5a} which is bonded to Ar¹ or Ar² is selected, identically or differently on each occurrence, from the group consisting of H, D, F, CN, a straight-chain alkyl group having 1 to 10 C atoms, a branched or cyclic alkyl group having 3 to 10 C atoms or an aromatic or heteroaromatic ring system having 5 to 24 aromatic ring atoms, each of which may be substituted by one or more radicals R⁶.

9. Electronic device according to one or more of claims 1 to 8, **characterised in that** the at least one semiconducting light emitting nanoparticle is selected from quantumsized light emitting materials, in particular from quantum dots and quantum rods.

10. Electronic device according to one or more of claims 1 to 9, **characterised in that** the at least one semiconducting light emitting nanoparticle quantumsized light emitting material is Cd-free.

11. Electronic device according to one or more of claims 1 to 10, which is selected from the group consisting of organic integrated circuits (OICs), organic field-effect transistors (OFETs), organic thin-film transistors (OTFTs), organic solar cells (OSCs), organic optical detectors, organic photoreceptors and organic electroluminescent devices, preferably organic electroluminescent devices which are more preferably selected from organic light-emitting transistors (OLETs), organic field-quench devices (OFQDs), organic light-emitting electrochemical cells (OLECs, LECs, LEECs), organic laser diodes (O-lasers) and organic light emitting diodes (OLEDs).

12. Electronic device according to one or more of claims 1 to 13, **characterised in that** the at least one layer is an emitting layer.

13. Method for preparing an electronic device according to one or more of claims 1 to 12, **characterized in that** at least one layer, preferably the at least one layer which comprises the at least one semiconducting light emitting nanoparticle and the at least one compound represented by the general following formula (1), is coated by a sublimation method and/or is coated by an OVPD method or by means of a carrier gas sublimation and/or is applied from solution by spin-coating or by a printing method.

14. Composition comprising at least one semiconducting light emitting nanoparticle and at least one compound selected from the formulae (2) to (5), (10) and (11) as defined in claim 1.

15. Formulation comprising a composition according to claim 14, or at least one semiconducting light emitting nanoparticle and at least one compound selected from the formulae (2) to (5), (10) and (11) as defined in claim 1, and at least a first solvent.

16. Formulation according to claim 15, **characterized in that** the first solvent is selected from the group consisting of alcohols, aldehydes, ketones, ethers, esters, amides such as dialkylformamides, sulfur compounds, nitro compounds, hydrocarbons, halogenated hydrocarbons (e.g. chlorinated hydrocarbons), aromatic or heteroaromatic hydrocarbons, halogenated aromatic or heteroaromatic hydrocarbons and (cyclic)siloxanes, and mixtures of two or more thereof.

17. Formulation according claim 15 or 16, **characterised in that** the first solvent that has a surface tension at room temperature (20°C to 25°C) of ≥ 20 mN/m as measured by the high precision drop shape analysis tool disclosed in the description.

18. Formulation according to one or more of claims 15 to 17, **characterised in that** the first solvent has a boiling point in the range from 150 to 350°C.

19. Formulation according to one or more of claims 15 to 18, **characterised in that** the formulation comprises a second solvent which is different from the first solvent.

20. Formulation according to one or more of claims 15 to 19, **characterised in that** the content of the first solvent is in the range from 50 to 100 vol.-%, based on the total amount of solvents in the formulation.

21. Formulation according to claim 19 or 20, **characterised in that** the second solvent has a boiling point in the range from 150 to 350°C.

22. Formulation according to one or more of claims 15 to 21, **characterised in that** the formulation has a surface tension at room temperature (20°C to 25°C) in the range from 15 to 80 mN/m as measured by the high precision drop shape analysis tool disclosed in the description.

23. Formulation according to one or more of claims 15 to 22, **characterised in that** the formulation has a viscosity at 25.0°C (+/- 0.2°C) in the range from 1 to 50 mPa·s as measured by the 1° cone-plate rotational rheometer disclosed in the description.

24. Formulation according to one or more of claims 15 to 23, **characterised in that** the content of the at least one compound selected from the formulae (2) to (5), (10) and (11)and the at least one semiconducting light emitting nanoparticle in the formulation is in the range from 0.001 to 50 weight-%, based on the total weight of the formulation.

## Patentansprüche

1. Elektronische Vorrichtung, umfassend Anode, Kathode und mindestens eine Schicht, die die folgenden Verbindungen umfasst:
a) mindestens ein halbleitendes lichtemittierendes Nanopartikel; und
b) mindestens eine Verbindung ausgewählt aus den folgenden Formeln (2) bis (5), (10) und (11): 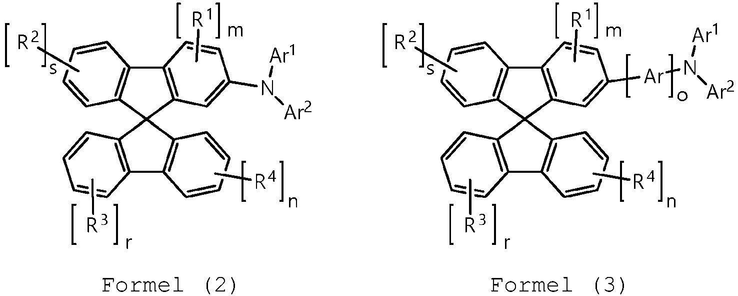 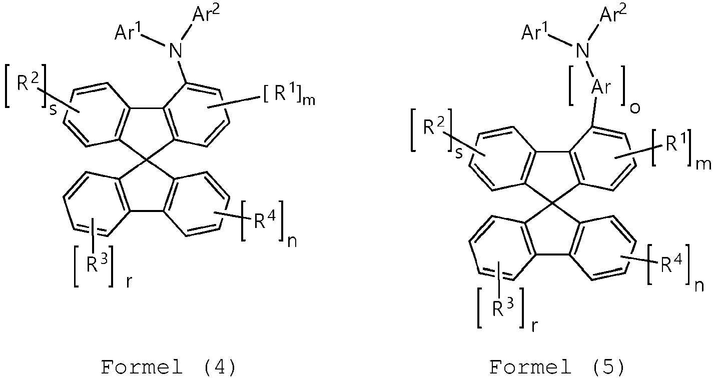 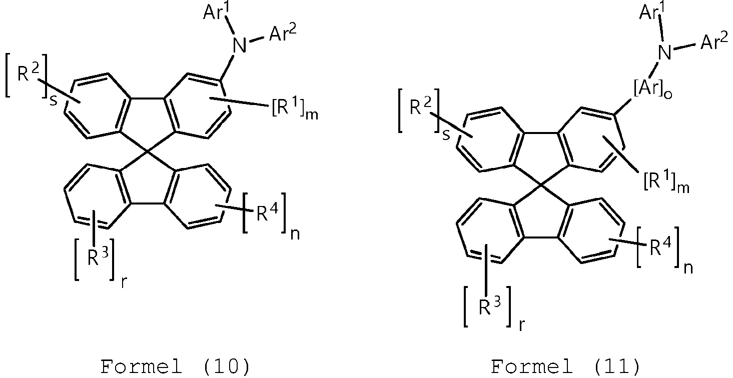 wobei für die verwendeten Symbole und Indizes Folgendes gilt:
Ar ist gleich oder verschieden bei jedem Auftreten ein aromatisches Ringsystem ausgewählt aus der Gruppe bestehend aus Benzol, Naphthalin, Phenanthren, Fluoren, Spirobifluoren, Dibenzofuran und Dibenzothiophen, von denen jedes mit einem oder mehreren Resten R^{5a} substituiert sein kann; Ar kann hier auch mit Ar¹ und/oder mit Ar² durch eine Gruppe E verbunden sein;
Ar¹, Ar² sind gleich oder verschieden bei jedem Auftreten ein aromatisches oder heteroaromatisches Ringsystem mit 6 bis 60 C, von denen jedes auch durch einen oder mehrere Reste R^{5a} substituiert sein kann; Ar¹ und Ar² können hier auch miteinander verbunden sein und/oder Ar¹ kann mit Ar verbunden sein und/oder Ar² kann mit Ar durch eine Gruppe E verbunden sein;
E ist bei jedem Auftreten gleich oder verschieden eine Einfachbindung, C(R^{5a})₂, NR^{5a}, O oder S;
R¹, R², R³ sind bei jedem Auftreten gleich oder verschieden ausgewählt aus der Gruppe bestehend aus H, D, F, Cl, Br, I, CN, Si(R⁶)₃, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen, die jeweils substituiert sein können durch einen oder mehrere Reste R⁶, wobei in jedem Fall eine oder mehrere nicht benachbarte CH₂-Gruppen ersetzt sein können durch Si(R⁶)₂, C=NR⁶, P(=O)(R⁶), SO, SO₂, NR⁶, O, S oder CONR⁶ und wobei ein oder mehrere H-Atome ersetzt sein können durch D, F, Cl, Br oder I, einem aromatischen oder heteroaromatischen Ringsystem mit 6 bis 60 C-Atomen, die in jedem Fall substituiert sein können durch einen oder mehrere Reste R⁶, einer Aryloxygruppe mit 5 bis 60 aromatischen Ringatomen, die substituiert sein können durch einen oder mehrere Reste R⁶, oder einer Aralkylgruppe mit 5 bis 60 aromatischen Ringatomen, die in jedem Fall substituiert sein können durch einen oder mehrere Reste R⁶, wobei zwei oder mehr benachbarte Substituenten R¹ oder R² oder R³ optional ein mono- oder polycyclisches, aliphatisches Ringsystem bilden können, das substituiert sein kann durch einen oder mehrere Reste R⁶;
R⁴ ist bei jedem Auftreten gleich oder verschieden ausgewählt aus der Gruppe bestehend aus H, D, F, Cl, Br, I, CN, Si(R⁶)₃, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen, von denen jedes substituiert sein kann durch einen oder mehrere Reste R⁶, wobei in jedem Fall ein oder mehrere nicht benachbarte CH₂-Gruppen ersetzt sein können durch Si(R⁶)₂, C=NR⁶, P(=O)(R⁶), SO, SO₂, O, S oder CONR⁶ und wobei ein oder mehrere H-Atome ersetzt sein können durch D, F, Cl, Br oder I, einem aromatischen oder heteroaromatischen Ringsystem mit 6 bis 60 C-Atomen, die in jedem Fall durch einen oder mehrere Reste R⁶ substituiert sein können, einer Aryloxygruppe mit 5 bis 60 aromatischen Ringatomen, die substituiert sein können durch einen oder mehrere Reste R⁶, oder einer Aralkylgruppe mit 5 bis 60 aromatischen Ringatomen, die in jedem Fall substituiert sein können durch einen oder mehrere Reste R⁶, wobei zwei oder mehrere benachbarte Substituenten R⁴ optional ein mono- oder polycyclisches, aliphatisches Ringsystem bilden können, das substituiert sein kann durch einen oder mehrere Reste R⁶;
R^{5a} ist bei jedem Auftreten gleich oder verschieden ausgewählt aus der Gruppe bestehend aus H, D, F, Cl, Br, I, CN, Si(R⁶)₃, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen, von denen jedes substituiert sein kann durch einen oder mehrere Reste R⁶, wobei in jedem Fall ein oder mehrere nicht benachbarte CH₂-Gruppen ersetzt sein können durch Si(R⁶)₂, C=NR⁶, P(=O)(R⁶), SO, SO₂, NR⁶, O, S oder CONR⁶ und wobei ein oder mehrere H-Atome ersetzt sein können durch D, F, Cl, Br oder I, einem aromatischen oder heteroaromatischen Ringsystem mit 6 bis 60 C-Atomen, die in jedem Fall substituiert sein können durch einen oder mehrere Reste R⁶, einer Aryloxygruppe mit 5 bis 60 aromatischen Ringatomen, die substituiert sein können durch einen oder mehrere Reste R⁶, oder einer Aralkylgruppe mit 5 bis 60 aromatischen Ringatomen, die in jedem Fall substituiert sein können durch einen oder mehrere Reste R⁶, wobei zwei oder mehrere benachbarte Substituenten R^{5a} optional ein mono- oder polycyclisches, aliphatisches Ringsystem bilden können, das substituiert sein kann durch einen oder mehrere Reste R⁶;
R⁶ ist ausgewählt aus der Gruppe bestehend aus H, D, F, einem aliphatischen Kohlenwasserstoffrest mit 1 bis 20 C-Atomen oder einem aromatischen oder heteroaromatischen Ringsystem mit 5 bis 30 C-Atomen, in dem ein oder mehrere H-Atome durch D oder F ersetzt sein können, wobei zwei oder mehr benachbarte Substituenten R⁶ miteinander ein mono- oder polycyclisches, aliphatisches Ringsystem bilden können;
m ist 0, 1, 2 oder 3;
n ist bei jedem Auftreten gleich oder verschieden 0, 1, 2, 3 oder 4;
o ist bei jedem Auftreten gleich oder verschieden 0, 1 oder 2;
r, s sind bei jedem Auftreten gleich oder verschieden 0, 1, 2, 3 oder 4.

2. Elektronische Vorrichtung nach Anspruch 1, **dadurch gekennzeichnet, dass** die mindestens eine Verbindung b) ausgewählt ist aus den folgenden Verbindungen der Formeln (2a-1) bis (2a-3), (3a-1) bis (3a-3), (4a), (5a), (10a) und (11a) : 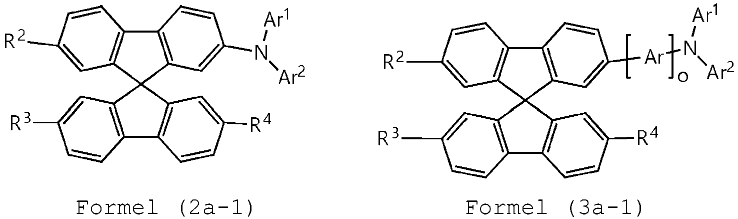 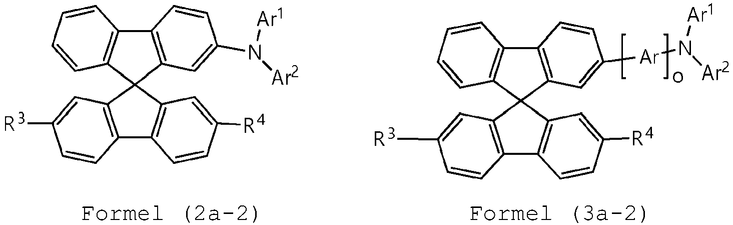 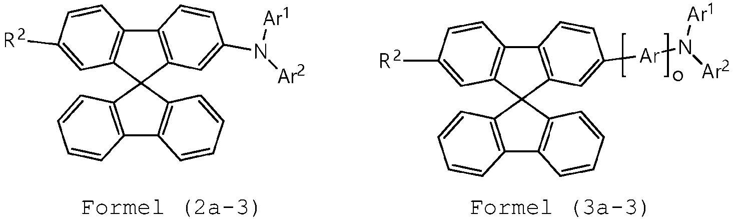 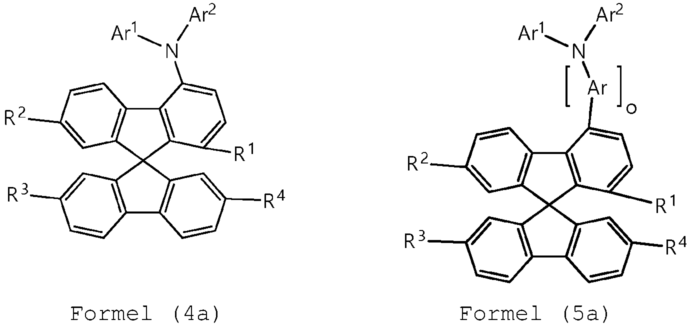 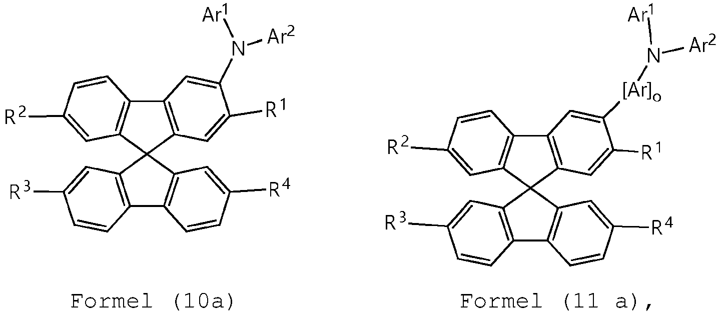 wobei die Symbole und Indizes wie in Anspruch 1 definiert sind.

3. Elektronische Vorrichtung nach Anspruch 1 oder 2, **dadurch gekennzeichnet, dass** die mindestens eine Verbindung b) ausgewählt ist aus den folgenden Verbindungen der Formeln (2b) bis (5b), (10b) und (11b): 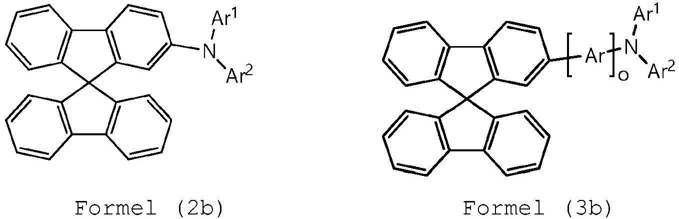 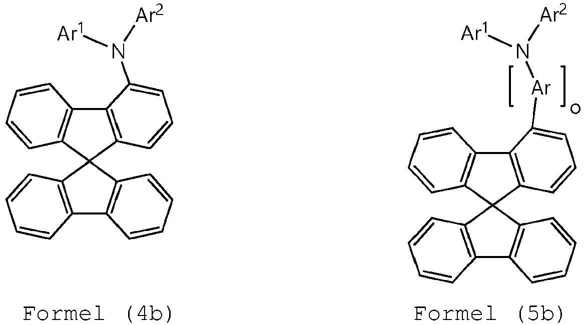 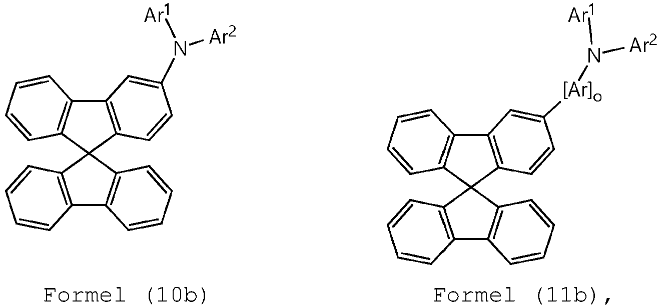 wobei die Symbole und Indizes wie in Anspruch 1 definiert sind.

4. Elektronische Vorrichtung nach einem oder mehreren der Ansprüche 1 bis 3, **dadurch gekennzeichnet, dass** die Gruppen Ar¹ und Ar² gleich oder verschieden bei jedem Auftreten ausgewählt sind aus der Gruppe bestehend aus Fluorenyl, Spirobifluorenyl, Phenyl, Biphenyl, Terphenyl, Quaterphenyl, Carbazolyl, Dibenzofuranyl, Dibenzothiophenyl, Naphthyl und Phenantryl, von denen jedes gleich oder verschieden mit einem oder mehreren Resten R^{5a} substituiert sein kann.

5. Elektronische Vorrichtung nach einem oder mehreren der Ansprüche 1 bis 4, **dadurch gekennzeichnet, dass** die Gruppen Ar¹ und Ar² bei jedem Auftreten gleich oder verschieden ausgewählt sind aus den Gruppen der Formeln (Ar-1) bis (Ar-123),
| | | |
|---|---|---|
| 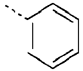 | 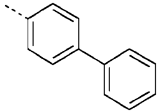 | 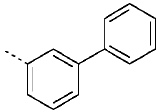 |
| Ar-1 | Ar-2 | Ar-3 |
| 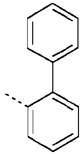 | 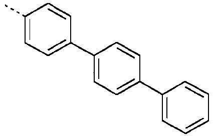 | 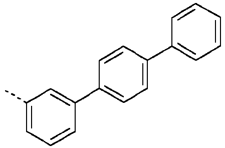 |
| Ar-4 | Ar-5 | Ar-6 |
| 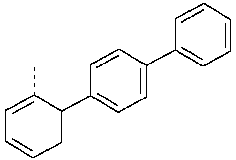 | 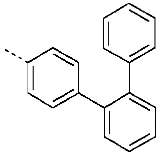 | 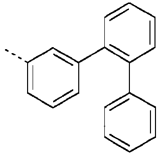 |
| Ar-7 | Ar-8 | Ar-9 |
| 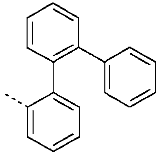 | 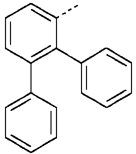 | 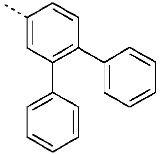 |
| Ar-10 | Ar-11 | Ar-12 |
| 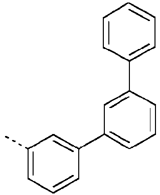 | 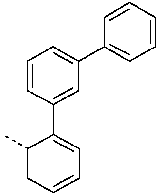 | 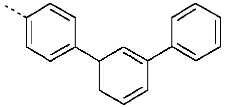 |
| Ar-13 | Ar-14 | Ar-15 |
| 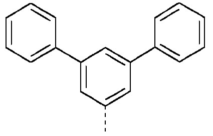 | 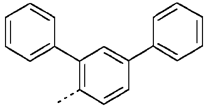 | 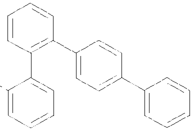 |
| Ar-16 | Ar-17 | Ar-18 |
| 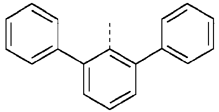 | | |
| Ar-19 | | |
| 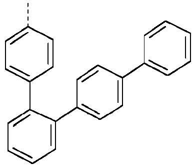 | 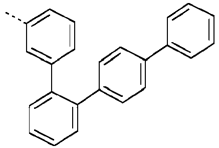 | 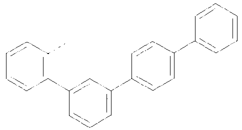 |
| Ar-20 | Ar-21 | Ar-22 |
| 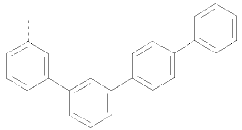 | 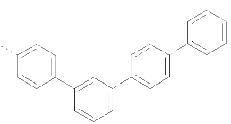 | 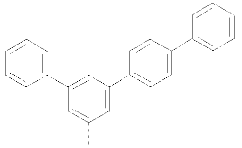 |
| Ar-23 | Ar-24 | Ar-25 |
| 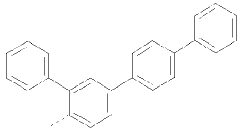 | 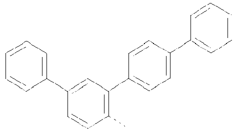 | 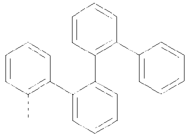 |
| Ar-26 | Ar-27 | Ar-28 |
| 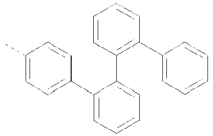 | 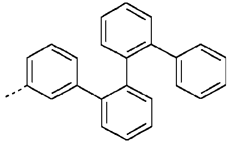 | 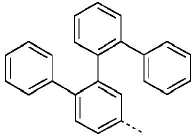 |
| Ar-29 | Ar-30 | Ar-31 |
| 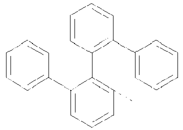 | 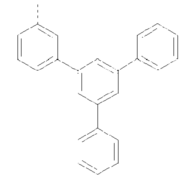 | 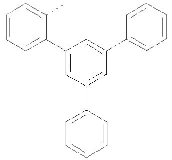 |
| Ar-32 | Ar-33 | Ar-34 |
| 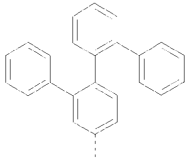 | 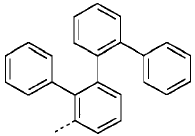 | 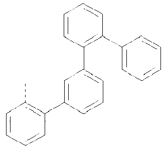 |
| Ar-35 | Ar-36 | Ar-37 |
| 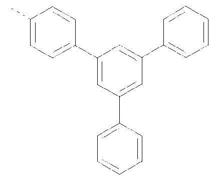 | 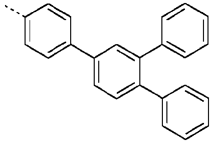 | 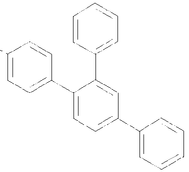 |
| Ar-38 | Ar-39 | Ar-40 |
| 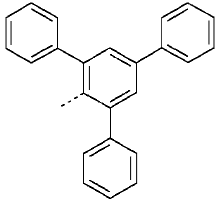 | 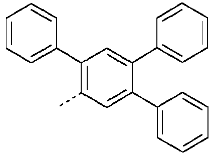 | 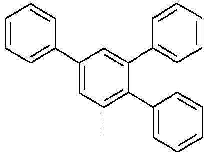 |
| Ar-41 | Ar-42 | Ar-43 |
| 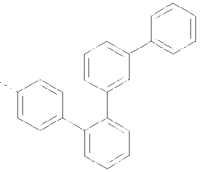 | 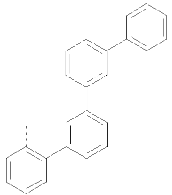 | 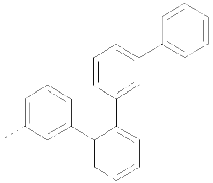 |
| Ar-44 | Ar-45 | Ar-46 |
| 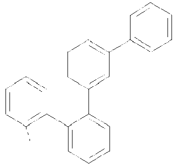 | | |
| Ar-47 | | |
| 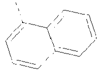 | 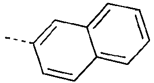 | 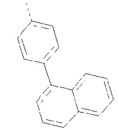 |
| Ar-48 | Ar-49 | Ar-50 |
| 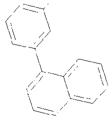 | 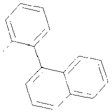 | 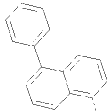 |
| Ar-51 | Ar-52 | Ar-53 |
| 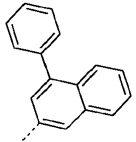 | 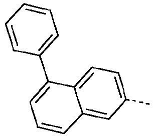 | 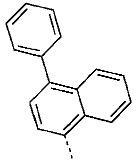 |
| Ar-54 | Ar-55 | Ar-56 |
| 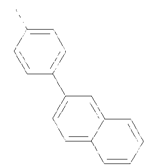 | 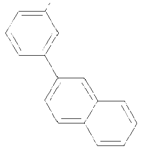 | 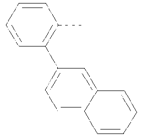 |
| Ar-57 | Ar-58 | Ar-59 |
| 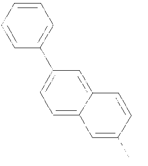 | 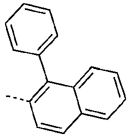 | 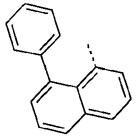 |
| Ar-60 | Ar-61 | Ar-62 |
| 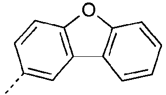 | 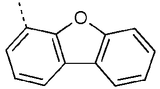 | 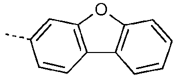 |
| Ar-63 | Ar-64 | Ar-65 |
| 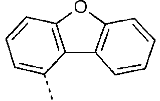 | 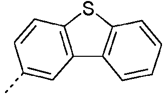 | 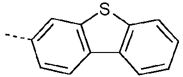 |
| Ar-66 | Ar-67 | Ar-68 |
| 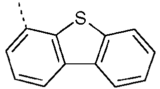 | 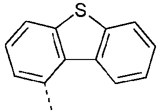 | 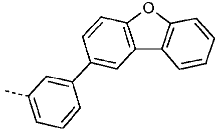 |
| Ar-69 | Ar-70 | Ar-71 |
| 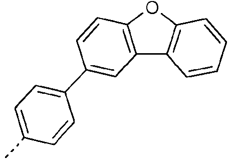 | 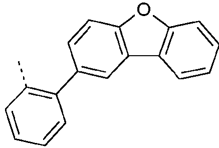 | 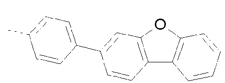 |
| Ar-72 | Ar-73 | Ar-74 |
| 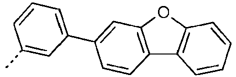 | 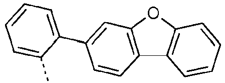 | 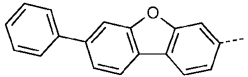 |
| Ar-75 | Ar-76 | Ar-77 |
| 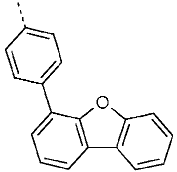 | 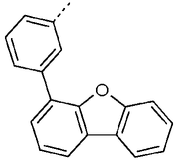 | 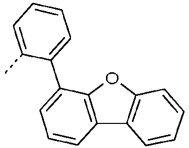 |
| Ar-78 | Ar-79 | Ar-80 |
| 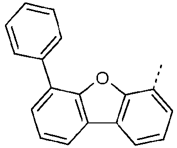 | 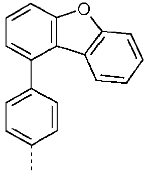 | 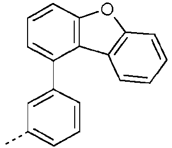 |
| Ar-81 | Ar-82 | Ar-83 |
| 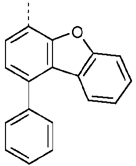 | 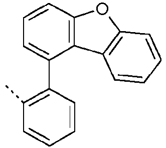 | 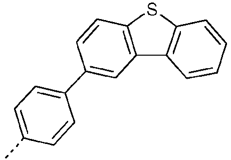 |
| Ar-84 | Ar-85 | Ar-86 |
| 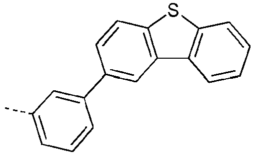 | 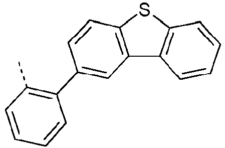 | 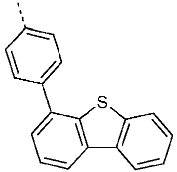 |
| Ar-87 | Ar-88 | Ar-89 |
| 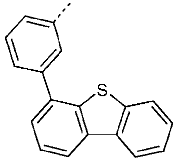 | 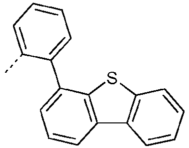 | 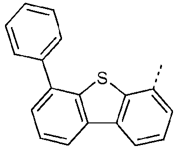 |
| Ar-90 | Ar-91 | Ar-92 |
| 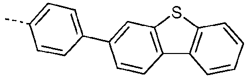 | 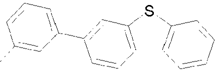 | 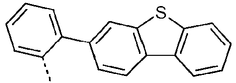 |
| Ar-93 | Ar-94 | Ar-95 |
| 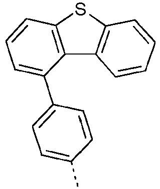 | 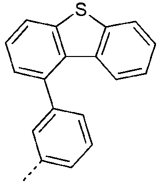 | 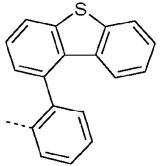 |
| Ar-96 | Ar-97 | Ar-98 |
| 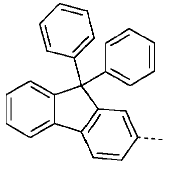 | 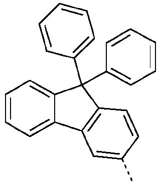 | 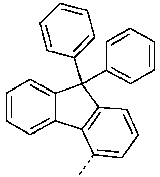 |
| Ar-99 | Ar-100 | Ar-101 |
| 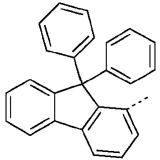 | 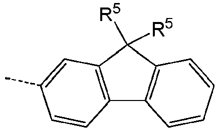 | 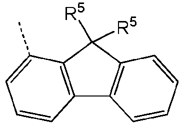 |
| Ar-102 | Ar-103 | Ar-104 |
| 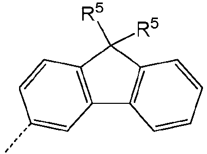 | 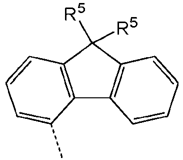 | 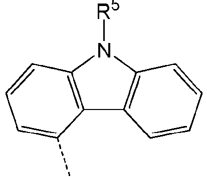 |
| Ar-105 | Ar-106 | Ar-107 |
| 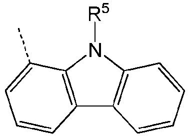 | 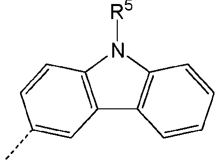 | 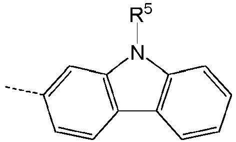 |
| Ar-108 | Ar-109 | Ar-110 |
| 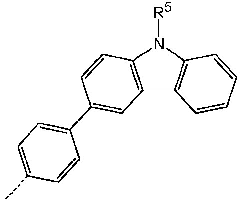 | 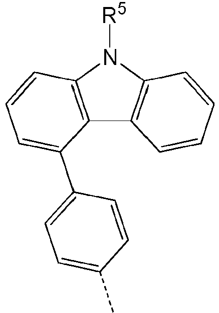 | 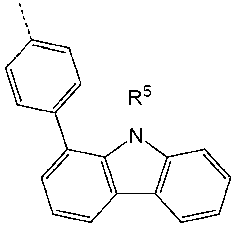 |
| Ar-111 | Ar-112 | Ar-113 |
| 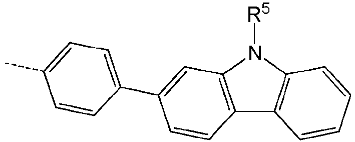 | | 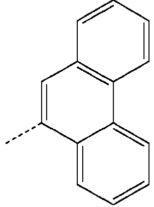 |
| Ar-114 | | Ar-115 |
| 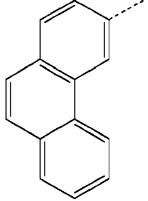 | 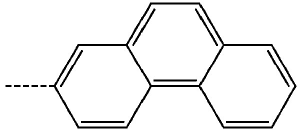 | |
| Ar-116 | Ar-117 | |
| 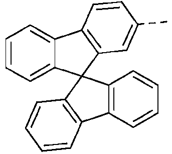 | 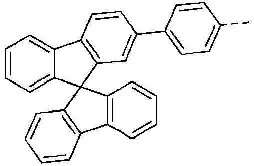 | |
| Ar-118 | Ar-119 | |
| 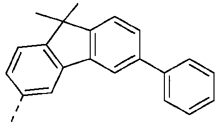 | 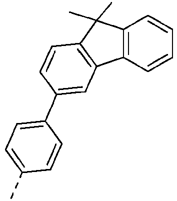 | |
| Ar-120 | Ar-120 | |
| 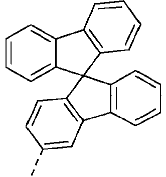 | 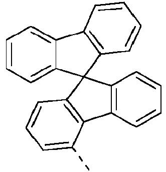 | |
| Ar-121 | Ar-122 | |
| 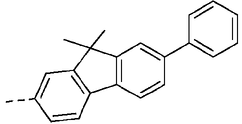 | | |
| | | |
| Ar-123 | | |
wobei die gestrichelte Bindung die Bindung an den Stickstoff angibt, die Gruppen gleich oder verschieden mit einem oder mehreren Resten R^{5a}, wie in Anspruch 1 definiert, substituiert sein können, bevorzugt aber unsubstituiert sind, und R⁵ in den Gruppen der Formeln (Ar-103) bis (Ar-114) die gleiche Bedeutung aufweist, wie in Anspruch 1 für R^{5a} definiert ist.

6. Elektronische Vorrichtung nach einem oder mehreren der Ansprüche 1 bis 5, **dadurch gekennzeichnet, dass** Ar¹ und Ar² gleich oder verschieden bei jedem Auftreten aus den Gruppen der Formeln (Ar-1), (Ar-2), (Ar-3), (Ar-4), (Ar-5), (Ar-6), (Ar-8), (Ar-9), (Ar-10), (Ar-12), (Ar-13), (Ar-15), (Ar-16), (Ar-17), (Ar-18), (Ar-19), (Ar-20), (Ar-31), (Ar-38), (Ar-41), (Ar-48), (Ar-49), (Ar-52), (Ar-63), (Ar-64), (Ar-65), (Ar-66), (Ar-71), (Ar-72), (Ar-73), (Ar-74), (Ar-75), (Ar-76), (Ar-77), (Ar-78), (Ar-79), (Ar-80), (Ar-81), (Ar-82), (Ar-83), (Ar-84), (Ar-85), (Ar-99), (Ar-100), (Ar-101), (Ar-103), (Ar-104), (Ar-105), (Ar-106), (Ar-107), (Ar-111), (Ar-115), (Ar-116), (Ar-117), (Ar-118), (Ar-119), (Ar-120), (Ar-121) und (Ar-122) ausgewählt sind.

7. Elektronische Vorrichtung nach einem oder mehreren der Ansprüche 1 bis 6, **dadurch gekennzeichnet, dass** Ar¹ und Ar² voneinander verschieden sind.

8. Elektronische Vorrichtung nach einem oder mehreren der Ansprüche 1 bis 7, **dadurch gekennzeichnet, dass** R^{5a}, das an Ar¹ oder Ar² gebunden ist, gleich oder verschieden bei jedem Auftreten ausgewählt ist aus der Gruppe bestehend aus H, D, F, CN, einer geradkettigen Alkylgruppe mit 1 bis 10 C-Atomen, einer verzweigten oder cyclischen Alkylgruppe mit 3 bis 10 C-Atomen oder einem aromatischen oder heteroaromatischen Ringsystem mit 5 bis 24 aromatischen Ringatomen, von denen jedes mit einem oder mehreren Resten R⁶ substituiert sein kann.

9. Elektronische Vorrichtung nach einem oder mehreren der Ansprüche 1 bis 8, **dadurch gekennzeichnet, dass** das mindestens eine halbleitende lichtemittierende Nanopartikel ausgewählt ist aus lichtemittierenden Materialien in Quantengröße, insbesondere aus Quantenpunkten und Quantenstäben.

10. Elektronische Vorrichtung nach einem oder mehreren der Ansprüche 1 bis 9, **dadurch gekennzeichnet, dass** das mindestens eine halbleitende lichtemittierende Material in Quantengröße des lichtemittierenden Nanopartikels Cdfrei ist.

11. Elektronische Vorrichtung nach einem oder mehreren der Ansprüche 1 bis 10, die ausgewählt ist aus der Gruppe bestehend aus organischen integrierten Schaltungen (OICs), organischen Feldeffekttransistoren (OFETs), organischen Dünnschichttransistoren (OTFTs), organischen Solarzellen (OSCs), organischen optischen Detektoren, organischen Photorezeptoren und organischen Elektrolumineszenzvorrichtungen, bevorzugt organischen Elektrolumineszenzvorrichtungen, die stärker bevorzugt ausgewählt sind aus organischen lichtemittierenden Transistoren (OLETs), organischen Field-Quench-Vorrichtungen(OFQDs), organischen lichtemittierenden elektrochemischen Zellen (OLECs, LECs, LEECs), organischen Laserdioden (O-Lasern) und organischen lichtemittierenden Dioden (OLEDs).

12. Elektronische Vorrichtung nach einem oder mehreren der Ansprüche 1 bis 13, **dadurch gekennzeichnet, dass** die mindestens eine Schicht eine emittierende Schicht ist.

13. Verfahren zum Herstellen einer elektronischen Vorrichtung nach einem oder mehreren der Ansprüche 1 bis 12, **dadurch gekennzeichnet, dass** mindestens eine Schicht, bevorzugt die mindestens eine Schicht, die das mindestens eine halbleitende lichtemittierende Nanopartikel und die mindestens eine Verbindung, die durch die allgemeine folgende Formel (1) dargestellt ist, umfasst, durch ein Sublimationsverfahren beschichtet wird und/oder durch ein OVPD-Verfahren oder mittels einer Trägergassublimation beschichtet wird und/oder aus Lösung durch Schleuderbeschichten oder durch ein Druckverfahren aufgebracht wird.

14. Zusammensetzung, umfassend mindestens ein halbleitendes lichtemittierendes Nanopartikel und mindestens eine Verbindung ausgewählt aus den Formeln (2) bis (5), (10) und (11), wie in Anspruch 1 definiert.

15. Formulierung, umfassend eine Zusammensetzung nach Anspruch 14 oder mindestens ein halbleitendes lichtemittierendes Nanopartikel und mindestens eine Verbindung ausgewählt aus den Formeln (2) bis (5), (10) und (11), wie in Anspruch 1 definiert, und mindestens ein erstes Lösungsmittel.

16. Formulierung nach Anspruch 15, **dadurch gekennzeichnet, dass** das erste Lösungsmittel ausgewählt ist aus der Gruppe bestehend aus Alkoholen, Aldehyden, Ketonen, Ethern, Estern, Amiden wie etwa Dialkylformamiden, Schwefelverbindungen, Nitroverbindungen, Kohlenwasserstoffen, halogenierten Kohlenwasserstoffen (z. B. chlorierten Kohlenwasserstoffen), aromatischen oder heteroaromatischen Kohlenwasserstoffen, halogenierten aromatischen oder heteroaromatischen Kohlenwasserstoffen und (cyclischen) Siloxanen, und Mischungen aus zwei oder mehr davon.

17. Formulierung nach Anspruch 15 oder 16, **dadurch gekennzeichnet, dass** das erste Lösungsmittel eine Oberflächenspannung bei Raumtemperatur (20 °C bis 25 °C) von ≥ 20 mN/m aufweist, gemessen mit dem in der Beschreibung offenbarten hochpräzisen Tropfenformanalysewerkzeug.

18. Formulierung nach einem oder mehreren der Ansprüche 15 bis 17, **dadurch gekennzeichnet, dass** das erste Lösungsmittel einen Siedepunkt im Bereich von 150 bis 350 °C aufweist.

19. Formulierung nach einem oder mehreren der Ansprüche 15 bis 18, **dadurch gekennzeichnet, dass** die Formulierung ein zweites Lösungsmittel umfasst, das sich von dem ersten Lösungsmittel unterscheidet.

20. Formulierung nach einem oder mehreren der Ansprüche 15 bis 19, **dadurch gekennzeichnet, dass** der Gehalt des ersten Lösungsmittels im Bereich von 50 bis 100 Vol.-%, bezogen auf die Gesamtmenge von Lösungsmitteln in der Formulierung, liegt.

21. Formulierung nach Anspruch 19 oder 20, **dadurch gekennzeichnet, dass** das zweite Lösungsmittel einen Siedepunkt im Bereich von 150 bis 350 °C aufweist.

22. Formulierung nach einem oder mehreren der Ansprüche 15 bis 21, **dadurch gekennzeichnet, dass** die Formulierung eine Oberflächenspannung bei Raumtemperatur (20 °C bis 25 °C) im Bereich von 15 bis 80 mN/m aufweist, gemessen mit dem in der Beschreibung offenbarten hochpräzisen Tropfenformanalysewerkzeug.

23. Formulierung nach einem oder mehreren der Ansprüche 15 bis 22, **dadurch gekennzeichnet, dass** die Formulierung eine Viskosität bei 25,0 °C (+/- 0,2 °C) im Bereich von 1 bis 50 mPa·s, gemessen mit dem in der Beschreibung offenbarten 1°-Kegel-Platten-Rotationsrheometer, aufweist.

24. Formulierung nach einem oder mehreren der Ansprüche 15 bis 23, **dadurch gekennzeichnet, dass** der Gehalt der mindestens einen Verbindung, die ausgewählt ist aus den Formeln (2) bis (5), (10) und (11), und des mindestens einen halbleitenden lichtemittierenden Nanopartikels in der Formulierung im Bereich von 0,001 bis 50 Gew.-%, bezogen auf das Gesamtgewicht der Formulierung, liegt.

## Revendications

1. Dispositif électronique comprenant une anode, une cathode et au moins une couche qui comprend les composés suivants :
a) au moins une nanoparticule électroluminescente semi-conductrice ; et
b) au moins un composé choisi parmi les formules (2) à (5), (10) et (11) suivantes : 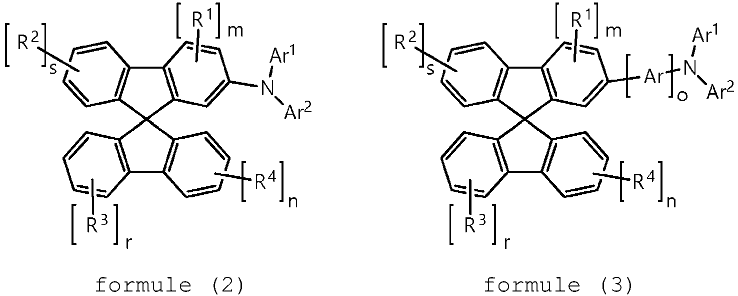 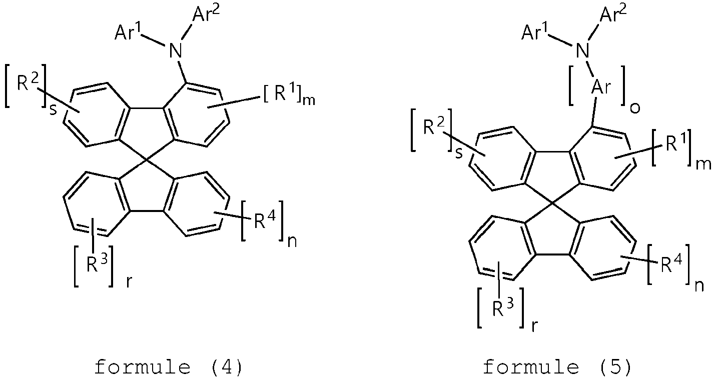 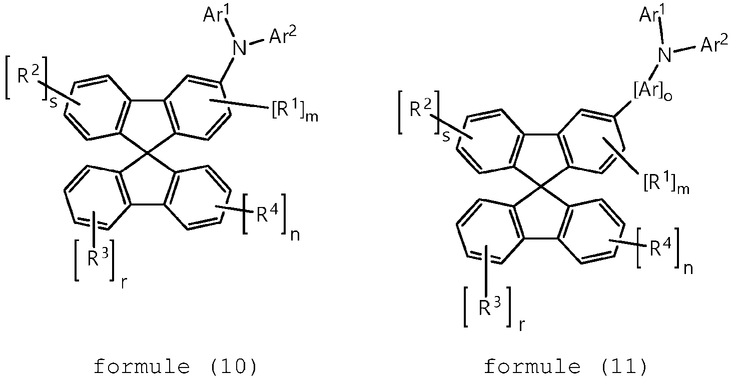 où ce qui suit s'applique aux symboles et indices utilisés :
Ar est, de manière identique ou différente à chaque occurrence, un système de cycle aromatique choisi dans le groupe constitué par un benzène, un naphtalène, un phénanthrène, un fluorène, un spirobifluorène, un dibenzofurane et un dibenzothiophène, chacun pouvant être substitué par un ou plusieurs radicaux R^{5a} ; Ar peut également être lié à Ar¹ et/ou à Ar² ici par un groupe E ; Ar¹, Ar² sont, de manière identique ou différente à chaque occurrence, un système de cycle aromatique ou hétéroaromatique comportant 6 à 60 C, chacun pouvant également être substitué par un ou plusieurs radicaux R^{5a} ; Ar¹ et Ar² ici peuvent également être liés l'un à l'autre et/ou Ar¹ peut être lié à Ar et/ou Ar² peut être lié à Ar par un groupe E ;
E est à chaque occurrence, de manière identique ou différente, une liaison simple, C(R^{5a})₂, NR^{5a}, O ou S ;
R¹, R², R³ sont choisis à chaque occurrence, de manière identique ou différente, dans le groupe constitué par H, D, F, Cl, Br, I, CN, Si(R⁶)₃, un groupe alkyle, alcoxy ou thioalkyle à chaîne droite comportant 1 à 40 atomes C ou un groupe alkyle, alcoxy ou thioalkyle ramifié ou cyclique comportant 3 à 40 atomes C, chacun pouvant être substitué par un ou plusieurs radicaux R⁶, où dans chaque cas un ou plusieurs groupes CH₂ non adjacents peuvent être remplacés par Si(R⁶)₂, C=NR⁶, P(=O)(R⁶), SO, SO₂, NR⁶, O, S ou CONR⁶ et où un ou plusieurs atomes H peuvent être remplacés par D, F, Cl, Br ou I, un système de cycle aromatique ou hétéroaromatique comportant 6 à 60 atomes C, qui peut dans chaque cas être substitué par un ou plusieurs radicaux R⁶, un groupe aryloxy comportant 5 à 60 atomes de cycle aromatique, qui peut être substitué par un ou plusieurs radicaux R⁶, ou un groupe aralkyle comportant 5 à 60 atomes de cycle aromatique, qui peut dans chaque cas être substitué par un ou plusieurs radicaux R⁶, où deux substituants adjacents R¹ ou R² ou R³ ou plus peuvent éventuellement former un système de cycle aliphatique mono- ou polycyclique, qui peut être substitué par un ou plusieurs radicaux R⁶ ;
R⁴ est choisi, de manière identique ou différente à chaque occurrence, dans le groupe constitué par H, D, F, Cl, Br, I, CN, Si(R⁶)₃, un groupe alkyle, alcoxy ou thioalkyle à chaîne droite comportant 1 à 40 atomes C ou un groupe alkyle, alcoxy ou thioalkyle ramifié ou cyclique comportant 3 à 40 atomes C, chacun pouvant être substitué par un ou plusieurs radicaux R⁶, où dans chaque cas un ou plusieurs groupes CH₂ non adjacents peuvent être remplacés par Si(R⁶)₂, C=NR⁶, P(=O) (R⁶), SO, SO₂, O, S ou CONR⁶ et où un ou plusieurs atomes H peuvent être remplacés par D, F, Cl, Br ou I, un système de cycle aromatique ou hétéroaromatique comportant 6 à 60 atomes C, qui peut dans chaque cas être substitué par un ou plusieurs radicaux R⁶, un groupe aryloxy comportant 5 à 60 atomes de cycle aromatique, qui peut être substitué par un ou plusieurs radicaux R⁶, ou un groupe aralkyle comportant 5 à 60 atomes de cycle aromatique, qui peut dans chaque cas être substitué par un ou plusieurs radicaux R⁶, où deux substituants adjacents R⁴ ou plus peuvent éventuellement former un système de cycle aliphatique mono- ou polycyclique, qui peut être substitué par un ou plusieurs radicaux R⁶ ;
R^{5a} est choisi à chaque occurrence, de manière identique ou différente, dans le groupe constitué par H, D, F, Cl, Br, I, CN, Si(R⁶)₃, un groupe alkyle, alcoxy ou thioalkyle à chaîne droite comportant 1 à 40 atomes C ou un groupe alkyle, alcoxy ou thioalkyle ramifié ou cyclique comportant 3 à 40 atomes C, chacun pouvant être substitué par un ou plusieurs radicaux R⁶, où dans chaque cas un ou plusieurs groupes CH₂ non adjacents peuvent être remplacés par Si(R⁶)₂, C=NR⁶, P(=O)(R⁶) , SO, SO₂, NR⁶, O, S ou CONR⁶ et où un ou plusieurs atomes H peuvent être remplacés par D, F, Cl, Br ou I, un système de cycle aromatique ou hétéroaromatique comportant 6 à 60 atomes C, qui peut dans chaque cas être substitué par un ou plusieurs radicaux R⁶, un groupe aryloxy comportant 5 à 60 atomes de cycle aromatique, qui peut être substitué par un ou plusieurs radicaux R⁶, ou un groupe aralkyle comportant 5 à 60 atomes de cycle aromatique, qui peut dans chaque cas être substitué par un ou plusieurs radicaux R⁶, où deux substituants adjacents R^{5a} ou plus peuvent éventuellement former un système de cycle aliphatique mono- ou polycyclique, qui peut être substitué par un ou plusieurs radicaux R⁶ ;
R⁶ est choisi dans le groupe constitué par H, D, F, un radical hydrocarboné aliphatique comportant 1 à 20 atomes C ou un système de cycle aromatique ou hétéroaromatique comportant 5 à 30 atomes C, dans lequel un ou plusieurs atomes H peuvent être remplacés par D ou F, où deux substituants adjacents R⁶ ou plus peuvent former un système de cycle aliphatique mono- ou polycyclique entre eux ;
m vaut 0, 1, 2 ou 3 ;
n vaut à chaque occurrence, de manière identique ou différente, 0, 1, 2, 3 ou 4 ;
o vaut à chaque occurrence, de manière identique ou différente, 0, 1 ou 2 ;
r, s valent à chaque occurrence, de manière identique ou différente, 0, 1, 2, 3 ou 4.

2. Dispositif électronique selon la revendication 1, **caractérisé en ce que** l'au moins un composé b) est choisi parmi les composés suivants de formules (2a-1) à (2a-3), (3a-1) à (3a-3), (4a), (5a), (10a) et (11a) : 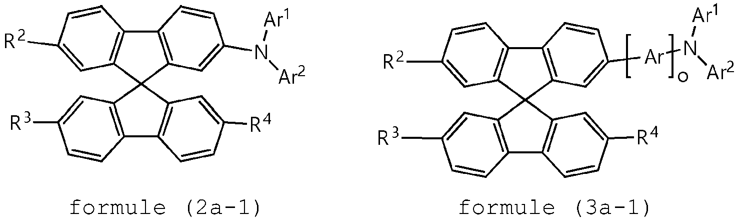 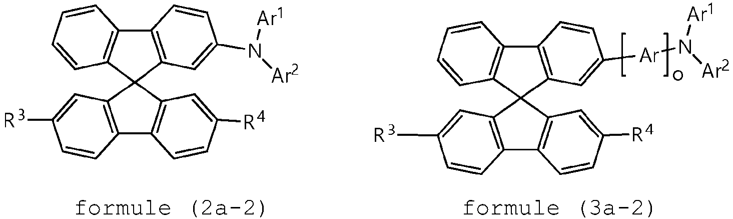 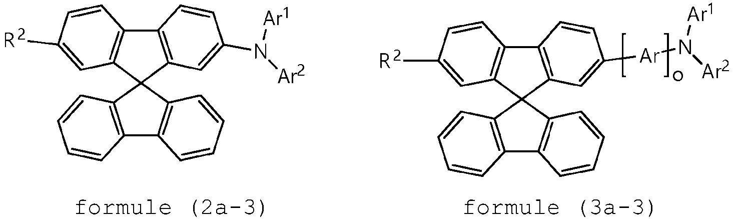 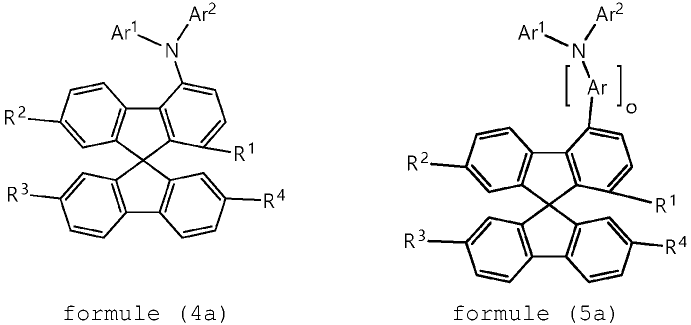 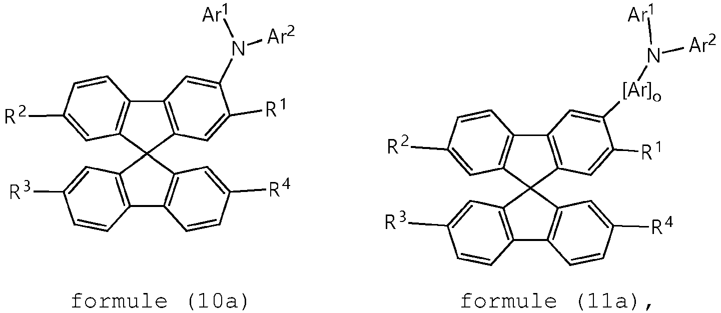 où les symboles et les indices sont tels que définis dans la revendication 1.

3. Dispositif électronique selon l'une des revendications 1 ou 2, **caractérisé en ce que** l'au moins un composé b) est choisi parmi les composés suivants de formules (2b) à (5b), (10b) et (11b) : 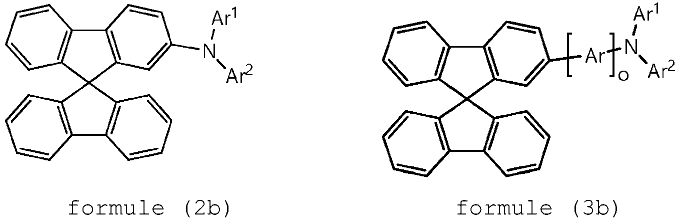 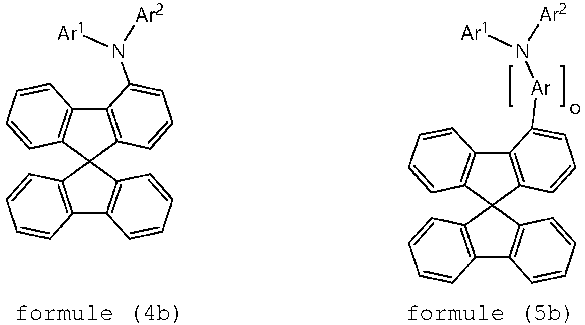 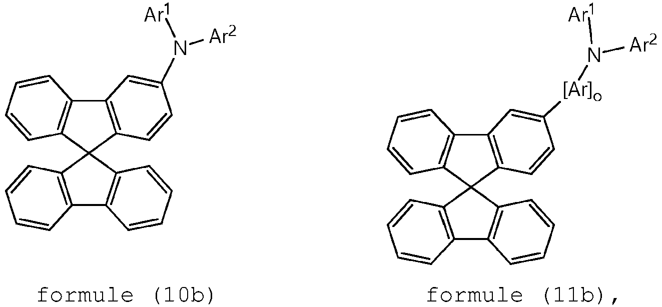 où les symboles et les indices sont tels que définis dans la revendication 1.

4. Dispositif électronique selon une ou plusieurs des revendications 1 à 3, **caractérisé en ce que** les groupes Ar¹ et Ar² sont choisis, de manière identique ou différente à chaque occurrence, dans le groupe constitué par un fluorényle, un spirobifluorényle, un phényle, un biphényle, un terphényle, un quaterphényle, un carbazolyle, un dibenzofuranyle, un dibenzothiophényle, un naphtyle et un phénantryle, chacun pouvant être substitué, de manière identique ou différente, par un ou plusieurs radicaux R^{5a}.

5. Dispositif électronique selon une ou plusieurs des revendications 1 à 4, **caractérisé en ce que** les groupes Ar¹ et Ar² sont choisis, de manière identique ou différente à chaque occurrence, parmi les groupes de formules (Ar-1) à (Ar-123),
| | | |
|---|---|---|
| 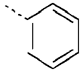 | 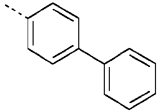 | 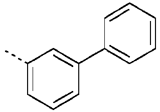 |
| Ar-1 | Ar-2 | Ar-3 |
| 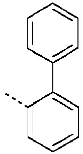 | 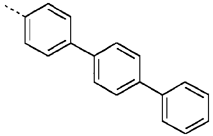 | 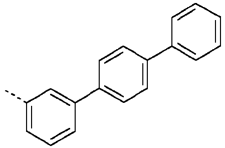 |
| Ar-4 | Ar-5 | Ar-6 |
| 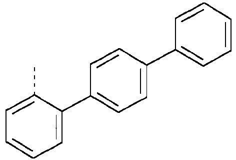 | 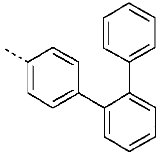 | 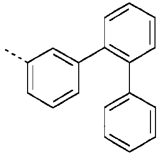 |
| Ar-7 | Ar-8 | Ar-9 |
| 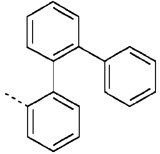 | 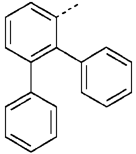 | 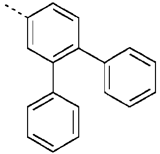 |
| Ar-10 | Ar-11 | Ar-12 |
| 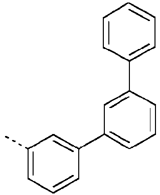 | 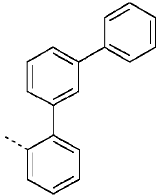 | 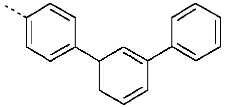 |
| Ar-13 | Ar-14 | Ar-15 |
| 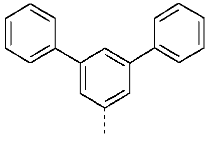 | 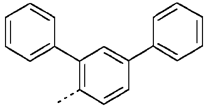 | 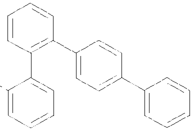 |
| Ar-16 | Ar-17 | Ar-18 |
| 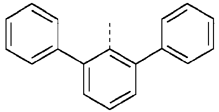 | | |
| Ar-19 | | |
| 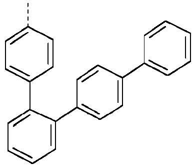 | 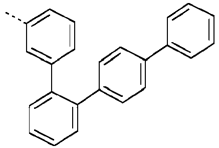 | 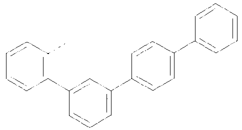 |
| Ar-20 | Ar-21 | Ar-22 |
| 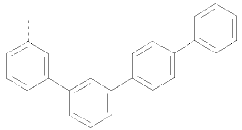 | 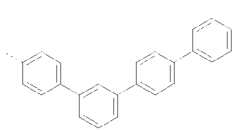 | 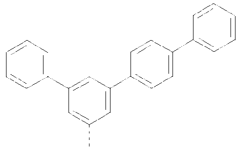 |
| Ar-23 | Ar-24 | Ar-25 |
| 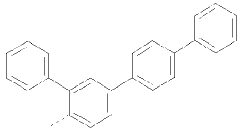 | 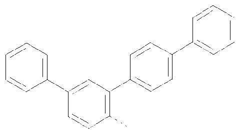 | 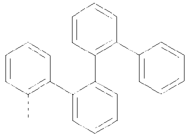 |
| Ar-26 | Ar-27 | Ar-28 |
| 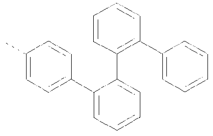 | 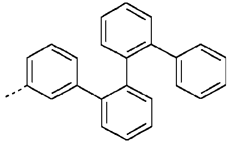 | 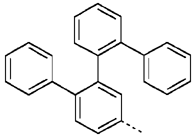 |
| Ar-29 | Ar-30 | Ar-31 |
| 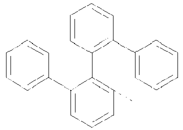 | 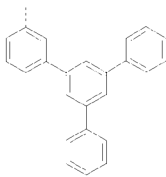 | 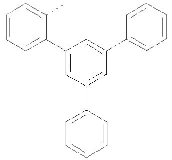 |
| Ar-32 | Ar-33 | Ar-34 |
| 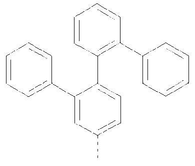 | 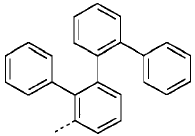 | 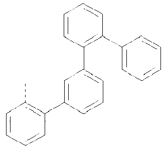 |
| Ar-35 | Ar-36 | Ar-37 |
| 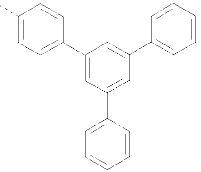 | 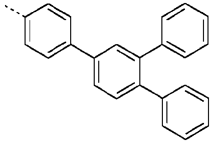 | 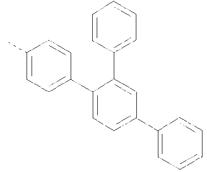 |
| Ar-38 | Ar-39 | Ar-40 |
| 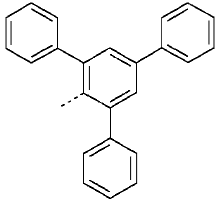 | 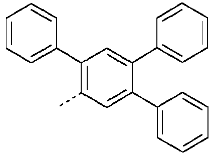 | 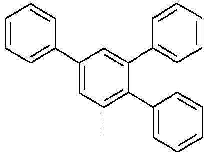 |
| Ar-41 | Ar-42 | Ar-43 |
| 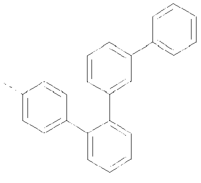 | 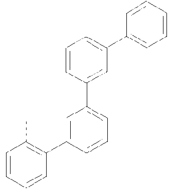 | 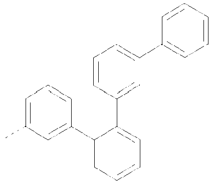 |
| Ar-44 | Ar-45 | Ar-46 |
| 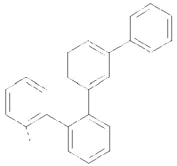 | | |
| Ar-47 | | |
| 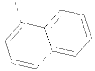 | 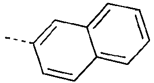 | 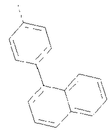 |
| Ar-48 | Ar-49 | Ar-50 |
| 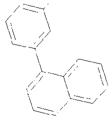 | 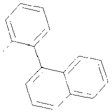 | 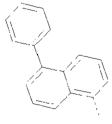 |
| Ar-51 | Ar-52 | Ar-53 |
| 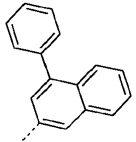 | 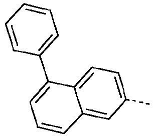 | 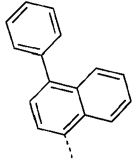 |
| Ar-54 | Ar-55 | Ar-56 |
| 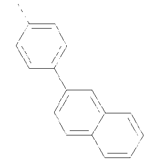 | 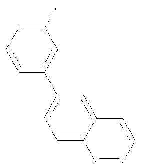 | 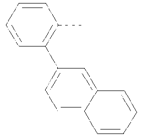 |
| Ar-57 | Ar-58 | Ar-59 |
| 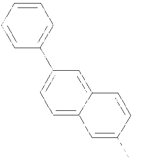 | 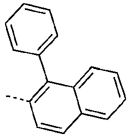 | 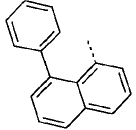 |
| Ar-60 | Ar-61 | Ar-62 |
| 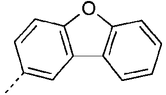 | 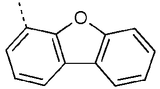 | 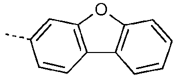 |
| Ar-63 | Ar-64 | Ar-65 |
| 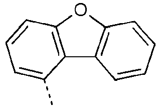 | 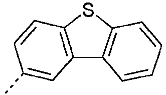 | 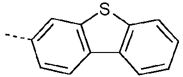 |
| Ar-66 | Ar-67 | Ar-68 |
| 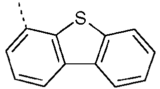 | 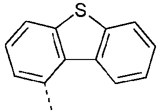 | 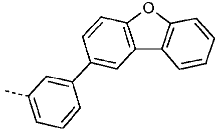 |
| Ar-69 | Ar-70 | Ar-71 |
| 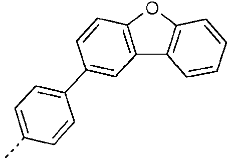 | 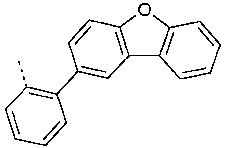 | 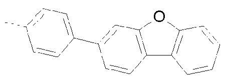 |
| Ar-72 | Ar-73 | Ar-74 |
| 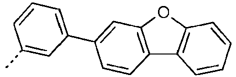 | 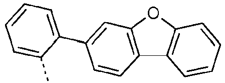 | 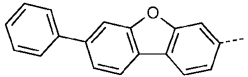 |
| Ar-75 | Ar-76 | Ar-77 |
| 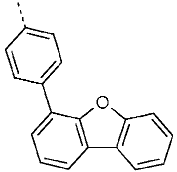 | 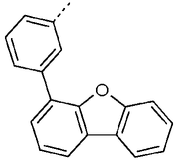 | 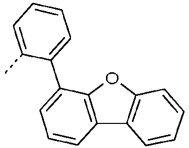 |
| Ar-78 | Ar-79 | Ar-80 |
| 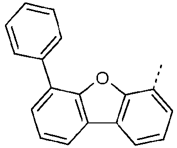 | 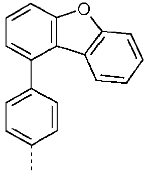 | 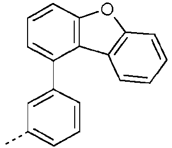 |
| Ar-81 | Ar-82 | Ar-83 |
| 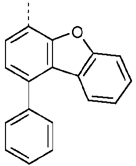 | 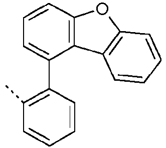 | 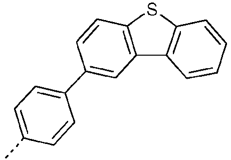 |
| Ar-84 | Ar-85 | Ar-86 |
| 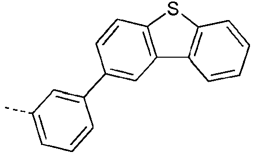 | 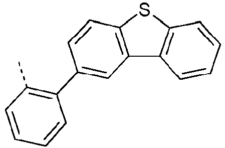 | 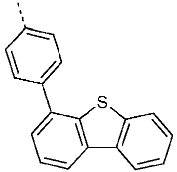 |
| Ar-87 | Ar-88 | Ar-89 |
| 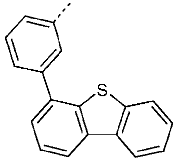 | 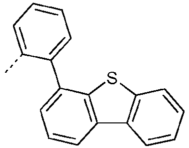 | 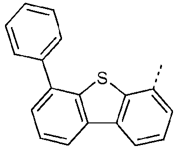 |
| Ar-90 | Ar-91 | Ar-92 |
| 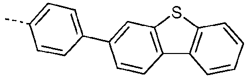 | 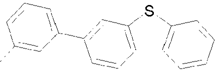 | 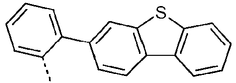 |
| Ar-93 | Ar-94 | Ar-95 |
| 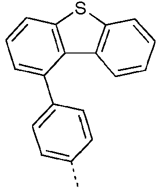 | 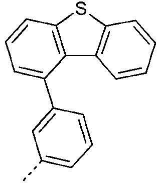 | 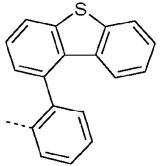 |
| Ar-96 | Ar-97 | Ar-98 |
| 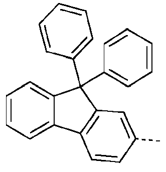 | 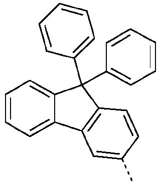 | 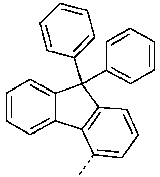 |
| Ar-99 | Ar-100 | Ar-101 |
| 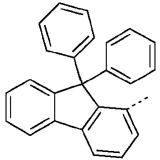 | 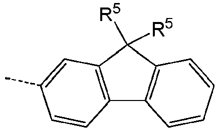 | 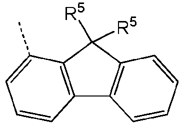 |
| Ar-102 | Ar-103 | Ar-104 |
| 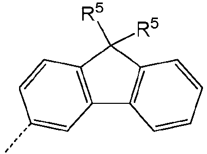 | 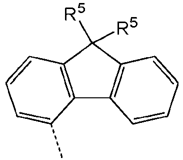 | 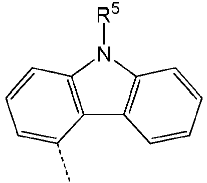 |
| Ar-105 | Ar-106 | Ar-107 |
| 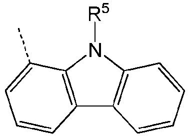 | 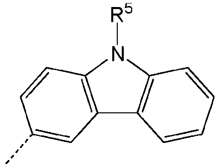 | 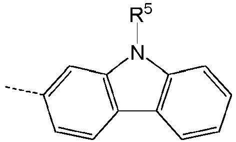 |
| Ar-108 | Ar-109 | Ar-110 |
| 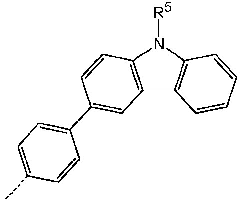 | 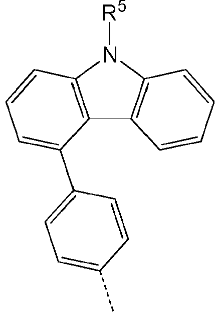 | 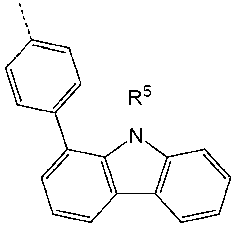 |
| Ar-111 | Ar-112 | Ar-113 |
| 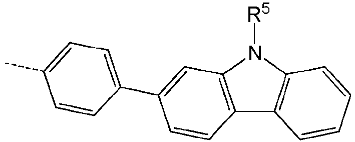 | | 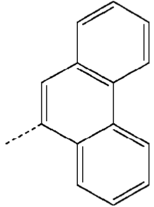 |
| Ar-1 14 | | Ar-115 |
| 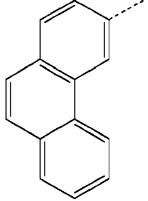 | 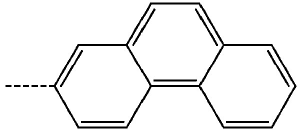 | |
| Ar-116 | Ar-117 | |
| 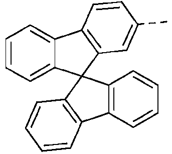 | 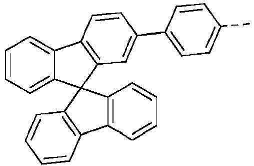 | |
| Ar-118 | Ar-119 | |
| 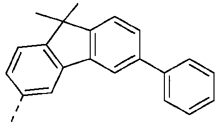 | 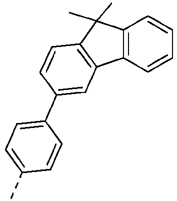 | |
| Ar-120 | Ar-120 | |
| 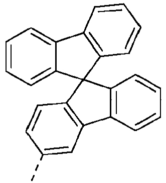 | 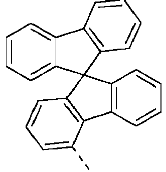 | |
| Ar-121 | Ar-122 | |
| 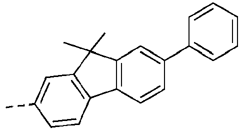 Ar-123 | | |
où la liaison en pointillés indique la liaison à l'azote, les groupes peuvent être substitués, de manière identique ou différente, par un ou plusieurs radicaux R^{5a} tels que définis dans la revendication 1, mais sont de préférence non substitués, et R⁵ dans les groupes des formules (Ar-103) à (Ar-114) a la même signification que celle définie dans la revendication 1 pour R^{5a}.

6. Dispositif électronique selon une ou plusieurs des revendications 1 à 5, **caractérisé en ce que** Ar¹ et Ar² sont choisis, de manière identique ou différente à chaque occurrence, parmi les groupes de formules (Ar-1), (Ar-2), (Ar-3), (Ar-4), (Ar-5), (Ar-6), (Ar-8), (Ar-9), (Ar-10), (Ar-12), (Ar-13), (Ar-15), (Ar-16), (Ar-17), (Ar-18), (Ar-19), (Ar-20), (Ar-31), (Ar-38), (Ar-41), (Ar-48), (Ar-49), (Ar-52), (Ar-63), (Ar-64), (Ar-65), (Ar-66), (Ar-71), (Ar-72), (Ar-73), (Ar-74), (Ar-75), (Ar-76), (Ar-77), (Ar-78), (Ar-79), (Ar-80), (Ar-81), (Ar-82), (Ar-83), (Ar-84), (Ar-85), (Ar-99), (Ar-100), (Ar-101), (Ar-103), (Ar-104), (Ar-105), (Ar-106), (Ar-107), (Ar-111), (Ar-115), (Ar-116), (Ar-117), (Ar-118), (Ar-119), (Ar-120), (Ar-121) et (Ar-122).

7. Dispositif électronique selon une ou plusieurs des revendications 1 à 6, **caractérisé en ce que** Ar¹ et Ar² sont différents l'un de l'autre.

8. Dispositif électronique selon une ou plusieurs des revendications 1 à 7, **caractérisé en ce que** R^{5a} qui est lié à Ar¹ ou Ar² est choisi, de manière identique ou différente à chaque occurrence, dans le groupe constitué par H, D, F, CN, un groupe alkyle à chaîne droite comportant 1 à 10 atomes C, un groupe alkyle ramifié ou cyclique comportant 3 à 10 atomes C ou un système de cycle aromatique ou hétéroaromatique comportant 5 à 24 atomes de cycle aromatique, dont chacun peut être substitué par un ou plusieurs radicaux R⁶.

9. Dispositif électronique selon une ou plusieurs des revendications 1 à 8, **caractérisé en ce que** l'au moins une nanoparticule électroluminescente semi-conductrice est choisie parmi des matériaux électroluminescents de taille quantique, en particulier parmi des points quantiques et des bâtonnets quantiques.

10. Dispositif électronique selon une ou plusieurs des revendications 1 à 9, **caractérisé en ce que** l'au moins une nanoparticule électroluminescente semi-conductrice, matériau électroluminescent de taille quantique, est exempte de Cd.

11. Dispositif électronique selon une ou plusieurs des revendications 1 à 10, qui est choisi dans le groupe constitué de circuits intégrés organiques (OIC), de transistors à effet de champ organiques (OFET), de transistors à couches minces organiques (OTFT), de cellules solaires organiques (OSC), de détecteurs optiques organiques, de photorécepteurs organiques et de dispositifs électroluminescents organiques, de préférence des dispositifs électroluminescents organiques qui sont idéalement choisis parmi des transistors organiques électroluminescents (OLET), des dispositifs organiques à extinction de champ (OFQD), des cellules électrochimiques électroluminescentes organiques (OLEC, LEC, LEEC), des diodes laser organiques (O-laser) et des diodes électroluminescentes organiques (OLED) .

12. Dispositif électronique selon une ou plusieurs des revendications 1 à 13, **caractérisé en ce que** l'au moins une couche est une couche émettrice.

13. Procédé permettant la préparation d'un dispositif électronique selon l'une ou plusieurs des revendications 1 à 12, **caractérisé en ce qu'**au moins une couche, de préférence l'au moins une couche qui comprend l'au moins une nanoparticule électroluminescente semi-conductrice et l'au moins un composé représenté par la formule générale (1) suivante, est revêtue par un procédé de sublimation et/ou est revêtue par un procédé OVPD ou au moyen d'une sublimation par gaz porteur et/ou est appliquée à partir d'une solution par dépôt à la tournette ou par un procédé d'impression.

14. Composition comprenant au moins une nanoparticule électroluminescente semi-conductrice et au moins un composé choisi parmi les formules (2) à (5), (10) et (11) telles que définies dans la revendication 1.

15. Formulation comprenant une composition selon la revendication 14, ou au moins une nanoparticule électroluminescente semi-conductrice et au moins un composé choisi parmi les formules (2) à (5), (10) et (11) telles que définies dans la revendication 1, et au moins un premier solvant.

16. Formulation selon la revendication 15, **caractérisée en ce que** le premier solvant est choisi dans le groupe constitué par les alcools, les aldéhydes, les cétones, les éthers, les esters, les amides tels que les dialkylformamides, les composés soufrés, les composés nitrés, les hydrocarbures, les hydrocarbures halogénés (par exemple les hydrocarbures chlorés), les hydrocarbures aromatiques ou hétéroaromatiques, les hydrocarbures aromatiques ou hétéroaromatiques halogénés et les siloxanes (cycliques), et les mélanges de deux ou plus de ceux-ci.

17. Formulation selon l'une des revendications 15 ou 16, **caractérisée en ce que** le premier solvant présente une tension superficielle à température ambiante (20 °C à 25 °C) ≥ 20 mN/m telle que mesurée par l'outil d'analyse de forme de goutte de haute précision divulgué dans la description.

18. Formulation selon une ou plusieurs des revendications 15 à 17, **caractérisée en ce que** le premier solvant présente un point d'ébullition compris dans la plage de 150 à 350 °C.

19. Formulation selon une ou plusieurs des revendications 15 à 18, **caractérisée en ce que** la formulation comprend un second solvant qui est différent du premier solvant.

20. Formulation selon une ou plusieurs des revendications 15 à 19, **caractérisée en ce que** la teneur en premier solvant est comprise dans la plage de 50 à 100 % en volume, sur la base de la quantité totale de solvants dans la formulation.

21. Formulation selon la revendication 19 ou 20, **caractérisée en ce que** le second solvant présente un point d'ébullition compris dans la plage de 150 à 350 °C.

22. Formulation selon une ou plusieurs des revendications 15 à 21, **caractérisée en ce que** la formulation présente une tension superficielle à température ambiante (20 °C à 25 °C) comprise dans la plage de 15 à 80 mN/m telle que mesurée par l'outil d'analyse de forme de goutte de haute précision divulgué dans la description.

23. Formulation selon une ou plusieurs des revendications 15 à 22, **caractérisée en ce que** la formulation présente une viscosité à 25,0 °C (+/- 0,2 °C) comprise dans la plage de 1 à 50 mPas telle que mesurée par le rhéomètre rotatif à cône-plan de 1° divulgué dans la description.

24. Formulation selon une ou plusieurs des revendications 15 à 23, **caractérisée en ce que** la teneur en l'au moins un composé choisi parmi les formules (2) à (5), (10) et (11) et en l'au moins une nanoparticule électroluminescente semi-conductrice dans la formulation est comprise dans la plage de 0,001 à 50 % en poids, sur la base du poids total de la formulation.
